# EUROPEAN PATENT APPLICATION

(11) **EP 3 691 416 A1**
(43) Date of publication of application: **05.08.2020**
(21) Application number: 18860343.5
(22) Date of filing: 19.09.2018
(51) Int. Cl.: H05B 33/12, C08G 61/10, C09K 11/06, H01L 51/50

(54) **LIGHT-EMITTING DEVICE**

(30) Priority: 29.09.2017 JP 2017189922
(71) Applicant: Sumitomo Chemical Company Limited, Tokyo 104-8260 (JP)
(72) Inventor: SASADA, Toshiaki, Tsukuba-shi Ibaraki 300-3294 (JP); ASADA, Kohei, Tsukuba-shi Ibaraki 300-3294 (JP); INAKAZU, Shinichi, Tsukuba-shi Ibaraki 300-3294 (JP); OHUCHI, Kazuei, Tsukuba-shi Ibaraki 300-3294 (JP)
(74) Representative: J A Kemp LLP
(86) International application number: PCT/JP2018/034562
(87) International publication number: WO 2019/065389

(57) **Abstract**

A light emitting device having an anode, a cathode, a first organic layer and a second organic layer, wherein the first organic layer is a layer containing a metal complex represented by the formula (1), and the second organic layer is a layer containing a metal complex represented by the formula (2) and the like: 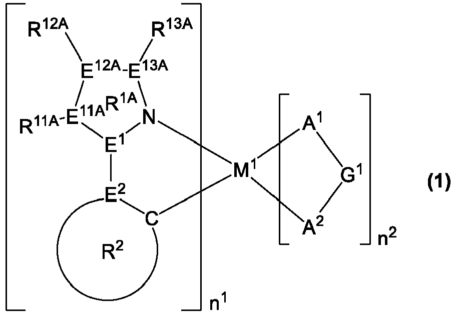 [M¹ represents an iridium atom and the like; n¹ represents an integer of 1 or more; n² represents an integer of 0 or more; Ring R^{1A} represents a triazole ring and the like; Ring R² represents an aromatic hydrocarbon ring and the like; E¹, E² and E^{11A} to E^{13A} represent a nitrogen atom or a carbon atom; R^{11A} to R^{13A} represent a substituent and the like; A¹-G¹-A² represents a bidentate ligand. At least one of E^{11A} to E^{13A} is a nitrogen atom, and at least one of R^{11A} to R^{13A} bonding to the nitrogen atom is a group represented by the formula (Ar-1A).] 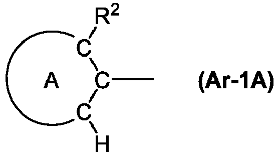 [Ring A represents an aromatic hydrocarbon ring and the like; R² represents a substituent and the like.] 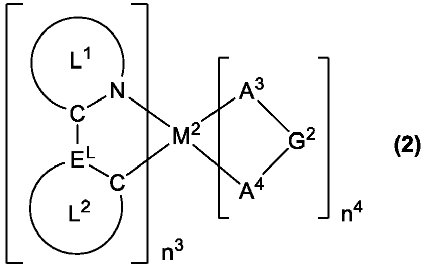 [M² represents an iridium atom and the like; n³ represents an integer of 1 or more; n⁴ represents an integer of 0 or more; E^{L} represents a carbon atom and the like; Ring L¹ represents a 6-membered aromatic hetero ring; Ring L² represents an aromatic hydrocarbon ring and the like; A³-G²⁻A⁴ represents a bidentate ligand.].

## Description

### Technical Field

The present invention relates to a light emitting device.

### Background Art

Light emitting devices such as organic electroluminescent devices and the like can be suitably used for display and lighting applications. For example, Patent Document 1 describes a light emitting device having a light emitting layer containing a metal complex BC1 and a light emitting layer containing a polymer compound containing a constitutional unit derived from a metal complex RM1 (Patent Document 1).

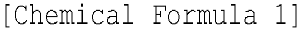

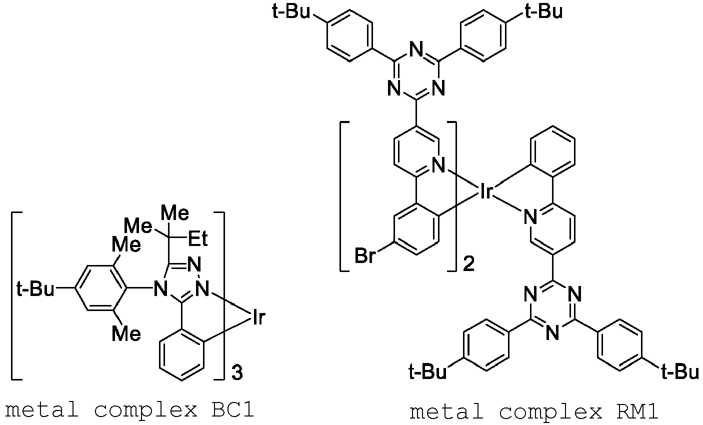

### [Prior Art Document]

### [Patent Document]

[Patent Document 1]International Publication WO 2016/185183

### Summary of the Invention

### Problem to be Solved by the Invention

However, the light emitting device described above was not necessarily sufficient in external quantum efficiency.

Then, the present invention has an objected of proving a light emitting device excellent in external quantum efficiency.

### Means for Solving the Problem

The present invention provides the following [1] to [12].
[1] A light emitting device having an anode, a cathode, and, a first organic layer and a second organic layer disposed between the above-described anode and the above-described cathode, wherein
   the above-described first organic layer is a layer containing a metal complex represented by the formula (1), and
   the above-described second organic layer is a layer containing at least one selected from the group consisting of a metal complex represented by the formula (2) and a polymer compound containing a constitutional unit having a group obtained by removing from the metal complex represented by the formula (2) one or more hydrogen atoms: 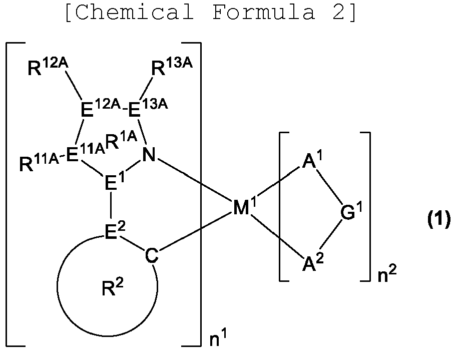 [wherein,
   M¹ represents a rhodium atom, a palladium atom, an iridium atom or a platinum atom.
   n¹ represents an integer of 1 or more and n² represents an integer of 0 or more, provided that n¹ + n² is 3 when M¹ is a rhodium atom or an iridium atom, while n¹ + n² = 2 when M¹ is a palladium atom or a platinum atom.
   Ring R^{1A} represents a diazole ring, a triazole ring or a tetrazole ring.
   Ring R² represents an aromatic hydrocarbon ring or an aromatic hetero ring, and the foregoing rings optionally have a substituent. When a plurality of the above-described substituents are present, they may be combined together to form a ring together with atoms to which they are attached. When a plurality of Ring R² are present, they may be the same or different.
   E¹, E², E^{11A}, E^{12A} and E^{13A} each independently represent a nitrogen atom or a carbon atom. When a plurality of E¹, E², E^{11A}, E^{12A} and E^{13A} are present, they may be the same or different at each occurrence. At least one of E¹ and E² is a carbon atom.
   R^{11A}, R^{12A} and R^{13A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{11A}, R^{12A} and R^{13A} are present, they may be the same or different at each occurrence.
   At least one of E^{11A}, E^{12A} and E^{13A} is a nitrogen atom, and at least one of R^{11A}, R^{12A} and R^{13A} bonding to the nitrogen atom is a group represented by the formula (Ar-1A) .
   R^{11A} and R^{12A} may be combined together to form a ring together with atoms to which they are attached. R^{12A} and R^{13A} may be combined together to form a ring together with atoms to which they are attached. The substituent which Ring R² optionally has and R^{11A} may be combined together to form a ring together with atoms to which they are attached.
   When E^{11A} is a nitrogen atom, R^{11A} may be present or absent. When E^{12A} is a nitrogen atom, R^{12A} may be present or absent. When E^{13A} is a nitrogen atom, R^{13A} may be present or absent.
   A¹-G¹-A² represents an anionic bidentate ligand. A¹ and A² each independently represent a carbon atom, an oxygen atom or a nitrogen atom, and these atoms may be ring-constituent atoms. G¹ represents a single bond or an atomic group constituting a bidentate ligand together with A¹ and A². When a plurality of A¹-G¹-A² are present, they may be the same or different.] 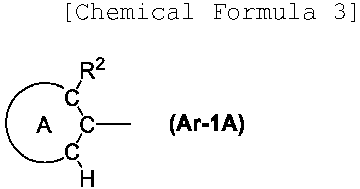
   [wherein,
   Ring A represents an aromatic hydrocarbon ring or an aromatic hetero ring, and the foregoing rings optionally have a substituent. When a plurality of the above-described substituents are present, they may be combined together to form a ring together with atoms to which they are attached.
   R² represents an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent.] 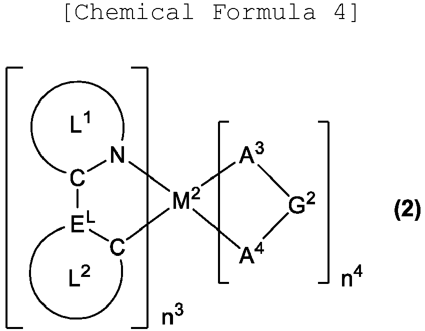
   [wherein,
   M² represents a rhodium atom, a palladium atom, an iridium atom or a platinum atom.
   n³ represents an integer of 1 or more and n⁴ represents an integer of 0 or more, provided that n³ + n⁴ = 3 when M² is a rhodium atom or an iridium atom, while n³ + n⁴ is 2 when M² is a palladium atom or a platinum atom.
   E^{L} represents a carbon atom or a nitrogen atom. When a plurality of E^{L} are present, they may be the same or different at each occurrence.
   Ring L¹ represents a 6-membered aromatic hetero ring, and this ring optionally has a substituent. When a plurality of the above-described substituents are present, they may be combined together to form a ring together with atoms to which they are attached. When a plurality of Ring L¹ are present, they may be the same or different.
   Ring L² represents an aromatic hydrocarbon ring or an aromatic hetero ring, and the foregoing rings optionally have a substituent. When a plurality of the above-described substituents are present, they may be combined together to form a ring together with atoms to which they are attached. When a plurality of Ring L² are present, they may be the same or different.
   The substituent which Ring L¹ optionally has and the substituent which Ring L² optionally has may be combined together to form a ring together with atoms to which they are attached.
   A³-G²-A⁴ represents an anionic bidentate ligand. A³ and A⁴ each independently represent a carbon atom, an oxygen atom or a nitrogen atom, and these atoms may be ring-constituent atoms. G² represents a single bond or an atomic group constituting a bidentate ligand together with A³ and A⁴. When a plurality of A³-G²-A⁴ are present, they may be the same or different.].
[2] The light emitting device according to [1], wherein the above-described second organic layer contains a polymer compound containing a constitutional unit represented by the formula (1-1B), the formula (1-2B), the formula (1-3B) or the formula (1-4B), as the above-described polymer compound containing a constitutional unit having a group obtained by removing from the metal complex represented by the formula (2) one or more hydrogen atoms: 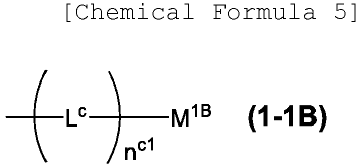 [wherein,
   M^{1B} represents a group obtained by removing from the above-described metal complex represented by the formula (2) one hydrogen atom.
   L^{C} represents an oxygen atom, a sulfur atom, -N(R^{A})-, - C(R^{B})₂-, -C(R^{B})=C(R^{B})-, -C≡C-, an arylene group or a divalent hetero ring group, and the foregoing groups optionally have a substituent. R^{A} represents a hydrogen atom, an alkyl group, a cycloalkyl group, an aryl group or a monovalent hetero ring group, and the foregoing groups optionally have a substituent. R^{B} represents a hydrogen atom, an alkyl group, a cycloalkyl group, an alkoxy group, a cycloalkoxy group, an aryl group or a monovalent hetero ring group, and the foregoing groups optionally have a substituent. A plurality of R^{B} may be the same or different, and they may be combined together to form a ring together with carbon atoms to which they are attached. When a plurality of L^{C} are present, they may be the same or different.
   n^{c1} represents an integer of 0 or more.] 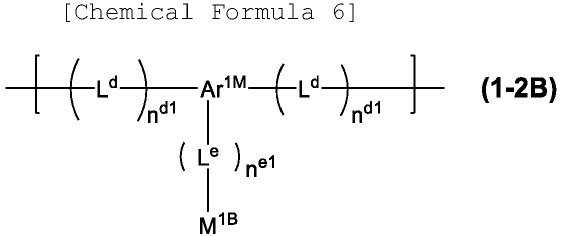
   [wherein,
   M^{1B} represents the same meaning as described above.
   L^{d} and L^{e} each independently represent an oxygen atom, a sulfur atom, -N(R^{A})-, -C(R^{B})₂-, -C(R^{B})=C(R^{B})-, -C≡C-, an arylene group or a divalent hetero ring group, and the foregoing groups optionally have a substituent. R^{A} and R^{B} represent the same meaning as described above. When a plurality of L^{d} and L^{e} are present, they may be the same or different at each occurrence.
   n^{d1} and n^{e1} each independently represent an integer of 0 or more. A plurality of n^{d1} may be the same or different.
   Ar^{1M} represents an aromatic hydrocarbon group or a hetero ring group, and the foregoing groups optionally have a substituent.] 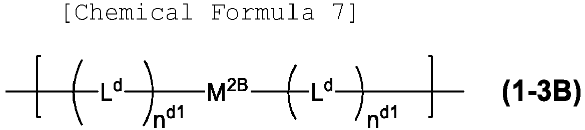
   [wherein,
   L^{d} and n^{d1} represent the same meaning as described above.
   M^{2B} represents a group obtained by removing from the above-described metal complex represented by the formula (2) two hydrogen atoms.] 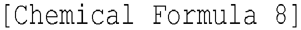 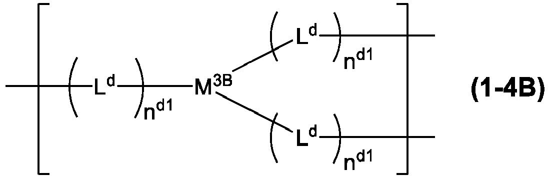
   [wherein,
   L^{d} and n^{d1} represent the same meaning as described above.
   M^{3B} represents a group obtained by removing from the above-described metal complex represented by the formula (2) three hydrogen atoms.].
[3] The light emitting device according to [1] or [2], wherein the above-described metal complex represented by the formula (1) is a metal complex represented by the formula (1-A1) or the formula (1-A2): 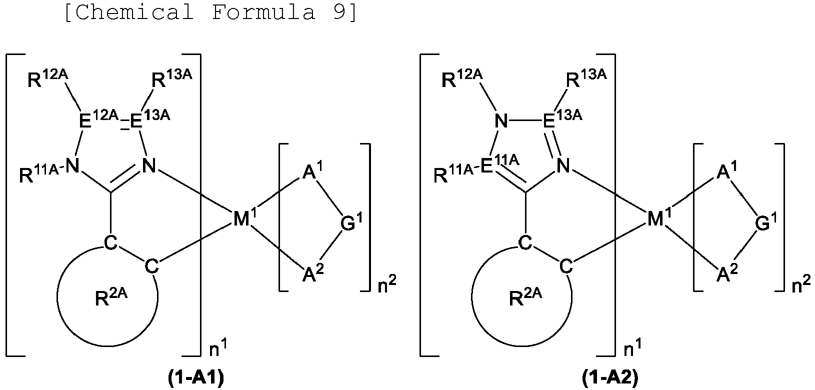
   [wherein, M¹, n¹, n², R^{11A}, R^{12A}, R^{13A}, E^{11A}, E^{12A}, E^{13A} and A¹-G¹-A² represent the same meaning as described above.
   Ring R^{2A} represents a benzene ring, a fluorene ring, a spirobifluorene ring, a dihydrophenanthrene ring, a pyridine ring, a diazabenzene ring, a carbazole ring, a dibenzofuran ring or a dibenzothiophene ring, and the foregoing rings optionally have a substituent. When a plurality of the above-described substituents are present, they may be combined together to form a ring together with atoms to which they are attached. When a plurality of Ring R^{2A} are present, they may be the same or different.
   The substituent which Ring R^{2A} optionally has and R^{11A} may be combined together to form a ring together with atoms to which they are attached.
   In the formula (1-A1), at least one of R^{11A} is the above-described group represented by the formula (Ar-1A), and in the formula (1-A2), at least one of R^{12A} is the above-described group represented by the formula (Ar-1A).].
[4] The light emitting device according to any one of [1] to [3], wherein the above-described group represented by the formula (Ar-1A) is a group represented by the formula (Ar-2A): 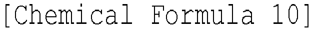 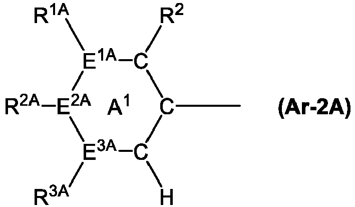 [wherein,
   R² represents the same meaning as described above.
   Ring A¹ represents a benzene ring, a pyridine ring or a diazabenzene ring.
   E^{1A}, E^{2A} and E^{3A} each independently represent a nitrogen atom or a carbon atom. When E^{1A} is a nitrogen atom, R^{1A} is absent. When E^{2A} is a nitrogen atom, R^{2A} is absent. When E^{3A} is a nitrogen atom, R^{3A} is absent.
   R^{1A}, R^{2A} and R^{3A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent.
   R^{1A} and R^{2A}, and, R^{2A} and R^{3A} each may be combined together to form a ring together with atoms to which they are attached.].
[5] The light emitting device according to any one of [1] to [4], wherein the above-described metal complex represented by the formula (2) is a metal complex represented by the formula (2-B): 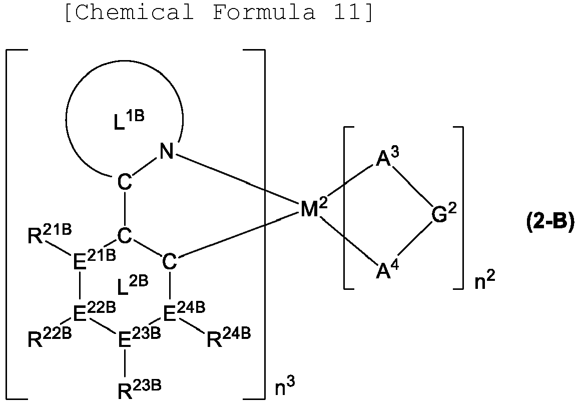 [wherein,
   M², n³, n⁴ and A³-G²-A⁴ represent the same meaning as described above.
   Ring L^{1B} represents a pyridine ring, a diazabenzene ring, an azanaphthalene ring or a diazanaphthalene ring, and the foregoing rings optionally have a substituent. When a plurality of the above-described substituents are present, they may be combined together to form a ring together with atoms to which they are attached. When a plurality of Ring L^{1B} are present, they may be the same or different.
   E^{21B}, E^{22B}, E^{23B} and E^{24B} each independently represent a nitrogen atom or a carbon atom. When a plurality of E^{21B}, E^{22B}, E^{23B} and E^{24B} are present, they may be the same or different at each occurrence. When E^{21B} is a nitrogen atom, R^{21B} is absent. When E^{22B} is a nitrogen atom, R^{22B} is absent. When E^{23B} is a nitrogen atom, R^{23B} is absent. When E^{24B} is a nitrogen atom, R^{24B} is absent.
   R^{21B}, R^{22B}, R^{23B} and R^{24B} each independently represent a hydrogen atom or a group represented by the formula (1-T). When a plurality of R^{21B}, R^{22B}, R^{23B} and R^{24B} are present, they may be the same or different at each occurrence. R^{21B} and R^{22B}, R^{22B} and R^{23B}, R^{23B} and R^{24B}, and, a substituent which Ring L^{1B} optionally has and R^{21B} each may be combined together to form a ring together with atoms to which they are attached.
   Ring L^{2B} represents a benzene ring, a pyridine ring or a diazabenzene ring.]

   [Chemical Formula 12] **-R^{1T} (1-T)**

   [wherein, R^{1T} represents an alkyl group, a cycloalkyl group, an alkoxy group, a cycloalkoxy group, an aryloxy group, an aryl group, a monovalent hetero ring group, a substituted amino group or a halogen atom, and the foregoing groups optionally have a substituent.].
[6] The light emitting device according to [5], wherein at least one of the above-described Ring L^{1B} has the above-described group represented by the formula (1-T), or at least one of the above-described R^{21B}, the above-described R^{22B}, the above-described R^{23B} and the above-described R^{24B} is the above-described group represented by the formula (1-T) .
[7] The light emitting device according to [6], wherein the above-described R^{1T} is an alkyl group optionally having a substituent, a cycloalkyl group optionally having a substituent, a group represented by the formula (D-A), a group represented by the formula (D-B) or a group represented by the formula (D-C): 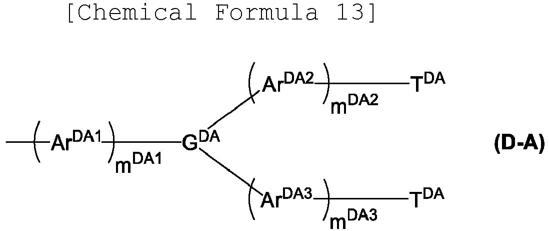 [wherein,
   m^{DA1}, m^{DA2} and m^{DA3} each independently represent an integer of 0 or more.
   G^{DA} represents a nitrogen atom, an aromatic hydrocarbon group or a hetero ring group, and the foregoing groups optionally have a substituent.
   Ar^{DA1}, Ar^{DA2} and Ar^{DA3} each independently represent an arylene group or a divalent hetero ring group, and the foregoing groups optionally have a substituent. When a plurality of Ar^{DA1}, Ar^{DA2} and Ar^{DA3} are present, they may be the same or different at each occurrence.
   T^{DA} represents an aryl group or a monovalent hetero ring group, and the foregoing groups optionally have a substituent. A plurality of T^{DA} may be the same or different.] 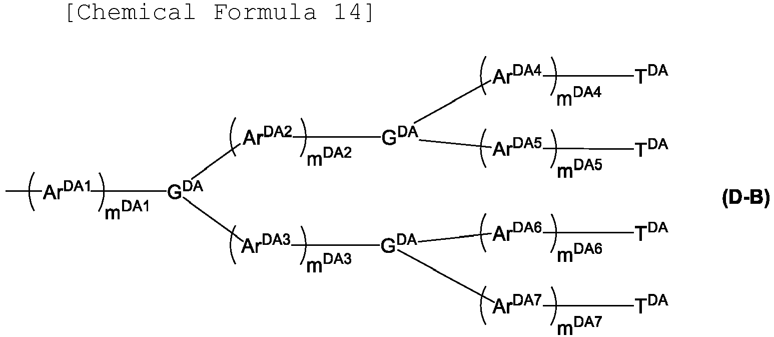
   [wherein,
   m^{DA1}m^{DA2}, m^{DA3}, m^{DA4}, m^{DA5}, m^{DA6} and M^{DA7} each independently represent an integer of 0 or more.
   G^{DA} represents a nitrogen atom, an aromatic hydrocarbon group or a hetero ring group, and the foregoing groups optionally have a substituent. A plurality of G^{DA} may be the same or different.
   Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and the foregoing groups optionally have a substituent. When a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence.
   T^{DA} represents an aryl group or a monovalent hetero ring group, and the foregoing groups optionally have a substituent. A plurality of T^{DA} may be the same or different.] 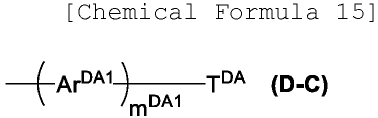
   [wherein,
   m^{DA1} represents an integer of 0 or more.
   Ar^{DA1} represents an arylene group or a divalent hetero ring group, and the foregoing groups optionally have a substituent. When a plurality of Ar^{DA1} are present, they may be the same or different.
   T^{DA} represents an aryl group or a monovalent hetero ring group, and the foregoing groups optionally have a substituent.].
[8] The light emitting device according to any one of [1] to [7], wherein the above-described first organic layer further comprises a compound represented by the formula (H-1) or a polymer compound containing a constitutional unit represented by the formula (Y), or a combination thereof: 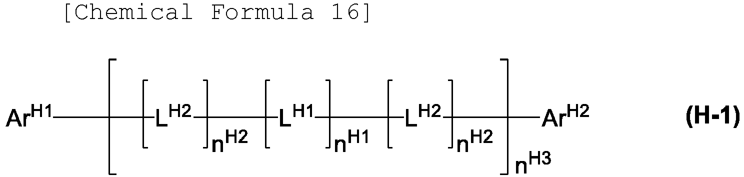 [wherein,
   Ar^{H1} and Ar^{H2} each independently represent an aryl group or a monovalent hetero ring group, and the foregoing groups optionally have a substituent.
   n^{H1} and n^{H2} each independently represent 0 or 1. When a plurality of n^{H1} are present, they may be the same or different. A plurality of n^{H2} may be the same or different.
   n^{H3} represents an integer of 0 or more and 10 or less.
   L^{H1} represents an arylene group, a divalent hetero ring group or a group represented by -[C(R^{H11})₂]n^{H11}-, and the foregoing groups optionally have a substituent. When a plurality of L^{H1} are present, they may be the same or different. n^{H11} represents an integer of 1 or more and 10 or less. R^{H11} represents a hydrogen atom, an alkyl group, a cycloalkyl group, an alkoxy group, a cycloalkoxy group, an aryl group or a monovalent hetero ring group, and the foregoing groups optionally have a substituent. A plurality of R^{H11} may be the same or different, and they may be combined together to form a ring together with carbon atoms to which they are attached.
   L^{H2} represents a group represented by -N(-L^{H21}-R^{H21})-. When a plurality of L^{H2} are present, they may be the same or different. L^{H21} represents a single bond, an arylene group or a divalent hetero ring group, and the foregoing groups optionally have a substituent. R^{H21} represents a hydrogen atom, an alkyl group, a cycloalkyl group, an aryl group or a monovalent hetero ring group, and the foregoing groups optionally have a substituent.] 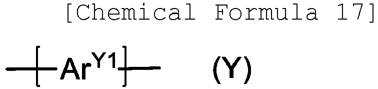
   [wherein, Ar^{Y1} represents an arylene group, a divalent hetero ring group, or a divalent group in which at least one arylene group and at least one divalent hetero ring group are bonded directly, and the foregoing groups optionally have a substituent.].
[9] The light emitting device according to any one of [1] to [8], wherein the maximum peak wavelength of the emission spectrum of the above-described metal complex represented by the formula (1) is 380 nm or more and less than 495 nm, and the maximum peak wavelength of the emission spectrum of the above-described metal complex represented by the formula (2) is 495 nm or more and less than 750 nm.
[10] The light emitting device according to any one of [1] to [9], wherein the above-described first organic layer and the above-described second organic layer are adjacent.
[11] The light emitting device according to any one of [1] to [10], wherein the above-described second organic layer is a layer disposed between the above-described anode and the above-described first organic layer.
[12] The light emitting device according to any one of [1] to [11], wherein the above-described first organic layer is a first light emitting layer, and the above-described second organic layer is a second light emitting layer.

### Effect of the Invention

According to the present invention, a light emitting device excellent in external quantum efficiency can be provided.

### Modes for Carrying Out the Invention

Suitable embodiments of the present invention will be illustrated in detail below.

### <Explanation of common terms>

Terms commonly used in the present specification have the following meanings unless otherwise stated.

Me represents a methyl group, Et represents an ethyl group, Bu represents a butyl group, i-Pr represents an isopropyl group and t-Bu represents a tert-butyl group.

A hydrogen atom may be a heavy hydrogen atom or a light hydrogen atom.

In the formula representing a metal complex, the solid line representing a bond with a metal means an ionic bond, a covalent bond or a coordination bond.

"Polymer compound" means a polymer having molecular weight distribution and having a polystyrene-equivalent number-average molecular weight of 1×10³ to 1×10⁸.

The polymer compound may be any of a block copolymer, a random copolymer, an alternating copolymer and a graft copolymer, and may also be a compound in another form.

The end group of the polymer compound is preferably a stable group since if a polymerization active group remains intact there, there is a possibility of a decrease in a light emitting property or luminance life when the polymer compound is used for fabrication of a light emitting device. The end group of the polymer compound is preferably a group conjugatively bonded to the main chain and includes, for example, an aryl group or a monovalent hetero ring group bonding to the main chain of the polymer compound via a carbon-carbon bond.

"Low molecular compound" means a compound having no molecular weight distribution and having a molecular weight of 1×10⁴ or less.

"Constitutional unit" means a unit occurring once or more times in the polymer compound.

"Alkyl group" may be any of linear and branched. The number of carbon atoms of the linear alkyl group, not including the number of carbon atoms of the substituent, is usually 1 to 50, preferably 3 to 30, more preferably 4 to 20. The number of carbon atoms of the branched alkyl group, not including the number of carbon atoms of the substituent, is usually 3 to 50, preferably 3 to 30, more preferably 4 to 20.

The alkyl group optionally has a substituent and examples thereof include, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom and the like (for example, a trifluoromethyl group, a pentafluoroethyl group, a perfluorobutyl group, a perfluorohexyl group, a perfluorooctyl group, a 3-phenylpropyl group, a 3 (4-methylphenyl)propyl group, a 3 (3,5-di-hexylphenyl)propyl group, a 6-ethyloxyhexyl group).

The number of carbon atoms of "cycloalkyl group", not including the number of carbon atoms of the substituent, is usually 3 to 50, preferably 3 to 30, more preferably 4 to 20.

The cycloalkyl group optionally has a substituent and examples thereof include a cyclohexyl group, a cyclohexylmethyl group and a cyclohexylethyl group.

"Aryl group" means an atomic group remaining after removing from an aromatic hydrocarbon one hydrogen atom bonding directly to a carbon atom constituting the ring. The number of carbon atoms of the aryl group, not including the number of carbon atoms of the substituent, is usually 6 to 60, preferably 6 to 20, more preferably 6 to 10.

The aryl group optionally has a substituent and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom and the like.

"Alkoxy group" may be any of linear and branched. The number of carbon atoms of the linear alkoxy group, not including the number of carbon atoms of the substituent, is usually 1 to 40, preferably 4 to 10. The number of carbon atoms of the branched alkoxy group, not including the number of carbon atoms of the substituent, is usually 3 to 40, preferably 4 to 10.

The alkoxy group optionally has a substituent and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of the "cycloalkoxy group", not including the number of carbon atoms of the substituent, is usually 3 to 40, preferably 4 to 10.

The cycloalkoxy group optionally has a substituent and examples thereof include a cyclohexyloxy group.

The number of carbon atoms of the "aryloxy group", not including the number of carbon atoms of the substituent, is usually 6 to 60, preferably 6 to 48.

The aryloxy group optionally has a substituent and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom or the like.

"p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of the p-valent hetero ring groups, "p-valent aromatic hetero ring group" as an atomic group remaining after removing from an aromatic heterocyclic compound p hydrogen atoms among hydrogen atoms bonding directly to carbon atoms or hetero atoms constituting the ring is preferable.

"Aromatic heterocyclic compound " means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to the hetero ring even if the hetero ring itself shows no aromaticity such as phenoxazine, phenothiazine, dibenzoborole, dibenzosilole, benzopyran and the like.

The number of carbon atoms of the monovalent hetero ring group, not including the number of carbon atoms of the substituent, is usually 2 to 60, preferably 4 to 20.

The monovalent hetero ring group optionally has a substituent and examples thereof include a thienyl group, a pyrrolyl group, a furyl group, a pyridinyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferred. The substituent which the amino group has is preferably an alkyl group, a cycloalkyl group, an aryl group or a monovalent hetero ring group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear and branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of the "cycloalkenyl group", not including the number of carbon atoms of the substituent, is usually 3 to 30, preferably 4 to 20.

The alkenyl group and the cycloalkenyl group optionally have a substituent and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"Alkynyl group" may be any of linear and branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of the "cycloalkynyl group", not including the number of carbon atoms of the substituent, is usually 4 to 30, preferably 4 to 20.

The alkynyl group and the cycloalkynyl group optionally have a substituent and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"Arylene group" means an atomic group remaining after removing from an aromatic hydrocarbon two hydrogen atoms bonding directly to carbon atoms constituting the ring. The number of carbon atoms of the arylene group, not including the number of carbon atoms of the substituent, is usually 6 to 60, preferably 6 to 30, more preferably 6 to 18.

The arylene group optionally has a substituent and examples thereof include a phenylene group, a naphthalenediyl group, an anthracenediyl group, a phenanthrenedilyl group, a dihydrophenanthrenedilyl group, a naphthacenediyl group, a fluorenediyl group, a pyrenediyl group, a perylenediyl group and a chrysenediyl group, and these groups having a substituent, and groups represented by the formula (A-1) to the formula (A-20) are preferable. The arylene group includes groups obtained by bonding a plurality of these groups. 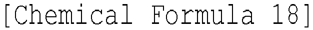 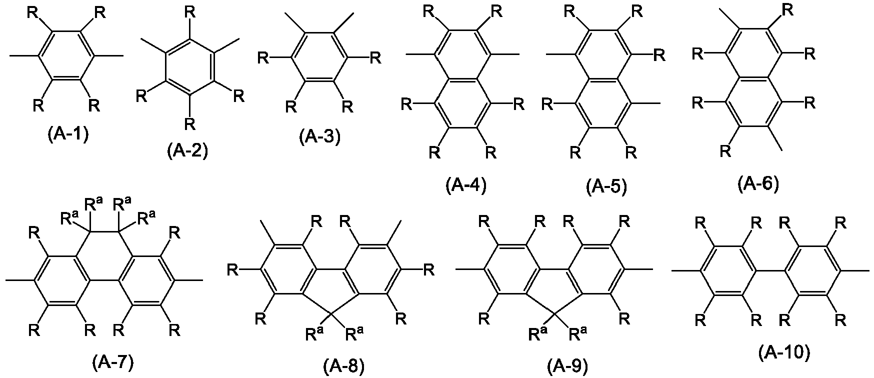 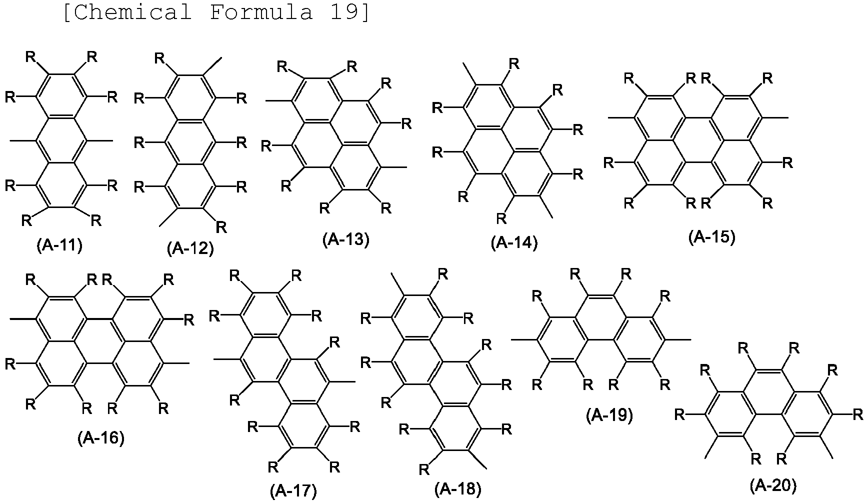 [wherein, R and R^{a} each independently represent a hydrogen atom, an alkyl group, a cycloalkyl group, an aryl group or a monovalent hetero ring group. A plurality of R and R^{a} each may be the same or different, and the plurality of R^{a} may be combined together to form a ring together with atoms to which they are attached.]

The number of carbon atoms of the divalent hetero ring group, not including the number of carbon atoms of the substituent, is usually 2 to 60, preferably 3 to 20, more preferably 4 to 15.

The divalent hetero ring group optionally has a substituent and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms bonding directly to carbon atoms or hetero atoms constituting the ring, preferably groups represented by the formula (AA-1) to the formula (AA-34). The divalent hetero ring group includes groups obtained by bonding a plurality of these groups. 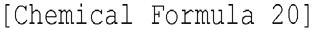 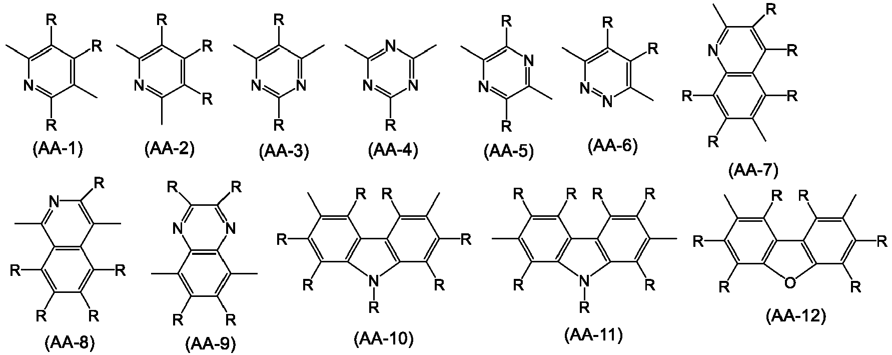 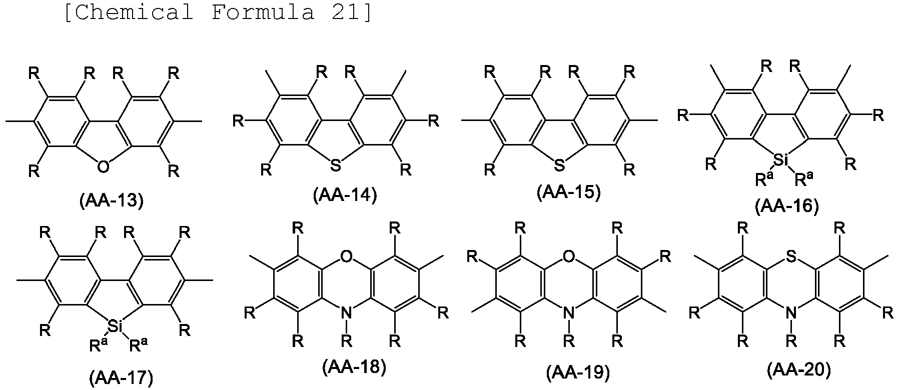 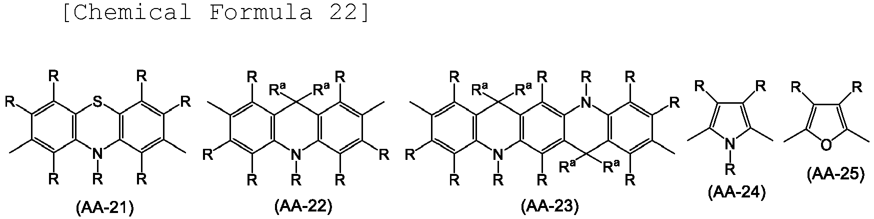 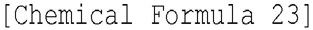 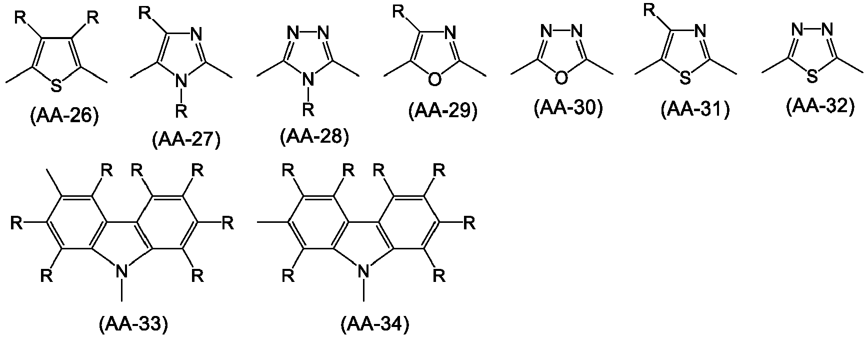 [wherein, R and R^{a} represent the same meaning as described above.]

"Crosslinking group" refers to a group capable of generating a new bond by being subjected to a heating treatment, an ultraviolet irradiation treatment, a near-ultraviolet irradiation treatment, a visible light irradiation treatment, an infrared irradiation treatment, a radical reaction and the like, preferably includes crosslinking groups represented by the formula (XL-1) to the formula (XL-19) in the Group A of crosslinking group. 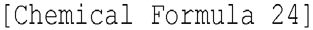 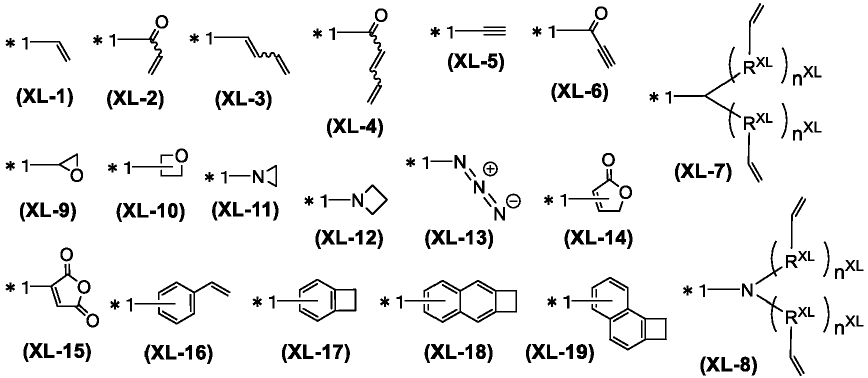 [wherein, R^{XL} represents a methylene group, an oxygen atom or a sulfur atom, and n^{XL} represents an integer of 0 to 5. When a plurality of R^{XL} are present, they may be the same or different. When a plurality of n^{XL} are present, they may be the same or different. *1 represents a binding position. These crosslinking groups optionally have a substituent, and when a plurality of the substituents are present, they may be combined together to form a ring together with carbon atoms to which they are attached.]

"Substituent" denotes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may also be a crosslinking group.

### <Light emitting device>

The light emitting device of the present invention is a light emitting device having an anode, a cathode, and, a first organic layer and a second organic layer disposed between the above-described anode and the above-described cathode, wherein the above-described first organic layer is a layer containing a metal complex represented by the formula (1), and the above-described second organic layer is a layer containing at least one selected from the group consisting of a metal complex represented by the formula (2) and a polymer compound containing a constitutional unit having a group obtained by removing from the metal complex represented by the formula (2) one or more hydrogen atoms.

### (First organic layer)

The first organic layer is a layer containing a metal complex represented by the formula (1). In the first organic layer, the metal complex represented by the formula (1) may be contained singly or in combination of two or more kinds thereof.

The content of the metal complex represented by the formula (1) in first organic layer may be within a range in which the function as the first organic layer is exhibited. For example, the content of the metal complex represented by the formula (1) may be 0.1 to 50% by mass, and is preferably 1 to 40% by mass, more preferably 10 to 30% by mass, based on the total amount of the first organic layer.

### [Metal complex represented by the formula (1)]

The metal complex represented by the formula (1) is usually a metal complex showing phosphorescence at room temperature (25°C), preferably a metal complex showing light emission from triplet excited state at room temperature.

M¹ is preferably an iridium atom or a platinum atom, more preferably an iridium atom, since the light emitting device of the present invention is more excellent in external quantum efficiency.

When M¹ is a rhodium atom or an iridium atom, n¹ is preferably 2 or 3, more preferably 3.

When M¹ is a palladium atom or a platinum atom, n¹ is preferably 2.

E¹ and E² are each preferably a carbon atom.

When Ring R^{1A} is a diazole ring, Ring R^{1A} is preferably an imidazole ring in which E^{11A} is a nitrogen atom, or an imidazole ring in which E^{12A} is a nitrogen atom, more preferably an imidazole ring in which E^{11A} is a nitrogen atom.

When Ring R^{1A} is a triazole ring, Ring R^{1A} is preferably a triazole ring in which E^{11A} and E^{12A} are each a nitrogen atom, or a triazole ring in which E^{11A} and E^{13A} are each a nitrogen atom, more preferably a triazole ring in which E^{11A} and E^{13A} are each a nitrogen atom.

When Ring R^{1A}is a tetrazole ring, Ring R^{1A} is preferably a tetrazole ring in which E^{11A} to E^{13A} are each a nitrogen atom.

Ring R^{1A} is preferably a diazole ring or a triazole ring, more preferably a triazole ring, since the light emitting device of the present invention is more excellent in external quantum efficiency.

When E^{11A} is a nitrogen atom and R^{11A} is present, R^{11A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{11A} is a carbon atom, R^{11A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

When E^{12A} is a nitrogen atom and R^{12A} is present, R^{12A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{12A} is a carbon atom, R^{12A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

When E^{13A} is a nitrogen atom and R^{13A} is present, R^{13A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{13a} is a carbon atom, R^{13A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

The aryl group represented by R^{11A} to R^{13A} is preferably a phenyl group, a naphthyl group, a phenanthrenyl group, a dihydrophenanthrenyl group, a fluorenyl group or a spirobifluorenyl group, more preferably a phenyl group, a fluorenyl group or a spirobifluorenyl group, further preferably a phenyl group, and the foregoing groups optionally have a substituent.

The monovalent hetero ring group represented by R^{11A} to R^{13A} is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiazinyl group, more preferably a pyridyl group, a pyrimidinyl group, a triazinyl group, a dibenzofuranyl group, a dibenzothienyl group or a carbazolyl group, further preferably a pyridyl group, a pyrimidinyl group or a triazinyl group, and the foregoing groups optionally have a substituent.

In the substituted amino group represented by R^{11A} to R^{13A}, the substituent which an amino group has is preferably an aryl group or a monovalent hetero ring group, more preferably an aryl group, and the foregoing groups optionally further have a substituent. The examples and preferable ranges of the aryl group and the monovalent hetero ring group as the substituent which an amino group has are the same as the examples and preferable ranges of the aryl group and the monovalent hetero ring group represented by R^{11A} to R^{13A}.

The substituent which R^{11A} to R^{13A} optionally have is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group, a cycloalkyl group or an aryl group, particularly preferably an alkyl group, and the foregoing groups optionally further have a substituent.

The substituent which the substituent which R^{11A} to R^{13A} optionally have optionally further has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group or a cycloalkyl group. The foregoing groups optionally further have a substituent, but it is preferable that they do not further have a substituent.

The aryl group, the monovalent hetero ring group or the substituted amino group represented by R^{11A} to R^{13A} is preferably a group represented by the formula (D-A) to the formula (D-C), more preferably a group represented by the formula (D-A) or the formula (D-C), since the light emitting device of the present invention is more excellent in external quantum efficiency.

### [Group represented by the formula (D-A) to the formula (D-C)]

m^{DA1} to m^{DA7} are each usually an integer of 10 or less, preferably an integer of 5 or less, more preferably an integer of 2 or less, further preferably 0 or 1. It is preferable that m^{DA2} to m^{DA7} represent the same integer, it is more preferable that m^{DA1} to m^{DA7} represent the same integer.

G^{DA} is preferably an aromatic hydrocarbon group or a hetero ring group, more preferably a group obtained by removing from a benzene ring, a pyridine ring, a pyrimidine ring, a triazine ring or a carbazole ring three hydrogen atoms bonding directly to carbon atoms or nitrogen atoms constituting the ring, and the foregoing groups optionally have a substituent.

The substituent which G^{DA} optionally has is preferably an alkyl group, a cycloalkyl group, an alkoxy group, a cycloalkoxy group, an aryl group or a monovalent hetero ring group, more preferably an alkyl group, a cycloalkyl group, an alkoxy group or a cycloalkoxy group, further preferably an alkyl group or a cycloalkyl group. The foregoing groups optionally further have a substituent, but it is preferable that they do not further have a substituent.

G^{DA} is preferably a group represented by the formula (GDA-11) to the formula (GDA-15), more preferably a group represented by the formula (GDA-11) to the formula (GDA-14), further preferably a group represented by the formula (GDA-11) or the formula (GDA-14), particularly a group represented by the formula (GDA-11). 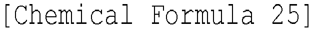 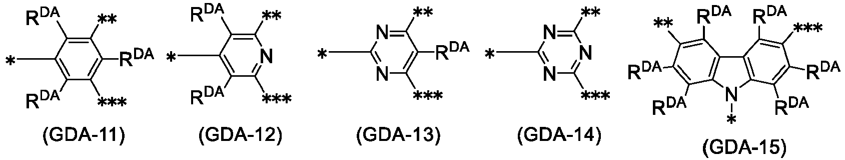 [wherein,
* represents a bond to Ar^{DA1} in the formula (D-A), to Ar^{DA1} in the formula (D-B), to Ar^{DA2} in the formula (D-B) or to Ar^{DA3} in the formula (D-B) .
** represents a bond to Ar^{DA2} in the formula (D-A), to Ar^{DA2} in the formula (D-B), to Ar^{DA4} in the formula (D-B) or to Ar^{DA6} in the formula (D-B) .
*** represents a bond to Ar^{DA3} in the formula (D-A), to Ar^{DA3} in the formula (D-B), to Ar^{DA5} in the formula (D-B) or to Ar^{DA7} in the formula (D-B).

R^{DA} represents a hydrogen atom, an alkyl group, a cycloalkyl group, an alkoxy group, a cycloalkoxy group, an aryl group or a monovalent hetero ring group, and the foregoing groups optionally further have a substituent. When a plurality of R^{DA} are present, they may be the same or different.]

R^{DA} is preferably a hydrogen atom, an alkyl group, a cycloalkyl group, an alkoxy group or a cycloalkoxy group, more preferably a hydrogen atom, an alkyl group or a cycloalkyl group, and the foregoing groups optionally have a substituent.

Ar^{DA1} to Ar^{DA7} are each preferably a phenylene group, a fluorenediyl group or a carbazolediyl group, more preferably a group represented by the formula (ArDA-1) to the formula (ArDA-6), further preferably a group represented by the formula (ArDA-1) to the formula (ArDA-3), particularly preferably a group represented by the formula (ArDA-1), and the foregoing groups optionally have a substituent. 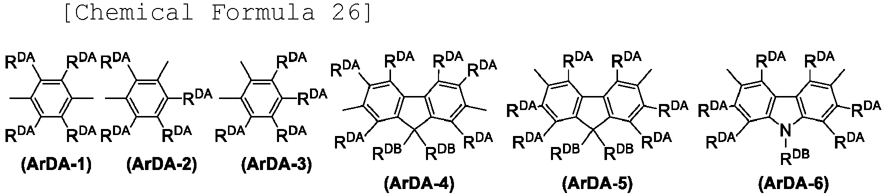 [wherein,
R^{DA} represents the same meaning as described above.
R^{DB} represents a hydrogen atom, an alkyl group, a cycloalkyl group, an aryl group or a monovalent hetero ring group, and the foregoing groups optionally have a substituent. When a plurality of R^{DB} are present, they may be the same or different, and they may be combined together to form a ring together with carbon atoms to which they are attached.]

R^{DB} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

The examples and preferable range of the substituent which Ar^{DA1} to Ar^{DA7}, R^{DA} and R^{DB} optionally have are the same as the examples and preferable range of the substituent which G^{DA} optionally has.

T^{DA} is preferably a group represented by the formula (TDA-1) to the formula (TDA-4), more preferably a group represented by the formula (TDA-1) or the formula (TDA-3), further preferably a group represented by the formula (TDA-1) . 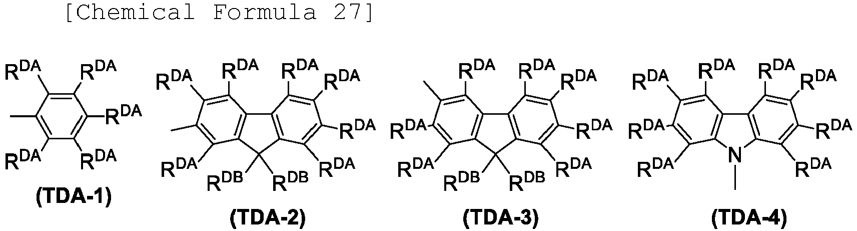 [wherein, R^{DA} and R^{DB} represent the same meaning as described above.]

The group represented by the formula (D-A) is preferably a group represented by the formula (D-A1) to the formula (D-A5), more preferably a group represented by the formula (D-A1), the formula (D-A3) or the formula (D-A5), further preferably a group represented by the formula (D-A1). 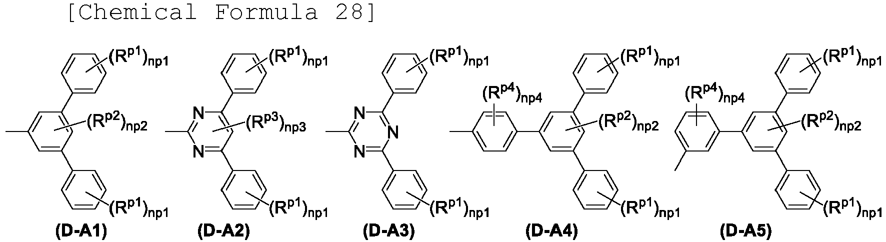 [wherein,
R^{p1} to RP4 each independently represent an alkyl group, a cycloalkyl group, an alkoxy group, a cycloalkoxy group or a halogen atom. When a plurality of R^{p1}, R^{p2} and R^{p4} are present, they may be the same or different at each occurrence.
np1 represents an integer of 0 to 5, np2 represents an integer of 0 to 3, np3 represents 0 or 1 and np4 represents an integer of 0 to 4. A plurality of np1 may be the same or different.]

The group represented by the formula (D-B) is preferably a group represented by the formula (D-B1) to the formula (D-B3), more preferably a group represented by the formula (D-B1). 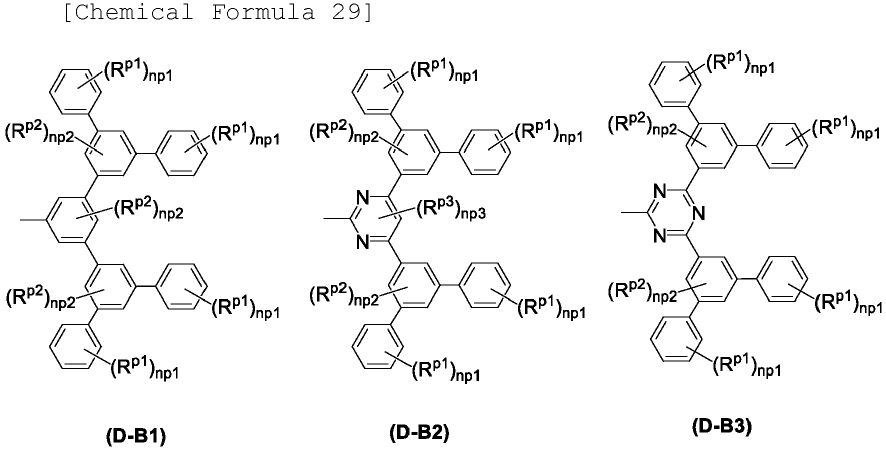 [wherein,
R^{p1} to RP3 each independently represent an alkyl group, a cycloalkyl group, an alkoxy group, a cycloalkoxy group or a halogen atom. When a plurality of R^{p1} and R^{p2} are present, they may be the same or different at each occurrence.
np1 represents an integer of 0 to 5, np2 represents an integer of 0 to 3, np3 represents 0 or 1. When a plurality of np1 and np2 are present, they may be the same or different at each occurrence.]

The group represented by the formula (D-C) is preferably a group represented by the formula (D-C1) to the formula (D-C4), more preferably a group represented by the formula (D-C1) to the formula (D-C3), further preferably a group represented by the formula (D-C1) or the formula (D-C2), particularly preferably a group represented by the formula (D-C1). 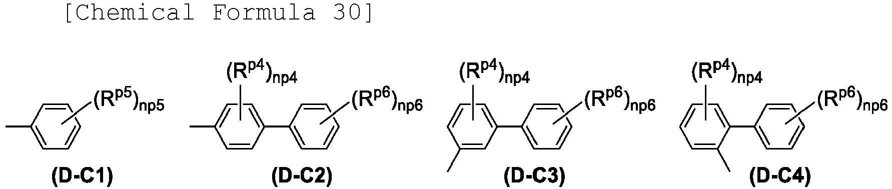 [wherein,
RP4 to RP6 each independently represent an alkyl group, a cycloalkyl group, an alkoxy group, a cycloalkoxy group or a halogen atom. When a plurality of RP4 to RP6 are present, they may be the same or different at each occurrence.
np4 represents an integer of 0 to 4, np5 represents an integer of 0 to 5 and np6 represents an integer of 0 to 5.]

np1 is preferably 0 or 1. np2 is preferably 0 or 1, more preferably 0. np3 is preferably 0. np4 is preferably an integer of 0 to 2. np5 is preferably an integer of 1 to 3. np6 is preferably an integer of 0 to 2.

RP1 to RP6 are each preferably an alkyl group or a cycloalkyl group, more preferably a methyl group, an ethyl group, an isopropyl group, a tert-butyl group, a hexyl group, a 2-ethylhexyl group, a cyclohexyl group or a tert-octyl group, further preferably a methyl group, an ethyl group, an isopropyl group, a tert-butyl group, a hexyl group, a 2-ethylhexyl group or a tert-octyl group.

In Ring R^{1A}, it is preferable that at least one of E^{11A} and E^{12A} is a nitrogen atom and at least one of R^{11A} and R^{12A} bonding to the nitrogen atom is a group represented by the formula (Ar-1A), it is more preferable that E^{11A} is a nitrogen atom and R^{11A} bonding to the nitrogen atom is a group represented by the formula (Ar-1A), since the light emitting device of the present invention is more excellent in external quantum efficiency.

When a plurality of Ring R^{1A} are present, it may be permissible that at least one of E^{11A} to E^{13A} is a nitrogen atom and at least one of R^{11A} to R^{13A} bonding to the nitrogen atom is a group represented by the formula (Ar-1A), in at least one of the plurality of Ring R^{1A}, and since synthesis of a metal complex represented by the formula (1) is easy, it is preferable that at least one of E^{11A} to E^{13A} is a nitrogen atom and at least one of R^{11A} to R^{13A} bonding to the nitrogen atom is a group represented by the formula (Ar-1A), in at least two of the plurality of Ring R^{1A}, it is more preferable that at least one of E^{11A} to E^{13A} is a nitrogen atom and at least one of R^{11A} to R^{13A} bonding to the nitrogen atom is a group represented by the formula (Ar-1A), in all of the plurality of Ring R^{1A}.

The number of carbon atoms of the aromatic hydrocarbon ring as Ring R², not including the number of carbon atoms of the substituent, is usually 6 to 60, preferably 6 to 30, more preferably 6 to 18. The aromatic hydrocarbon ring as Ring R² includes, for example, a benzene ring, a naphthalene ring, an indene ring, a fluorene ring, a spirobifluorene ring, a phenanthrene ring and a dihydrophenanthrene ring, and rings obtained by condensation of one or more and five or less of these rings, and since the light emitting device of the present invention is more excellent in external quantum efficiency, it is preferably a benzene ring, a naphthalene ring, a fluorene ring, a spirobifluorene ring, a phenanthrene ring or a dihydrophenanthrene ring, more preferably a benzene ring, a fluorene ring, a spirobifluorene ring or a dihydrophenanthrene ring, further preferably a benzene ring or a fluorene ring, particularly preferably a benzene ring, and the foregoing rings optionally have a substituent.

The number of carbon atoms of the aromatic hetero ring as Ring R², not including the number of carbon atoms of the substituent, is usually 2 to 60, preferably 3 to 30, more preferably 4 to 15. The aromatic hetero ring as Ring R² includes, for example, a pyrrole ring, a diazole ring, a furan ring, a thiophene ring, a pyridine ring and a diazabenzene ring, and rings obtained by condensation of one or more and five or less aromatic rings to these rings, and since the light emitting device of the present invention is more excellent in external quantum efficiency, it is preferably a pyridine ring, a diazabenzene ring, an azanaphthalene ring, a diazanaphthalene ring, an indole ring, a benzofuran ring, a benzothiophene ring, a carbazole ring, an azacarbazole ring, a diazacarbazole ring, a dibenzofuran ring or a dibenzothiophene ring, more preferably a pyridine ring, a diazabenzene ring, a carbazole ring, a dibenzofuran ring or a dibenzothiophene ring, further preferably a carbazole ring, a dibenzofuran ring or a dibenzothiophene ring, particularly preferably a dibenzofuran ring, and the foregoing rings optionally have a substituent. When Ring R² is a 6-membered aromatic hetero ring, E² is preferably a carbon atom.

Ring R² is preferably a benzene ring, a fluorene ring, a spirobifluorene ring, a dihydrophenanthrene ring, a pyridine ring, a diazabenzene ring, a carbazole ring, a dibenzofuran ring or a dibenzothiophene ring, more preferably a benzene ring, a fluorene ring, a carbazole ring, a dibenzofuran ring or a dibenzothiophene ring, further preferably a benzene ring or a dibenzofuran ring, and the foregoing rings optionally have a substituent, since the light emitting device of the present invention is further excellent in external quantum efficiency.

The substituent which Ring R² optionally has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group or an aryl group, and the foregoing groups optionally further have a substituent.

The examples and preferable ranges of the aryl group, the monovalent hetero ring group and the substituted amino group as the substituent which Ring R² optionally has are the same as the examples and preferable ranges of the aryl group, the monovalent hetero ring group and the substituted amino group represented by R^{11A} to R^{13A}, respectively.

The examples and preferable range of the substituent which the substituent which Ring R² optionally has optionally further has are the same as the examples and preferable range of the substituent which R^{11A} to R^{13A} optionally have.

It is preferable that R^{11A} and R^{12A}, R^{12A} and R^{13A}, and a substituent which Ring R² optionally has and R^{11A} are each not combined together to form a ring together with atoms to which they are attached, since synthesis of a metal complex represented by the formula (1) is easy.

### [Group represented by the formula (Ar-1A)]

The examples and preferable range of the aromatic hydrocarbon ring as Ring A are the same as the examples and preferable range of the aromatic hydrocarbon ring as Ring R². The examples and preferable range of the aromatic hetero ring as Ring A are the same as the examples and preferable range of the aromatic hetero ring as Ring R².

Ring A is preferably a benzene ring, a fluorene ring, a spirobifluorene ring, a dihydrophenanthrene ring, a pyridine ring, a diazabenzene ring, a carbazole ring, a dibenzofuran ring or a dibenzothiophene ring, more preferably a benzene ring, a pyridine ring or a diazabenzene ring, further preferably a benzene ring, and the foregoing rings optionally have a substituent, since the light emitting device of the present invention is more excellent in external quantum efficiency.

The examples and preferable range of the substituent which Ring A optionally has are the same as the examples and preferable range of the substituent which Ring R² optionally has.

When a plurality of the substituents which Ring A optionally has are present, it is preferable that they are not combined together to form a ring together with atoms to which they are attached, since synthesis of a metal complex represented by the formula (1) is easy.

R² is preferably an alkyl group, a cycloalkyl group, an aryl group, a monovalent hetero ring group or a substituted amino group, more preferably an alkyl group, a cycloalkyl group or an aryl group, further preferably an alkyl group, and the foregoing groups optionally further have a substituent, since the light emitting device of the present invention is more excellent in external quantum efficiency.

The examples and preferable ranges of the aryl group, the monovalent hetero ring group and the substituted amino group represented by R² are the same as the examples and preferable ranges of the aryl group, the monovalent hetero ring group and the substituted amino group represented by R^{11A} to R^{13A}.

The examples and preferable range of the substituent which R² optionally has are the same as the examples and preferable range of the substituent which R^{11A} to R^{13A} optionally have.

The group represented by the formula (Ar-1A) is preferably a group represented by the formula (Ar-2A), since the light emitting device of the present invention is more excellent in external quantum efficiency.

E^{1A} to E^{3A} are each preferably a carbon atom.

When Ring A¹ is a pyridine ring, a pyridine ring in which E^{1A} is a nitrogen atom is preferable.

When Ring A¹ is a diazabenzene ring, a pyrimidine ring in which E^{1A} and E^{3A} are each a nitrogen atom is preferable.

Ring A¹ is preferably a benzene ring.

R^{1A} to R^{3A} are each preferably a hydrogen atom, an alkyl group, a cycloalkyl group, an aryl group, a monovalent hetero ring group or a substituted amino group, more preferably a hydrogen atom, an alkyl group or an aryl group, and the foregoing groups optionally have a substituent, since the light emitting device of the present invention is more excellent in external quantum efficiency.

R^{1A} and R^{3A} are each further preferably a hydrogen atom.

R^{2A} is further preferably an alkyl group or an aryl group, and the foregoing groups optionally have a substituent.

The examples and preferable ranges of the aryl group, the monovalent hetero ring group and the substituted amino group represented by R^{1A} to R^{3A} are the same as the examples and preferable ranges of the aryl group, the monovalent hetero ring group and the substituted amino group represented by R^{11A} to R^{13A}, respectively.

The examples and preferable range of the substituent which R^{1A} to R^{3A} optionally have are the same as the examples and preferable range of the substituent which R^{11A} to R^{13A} optionally have.

R^{1A} and R^{2A}, and, R^{2A} and R^{3A} each may be combined together to form a ring together with atoms to which they are attached, since synthesis of a metal complex represented by the formula (1) is easy, however, it is preferable that they are not combined to form a ring.

The group represented by the formula (Ar-2A) is preferably a group represented by the formula (Ar-3A), since the light emitting device of the present invention is more excellent in external quantum efficiency. 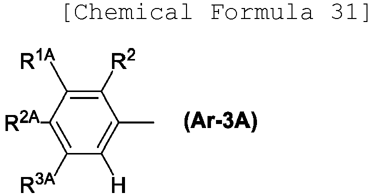 [wherein, R², R^{1A}, R^{2A} and R^{3A} represent the same meaning as described above.]

### [Anionic bidentate ligand]

The anionic bidentate ligand represented by A¹-G¹-A² includes, for example, ligands represented by the following formulae. However, the anionic bidentate ligand represented by A¹-G¹-A² is different from a ligand of which number is defined by subscript n¹. 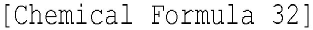 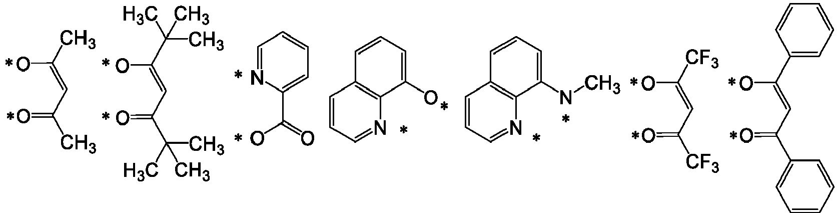 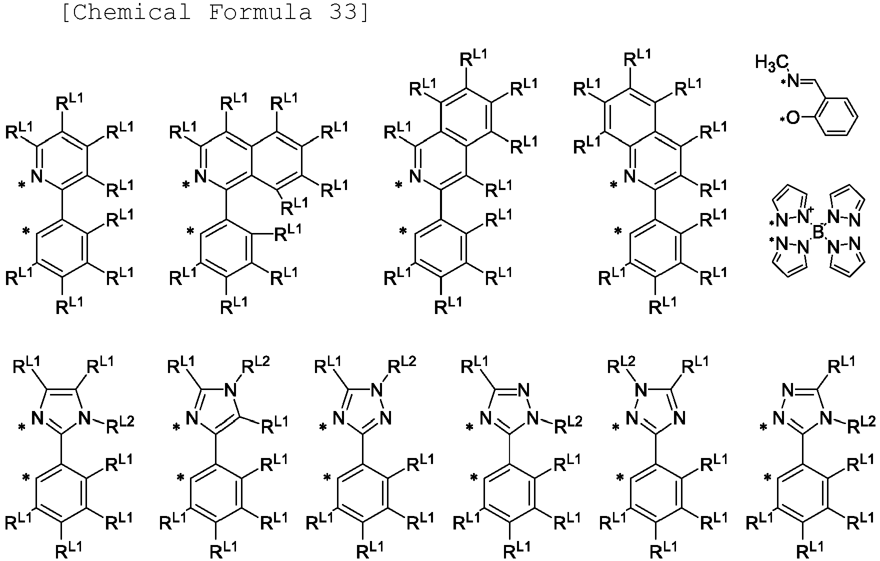 [wherein,
* represents a site binding to M¹.
R^{L1} represents a hydrogen atom, an alkyl group, a cycloalkyl group or a halogen atom, and the foregoing groups optionally have a substituent. A plurality of R^{L1} may be the same or different.
R^{L2} represents an alkyl group, a cycloalkyl group, an aryl group, a monovalent hetero ring group or a halogen atom, and the foregoing groups optionally have a substituent.]

R^{L1} is preferably a hydrogen atom, an alkyl group, a cycloalkyl group or a fluorene atom, more preferably a hydrogen atom or an alkyl group, and the foregoing groups optionally have a substituent.

R^{L2} is preferably an alkyl group, a cycloalkyl group, an aryl group or a monovalent hetero ring group, more preferably an aryl group, and the foregoing groups optionally have a substituent.

The metal complex represented by the formula (1) is preferably a metal complex represented by the formula (1-A1) or the formula (1-A2), more preferably a metal complex represented by the formula (1-A1), since the light emitting device of the present invention is more excellent in external quantum efficiency.

Ring R^{2A} is preferably a benzene ring, a fluorene ring, a carbazole ring, a dibenzofuran ring or a dibenzothiophene ring, more preferably a benzene ring or a dibenzofuran ring, and the foregoing rings optionally have a substituent.

The examples and preferable range of the substituent which Ring R^{2A} optionally has are the same as the examples and preferable range of the substituent which Ring R² optionally has.

When a plurality of the substituents which Ring R^{2A} optionally has are present, it is preferable that they are not combined together to form a ring together with atoms to which they are attached, since synthesis of a metal complex represented by the formula (1-A1) or the formula (1-A2) is easy.

It is preferable that a substituent which Ring R^{2A} optionally has and R^{11A} are not combined together to form a ring together with atoms to which they are attached, since synthesis of a metal complex represented by the formula (1-A1) or the formula (1-A2) is easy.

When a plurality of R^{11A} are present in the formula (1-A1), it is preferable that at least two of R^{11A} represent a group represented by the formula (Ar-1A), it is more preferable that all of R^{11A} represent a group represented by the formula (Ar-1A), since synthesis of a metal complex represented by the formula (1-A1) is easy.

In the formula (1-A1), E^{12A} is preferably a carbon atom.

In the formula (1-A1), it is preferable that E^{13A} is a nitrogen atom and R^{13A} is absent.

When a plurality of R^{12A} are present in the formula (1-A2), it is preferable that at least two of R^{12A} represent a group represented by the formula (Ar-1A), it is more preferable that all of R^{12A} represent a group represented by the formula (Ar-1A), since synthesis of a metal complex represented by the formula (1-A2) is easy.

In the formula (1-A2), E^{13A} is preferably a carbon atom.

In the formula (1-A2), it is preferable that E^{11A} is a nitrogen atom and R^{11A} is absent.

The metal complex represented by the formula (1-A1) is preferably a metal complex represented by the formula (1-A1-1) to the formula (1-A1-3), more preferably a metal complex represented by the formula (1-A1-1) or the formula (1-A1-2), further preferably a metal complex represented by the formula (1-A1-2), since the light emitting device of the present invention is more excellent in external quantum efficiency.

The metal complex represented by the formula (1-A2) is preferably a metal complex represented by the formula (1-A2-1) or the formula (1-A2-2), more preferably a metal complex represented by the formula (1-A2-2), since the light emitting device of the present invention is more excellent in external quantum efficiency. 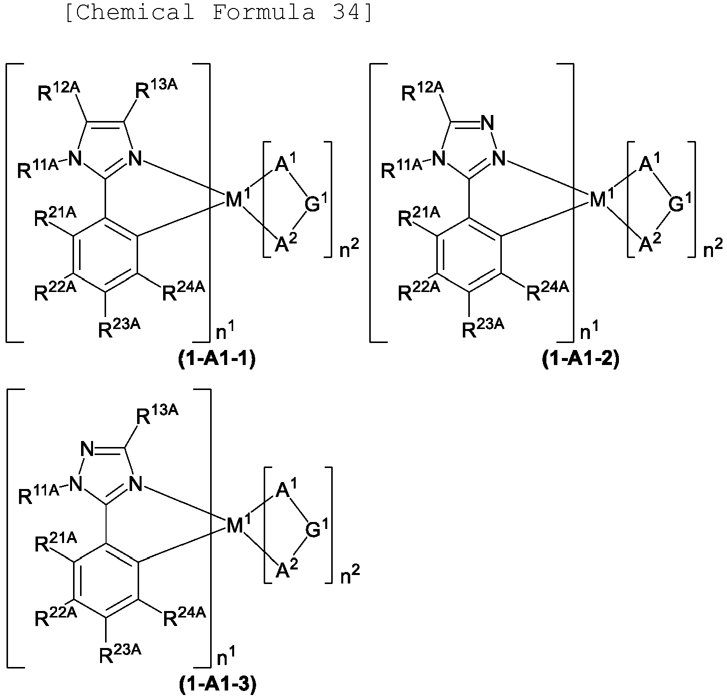 [wherein, M¹, n¹, n², R^{11A}, R^{12A}, R^{13A} and A¹-G¹-A² represent the same meaning as described above.

R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{21A}, R^{22A}, R^{23A} and R^{24A} are present, they may be the same or different at each occurrence. R^{21A} and R^{22A}, R^{22A} and R^{23A}, R^{23A} and R^{24A}, and, R^{11A} and R^{21A} each may be combined together to form a ring together with atoms to which they are attached.] 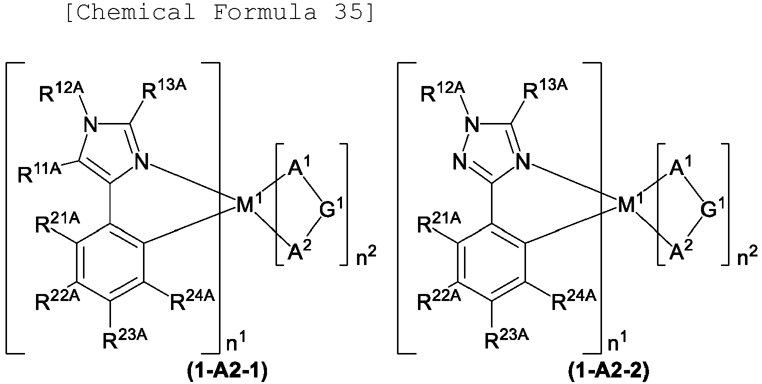 [wherein, M¹, n¹, n², R^{11A}, R^{12A}, R^{13A} and A¹-G¹-A² represent the same meaning as described above.

R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{21A}, R^{22A}, R^{23A} and R^{24A} are present, they may be the same or different at each occurrence. R^{21A} and R^{22A}, R^{22A} and R^{23A}, R^{23A} and R^{24A}, and, R^{11A} and R^{21A} each may be combined together to form a ring together with atoms to which they are attached.]

R^{21A} to R^{24A} are each preferably a hydrogen atom, an alkyl group, a cycloalkyl group, an aryl group, a monovalent hetero ring group or a substituted amino group, more preferably a hydrogen atom, an alkyl group or an aryl group, and the foregoing groups optionally have a substituent.

The examples and preferable ranges of the aryl group, the monovalent hetero ring group and the substituted amino group represented by R^{21A} to R^{24A} are the same as the examples and preferable ranges of the aryl group, the monovalent hetero ring group and the substituted amino group as the substituent which Ring R² optionally has, respectively.

It is preferable that R^{11A} and R^{21A} are not combined together to form a ring together with atoms to which they are attached, since synthesis of a metal complex represented by the formula (1) is easy.

When R^{21A} and R^{22A}, R^{22A} and R^{23A}, or R^{23A} and R^{24A} are combined together to form a ring together with atoms to which they are attached, the ring to be formed includes, for example, aromatic hydrocarbon rings or aromatic hetero rings, and it is preferably a benzene ring, an indene ring, a pyridine ring, a diazabenzene ring, a benzofuran ring, a benzothiophene ring or an indole ring, more preferably an indene ring, a benzofuran ring, a benzothiophene ring or an indole ring, further preferably a benzofuran ring or a benzothiophene ring, particularly preferably a benzofuran ring, and the foregoing rings optionally have a substituent.

When R^{21A} and R^{22A}, R^{22A} and R^{23A}, or R^{23A} and R^{24A} are combined together to form a ring together with atoms to which they are attached, it is preferable that R^{21A} and R^{22A}, or R^{22A} and R^{23A} are combined together to form a ring together with atoms to which they are attached, it is more preferable that R^{22A} and R^{23A} are combined together to form a ring together with atoms to which they are attached.

The examples and preferable range of the substituent which R^{21A} to R^{24A} optionally have are the same as the examples and preferable range of the substituent which the substituent which Ring R² optionally has optionally further has.

The metal complex represented by the formula (1) includes, for example, metal complexes represented by the following formulae. 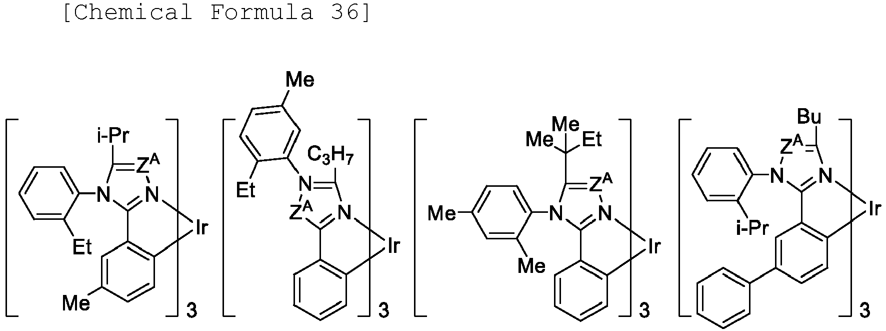 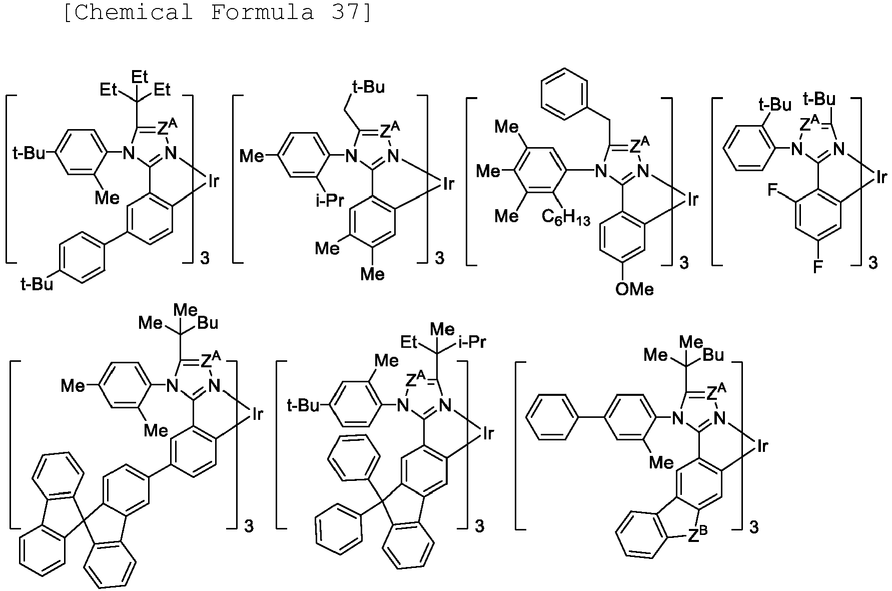 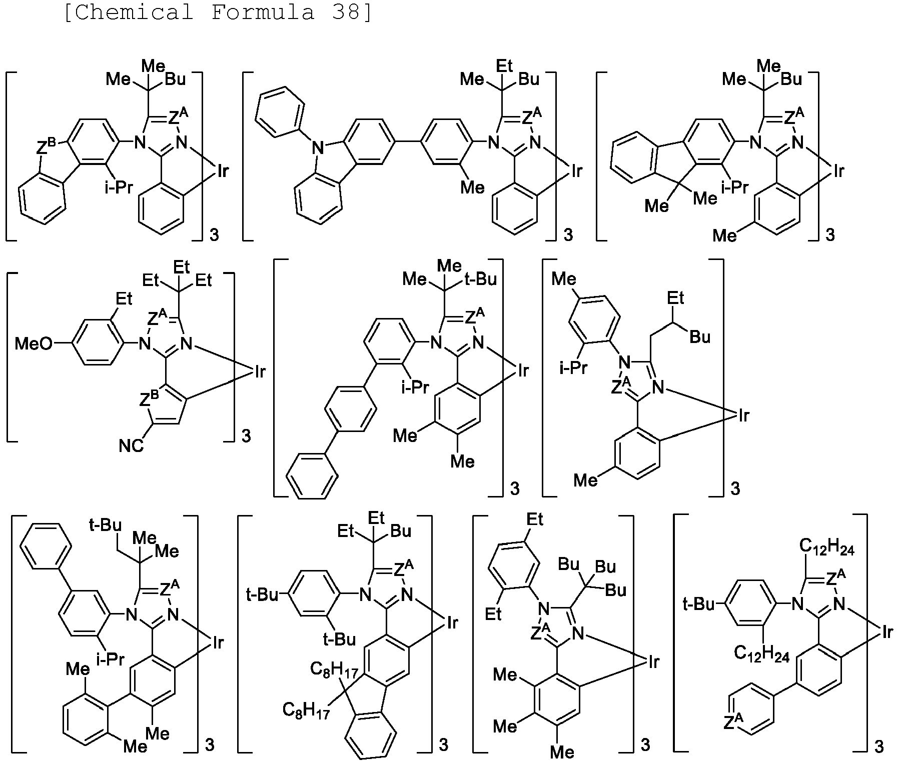 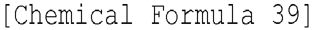 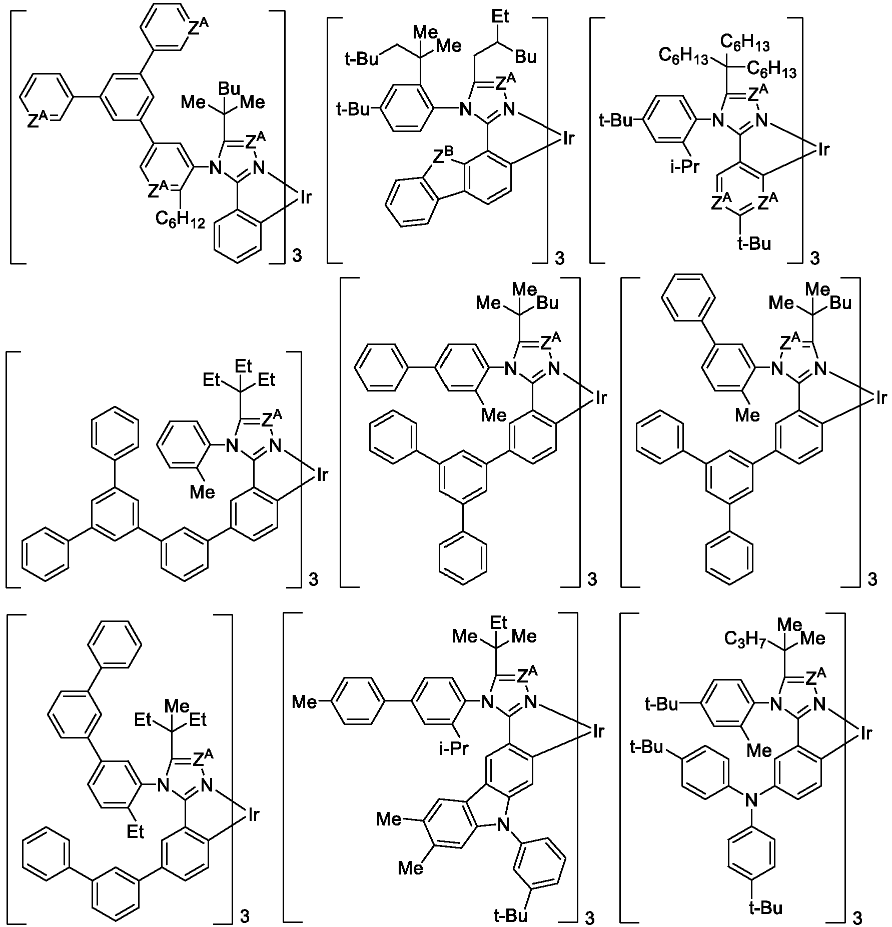 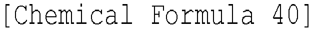 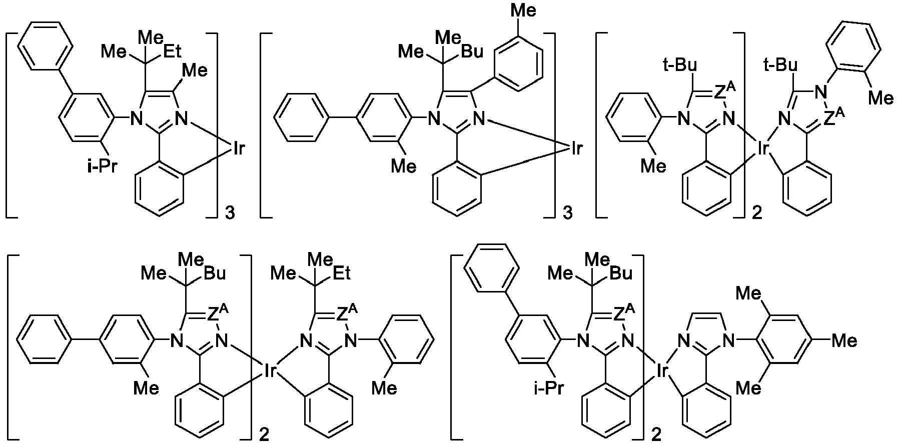 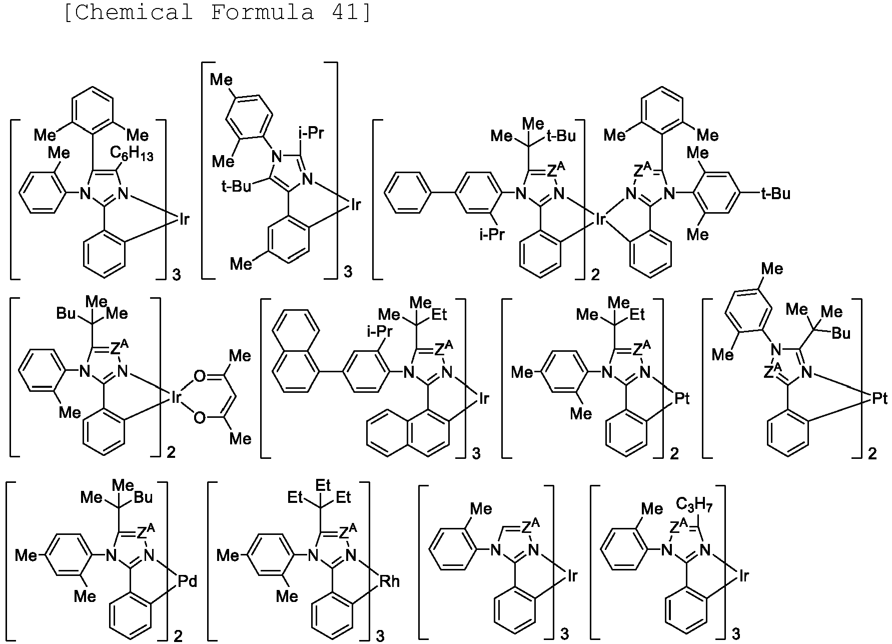 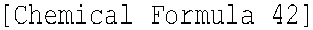 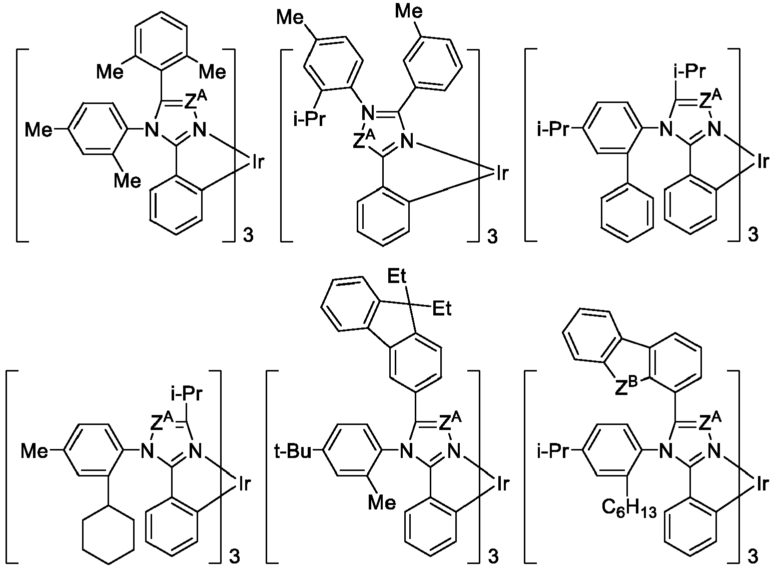 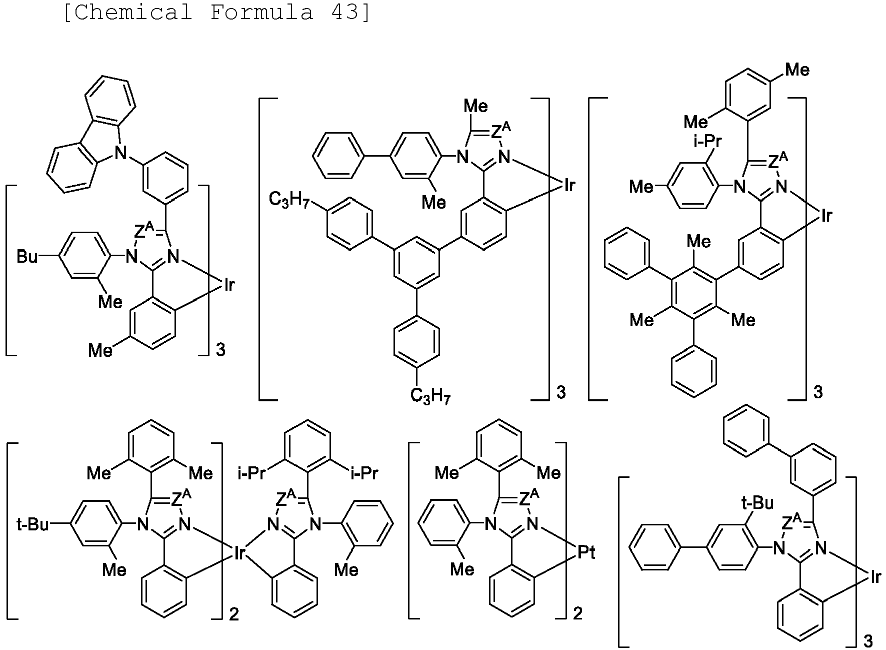 [wherein,
Z^{A} represents a group represented by -CH= or a group represented by -N=. When a plurality of Z^{A} are present, they may be the same or different.
Z^{B} represents a group represented by -O- or a group represented by -S-. When a plurality of Z^{B} are present, they may be the same or different.]
Z^{A} is preferably a group represented by -N=. Z^{B} is preferably a group represented by -O-.

### <Production method of metal complex represented by the formula (1)>

The metal complex represented by the formula (1) can be produced, for example, by a method of reacting a compound as a ligand and a metal compound. If necessary, ligands of a metal complex may be subjected to a functional group transformation reaction.

The metal complex represented by the formula (1) can be produced, for example, by a method comprising Step A of reacting a compound represented by the formula (M-1) and a metal compound or its hydrate. 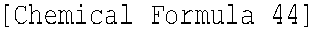 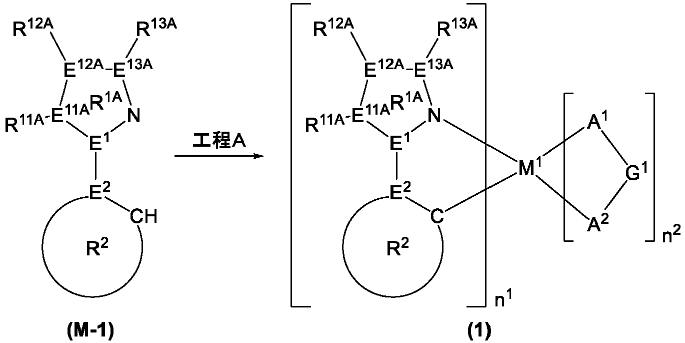 [wherein, M¹, n¹, n², Ring R^{1A}, Ring R², R^{11A} to R^{13A}, E¹, E², E^{11A} to E^{13A} and A¹-G¹-A² represent the same meaning as described above.]

In Step A, the metal compound includes, for example, iridium compounds such as iridium chloride, tris(acetylacetonato)iridium (III), chloro(cyclooctadiene)iridium(I) dimer, iridium(III) acetate and the like; platinum compounds such as potassium chloroplatinate and the like; palladium compounds such as palladium chloride, palladium acetate and the like; and rhodium compounds such as rhodium chloride and the like. The metal compound hydrate includes, for example, iridium chloride trihydrate and rhodium chloride trihydrate.

In Step A, the amount of the compound represented by the formula (M-1) is usually 2 to 20 mol with respect to 1 mol of a metal compound or its hydrate.

Step A is carried out usually in a solvent. The solvent includes alcohol solvents such as methanol, ethanol, propanol, ethylene glycol, glycerin, 2-methoxyethanol, 2-ethoxyethanol and the like; ether solvents such as diethyl ether, tetrahydrofuran (THF), dioxane, cyclopentyl methyl ether, diglyme and the like; halogen solvents such as methylene chloride, chloroform and the like; nitrile solvents such as acetonitrile, benzonitrile and the like; hydrocarbon solvents such as hexane, decalin, toluene, xylene, mesitylene and the like; amide solvents such as N,N-dimethylformamide, N,N-dimethylacetamide and the like; acetone, dimethyl sulfoxide, water and the like.

In Step A, the reaction time is usually 30 minutes to 200 hours, and the reaction temperature is usually between the melting point and the boiling point of a solvent present in the reaction system.

The compound, the catalyst and the solvent used in the reaction explained in <Production method of metal complex represented by the formula (1)> each may be used singly or in combination of two or more kinds thereof.

### [Host material]

The first organic layer is preferably a layer containing a metal complex represented by the formula (1) and a host material having at least one function selected from hole injectability, hole transportability, electron injectability and electron transportability, since the light emitting device of the present invention is more excellent in external quantum efficiency. In the first organic layer, the host material may be contained singly or in combination of two or more kinds thereof.

When the first organic layer is a layer containing a metal complex represented by the formula (1) and a host material, the content of the host material is usually 1 to 99 parts by mass, preferably 10 to 90 parts by mass, more preferably 30 to 85 parts by mass, further preferably 50 to 80 parts by mass, when the sum of the metal complex represented by the formula (1) and the host material is taken as 100 parts by mass.

It is preferable that the lowest excited triplet state (T₁) of the host material has higher energy level than the lowest excited triplet state (T₁) of the metal complex represented by the formula (1), since the light emitting device of the present invention is more excellent in external quantum efficiency.

The host material is preferably one showing solubility in a solvent which is capable of dissolving a metal complex represented by the formula (1), since the light emitting device of the present invention can be fabricated by a wet method.

The host material is classified into a low molecular compound (low molecular host) and a polymer compound (polymer host), and the first organic layer may contain any host material. As the host material which may be contained in the first organic layer, low molecular compounds are preferable.

### [Low molecular host]

The low molecular host is preferably a compound represented by the formula (H-1) .

Ar^{H1} and Ar^{H2} are each preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a fluorenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a fluorenyl group, a spirobifluorenyl group, a dibenzothienyl group, a dibenzofuryl group or a carbazolyl group, particularly preferably a group represented by the formula (TDA-3), and the foregoing groups optionally have a substituent.

The substituent which Ar^{H1} and Ar^{H2} optionally have is preferably a halogen atom, an alkyl group, a cycloalkyl group, an alkoxy group, a cycloalkoxy group, an aryl group or a monovalent hetero ring group, more preferably an alkyl group, a cycloalkoxy group, an alkoxy group or a cycloalkoxy group, further preferably an alkyl group or a cycloalkoxy group, and the foregoing groups optionally further have a substituent.

n^{H1} is preferably 1. n^{H2} is preferably 0.

n^{H3} is usually an integer of 0 or more and 10 or less, preferably an integer of 0 or more and 5 or less, further preferably an integer of 1 or more and 3 or less, particularly preferably 1.

n^{H11} is preferably an integer of 1 or more and 5 or less, more preferably an integer of 1 or more and 3 or less, further preferably 1.

R^{H11} is preferably a hydrogen atom, an alkyl group, a cycloalkyl group, an aryl group or a monovalent hetero ring group, more preferably a hydrogen atom, an alkyl group or a cycloalkyl group, further preferably a hydrogen atom or an alkyl group, and the foregoing groups optionally have a substituent.

L^{H1} is preferably an arylene group or a divalent hetero ring group, and the foregoing groups optionally further have a substituent.

L^{H1} is preferably a group represented by the formula (A-1) to the formula (A-3), the formula (A-8) to the formula (A-10), the formula (AA-1) to the formula (AA-6), the formula (AA-10) to the formula (AA-21) or the formula (AA-24) to the formula (AA-34), more preferably a group represented by the formula (A-1), the formula (A-2), the formula (A-8), the formula (A-9), the formula (AA-1) to the formula (AA-4), the formula (AA-10) to the formula (AA-15), the formula (AA-33) or the formula (AA-34), further preferably a group represented by the formula (A-1), the formula (A-2), the formula (A-8), the formula (AA-2), the formula (AA-4), the formula (AA-10), the formula (AA-12), the formula (AA-14) or (AA-33), particularly preferably a group represented by the formula (A-8), the formula (AA-10), the formula (AA-12) or the formula (AA-14), especially preferably a group represented by the formula (AA-14).

The substituent which L^{H1} optionally has is preferably a halogen atom, an alkyl group, a cycloalkyl group, an alkoxy group, a cycloalkoxy group, an aryl group or a monovalent hetero ring group, more preferably an alkyl group, an alkoxy group, an aryl group or a monovalent hetero ring group, further preferably an alkyl group, an aryl group or a monovalent hetero ring group, particularly preferably a monovalent hetero ring group, and the foregoing groups optionally further have a substituent.

L^{H21} is preferably a single bond or an arylene group, more preferably a single bond, and this arylene group optionally has a substituent.

The definitions and examples of the arylene group or the divalent hetero ring group represented by L^{H21} are the same as the definitions and examples of the arylene group or the divalent hetero ring group represented by L^{H1}.

R^{H21} is preferably an aryl group or a monovalent hetero ring group, and the foregoing groups optionally have a substituent.

The definitions and examples of the aryl group and the monovalent hetero ring group represented by R^{H21} are the same as the definitions and examples of the aryl group and the monovalent hetero ring group represented by Ar^{H1} and Ar^{H2}.

The definition and examples of the substituent which R^{H21} optionally has are the same as the definition and examples of the substituent which Ar^{H1} and Ar^{H2} optionally have.

The compound represented by the formula (H-1) is preferably a compound represented by the formula (H-2). 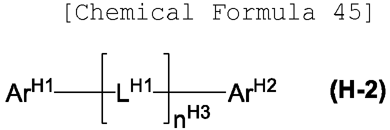 [wherein, Ar^{H1}, Ar^{H2}, n^{H3} and L^{H1} represent the same meaning as described above.]

As the compound represented by the formula (H-1), compounds represented by the following formulae and a compound HM-1 described later are exemplified.

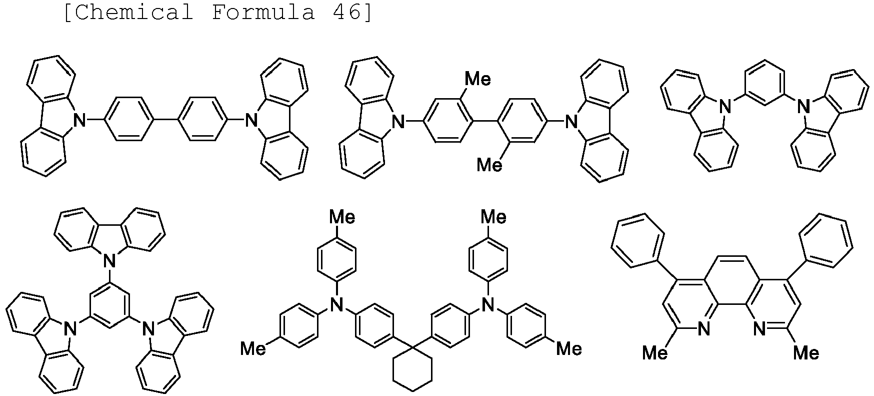

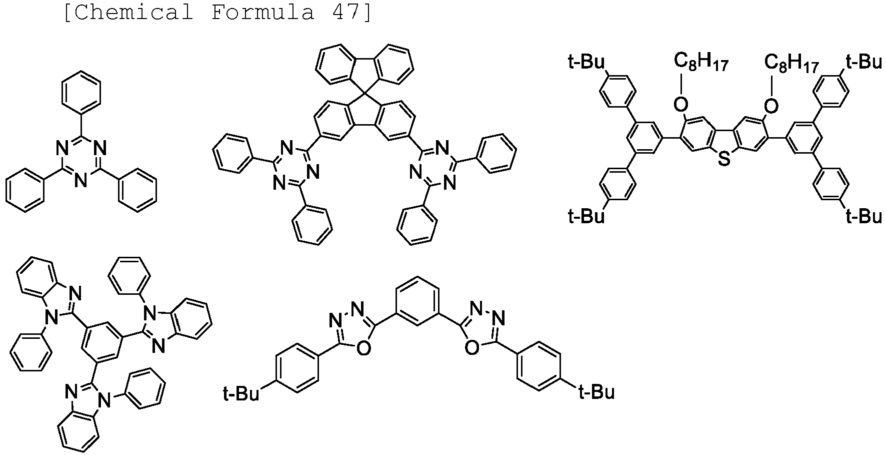

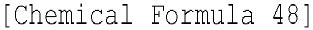

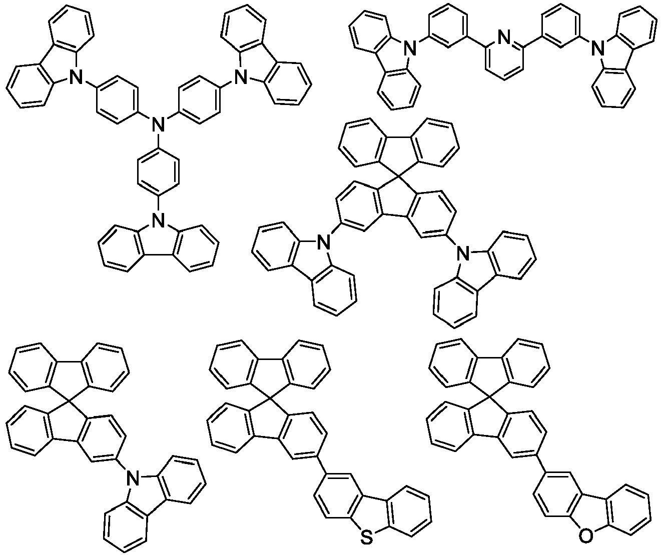

The polymer compound used for the host material includes, for example, polymer compounds as the hole transporting material described later and polymer compounds as the electron transporting material described later.

### [Polymer host]

The polymer host is preferably a polymer compound containing a constitutional unit represented by the formula (Y) .

The arylene group represented by Ar^{Y1} is more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19), and the foregoing groups optionally have a substituent.

The divalent hetero ring group represented by Ar^{Y1} is more preferably a group represented by the formula (AA-1) to the formula (AA-4), the formula (AA-10) to the formula (AA-15), the formula (AA-18) to the formula (AA-21), the formula (AA-33) or the formula (AA-34), further preferably a group represented by the formula (AA-4), the formula (AA-10), the formula (AA-12), the formula (AA-14) or the formula (AA-33), and the foregoing groups optionally have a substituent.

The more preferable range and the further preferable range of the arylene group and the divalent heterocyclic group of the divalent group in which at least one arylene group and at least one divalent heterocyclic group are bonded directly represented by Ar^{Y1} are the same as the more preferable range and the further preferable range of the arylene group and the divalent heterocyclic group represented by Ar^{Y1} described above, respectively.

"Divalent group in which at least one arylene group and at least one divalent hetero ring group are bonded directly" includes, for example, groups represented by the following formulae, and these groups optionally have a substituent. 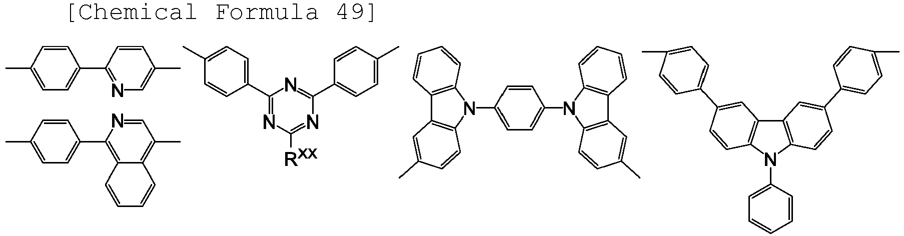 [wherein, R^{XX} represents a hydrogen atom, an alkyl group, a cycloalkyl group, an aryl group or a monovalent hetero ring group, and the foregoing groups optionally have a substituent.]

R^{XX} is preferably an alkyl group, a cycloalkyl group or an aryl group, and the foregoing groups optionally have a substituent.

The substituent which a group represented by Ar^{Y1} optionally has is preferably an alkyl group, a cycloalkyl group or an aryl group, and the foregoing groups optionally further have a substituent.

The constitutional unit represented by the formula (Y) includes, for example, constitutional units represented by the formula (Y-1) to the formula (Y-10), and it is preferably a constitutional unit represented by the formula (Y-1) to the formula (Y-3) from the standpoint of the external quantum efficiency of the light emitting device of the present invention, preferably a constitutional unit represented by the formula (Y-4) to the formula (Y-7) from the standpoint of the electron transportability of the light emitting device of the present invention, and preferably a constitutional unit represented by the formula (Y-8) to the formula (Y-10) from the standpoint of the hole transportability of the light emitting device of the present invention. 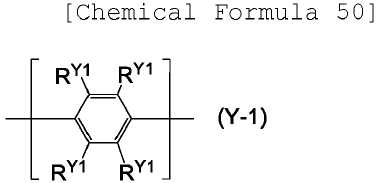 [wherein, R^{Y1} represents a hydrogen atom, an alkyl group, a cycloalkyl group, an alkoxy group, a cycloalkoxy group, an aryl group or a monovalent hetero ring group, and the foregoing groups optionally have a substituent. A plurality of R^{Y1} may be the same or different, and the adjacent R^{Y1} may be combined together to form a ring together with carbon atoms to which they are attached.]

R^{Y1} is preferably a hydrogen atom, an alkyl group, a cycloalkyl group or an aryl group, and the foregoing groups optionally have a substituent.

The constitutional unit represented by the formula (Y-1) is preferably a constitutional unit represented by the formula (Y-1'). 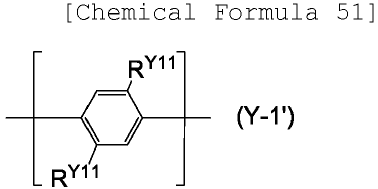 [wherein, R^{Y11} represents an alkyl group, a cycloalkyl group, an alkoxy group, a cycloalkoxy group, an aryl group or a monovalent hetero ring group, and the foregoing groups optionally have a substituent. A plurality of R^{Y11} may be the same or different.]

R^{Y11} is preferably an alkyl group, a cycloalkyl group or an aryl group, more preferably an alkyl group or a cycloalkyl group, and the foregoing groups optionally have a substituent. 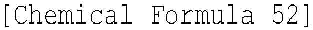 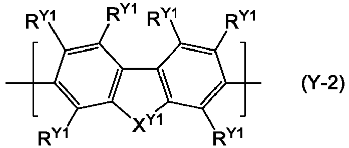 [wherein,
R^{Y1} represents the same meaning as described above.
X^{Y1} represents a group represented by -C(R^{Y2})₂-,-C(R^{Y2})=C(R^{Y2})- or -C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent hetero ring group, and the foregoing groups optionally have a substituent. A plurality of R^{Y2} may be the same or different, R^{Y2} may be combined together to form a ring together with carbon atoms to which they are attached.]

R^{Y2} is preferably an alkyl group, a cycloalkyl group, an aryl group or a monovalent hetero ring group, more preferably an alkyl group, a cycloalkyl group or an aryl group, and the foregoing groups optionally have a substituent.

Regarding the combination of two groups R^{Y2} in the group represented by -C(R^{Y2})₂- represented by X^{Y1}, it is preferable that both are alkyl groups or cycloalkyl groups, both are aryl groups, both are monovalent heterocyclic groups, or one is an alkyl group or a cycloalkyl group and the other is an aryl group or a monovalent heterocyclic group, it is more preferable that one is an alkyl group or a cycloalkyl group and the other is an aryl group, and the foregoing groups optionally have a substituent. Two groups R^{Y2} may be combined together to form a ring together with atoms to which they are attached, and when R^{Y2} forms a ring, the group represented by -C(R^{Y2})₂- is preferably a group represented by the formula (Y-A1) to the formula (Y-A5), more preferably a group represented by the formula (Y-A4), and the foregoing groups optionally have a substituent.

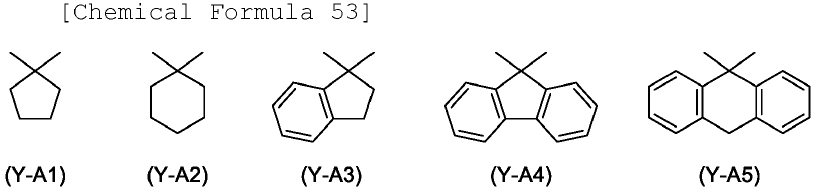

Regarding the combination of two groups R^{Y2} in the group represented by -C(R^{Y2})=C(R^{Y2})- represented by X^{Y1}, it is preferable that both are alkyl groups or cycloalkyl groups, or one is an alkyl group or a cycloalkyl group and the other is an aryl group, and the foregoing groups optionally have a substituent.

Four groups R^{Y2} in the group represented by -C(R^{Y2})₂-C(R^{Y2})₂- represented by X^{Y1} are preferably alkyl groups or cycloalkyl groups optionally having a substituent. A plurality of R^{Y2} may be combined together to form a ring together with atoms to which they are attached, and when R^{Y2} forms a ring, the group represented by -C(R^{Y2})₂-C(R^{Y2})₂- is preferably a group represented by the formula (Y-B1) to the formula (Y-B5), more preferably a group represented by the formula (Y-B3), and the foregoing groups optionally have a substituent. 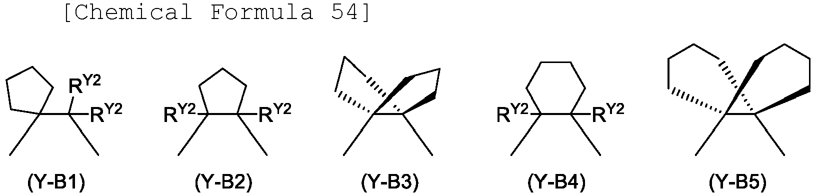 [wherein, R^{Y2} represents the same meaning as described above.]

The constitutional unit represented by the formula (Y-2) is preferably a constitutional unit represented by the formula (Y-2'). 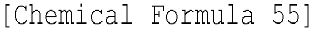 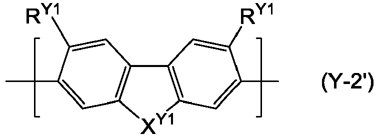 [wherein, R^{Y1} and X^{Y1} represent the same meaning as described above.] 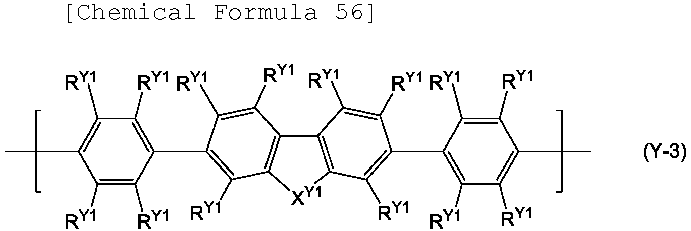 [wherein, R^{Y1} and X^{Y1} represent the same meaning as described above.]

The constitutional unit represented by the formula (Y-3) is preferably a constitutional unit represented by the formula (Y-3'). 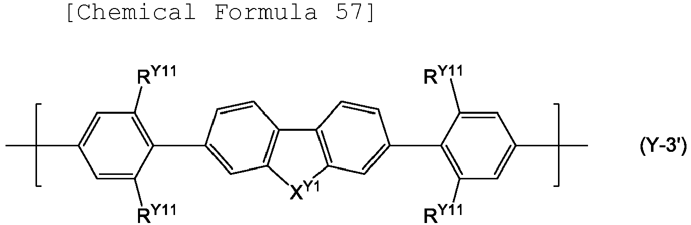 [wherein, R^{Y11} and X^{Y1} represent the same meaning as described above.] 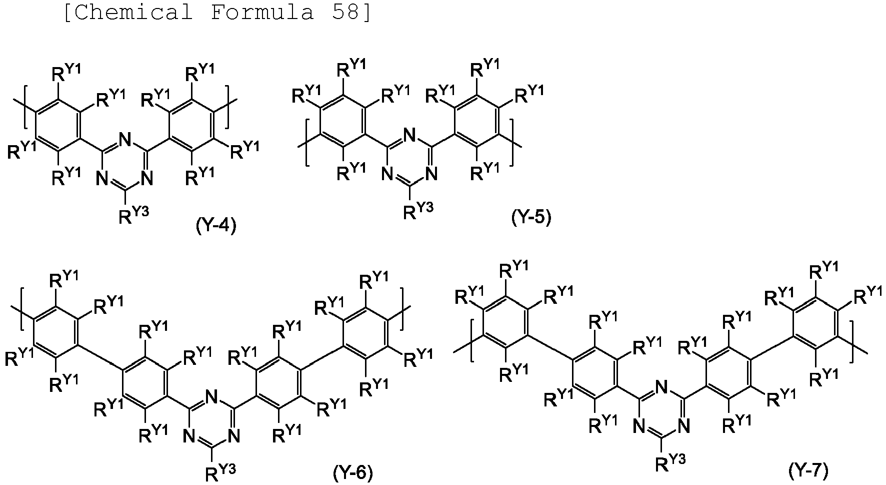 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent hetero ring group, and the foregoing groups optionally have a substituent.]

R^{Y3} is preferably an alkyl group, a cycloalkyl group, an alkoxy group, a cycloalkoxy group, an aryl group or a monovalent hetero ring group, more preferably an aryl group, and the foregoing groups optionally have a substituent.

The constitutional unit represented by the formula (Y-4) is preferably a constitutional unit represented by the formula (Y-4'), and the constitutional unit represented by the formula (Y-6) is preferably a constitutional unit represented by the formula (Y-6'). 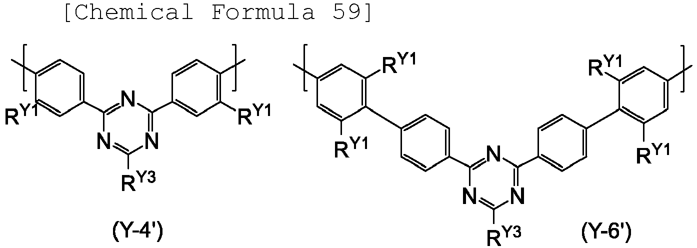 [wherein, R^{Y1} and R^{Y3} represent the same meaning as described above.] 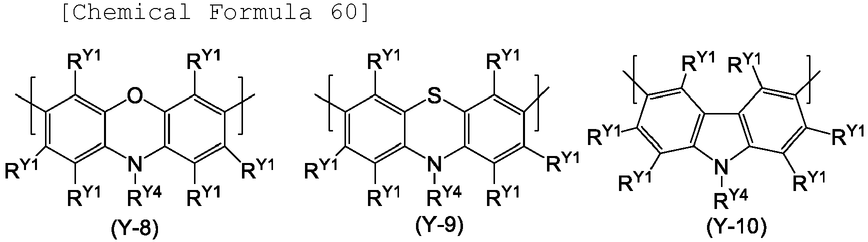 [wherein,
R^{Y1} represents the same meaning as described above.
R^{Y4} represents a hydrogen atom, an alkyl group, a cycloalkyl group, an alkoxy group, a cycloalkoxy group, an aryl group or a monovalent hetero ring group, and the foregoing groups optionally have a substituent.]

R^{Y4} is preferably an alkyl group, a cycloalkyl group, an alkoxy group, a cycloalkoxy group, an aryl group or a monovalent hetero ring group, more preferably an aryl group, and the foregoing groups optionally have a substituent.

The constitutional unit represented by the formula (Y) includes, for example, constitutional units composed of an arylene group represented by the formula (Y-101) to the formula (Y-121), constitutional units composed of a divalent hetero ring group represented by the formula (Y-201) to the formula (Y-206), and constitutional units composed of a divalent group in which at least one arylene group and at least one divalent hetero ring group are bonded directly represented by the formula (Y-300) to the formula (Y-304).

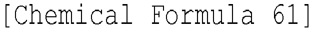

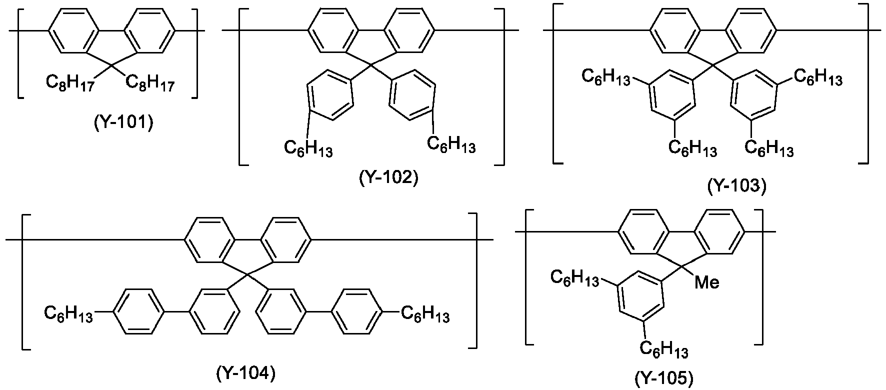

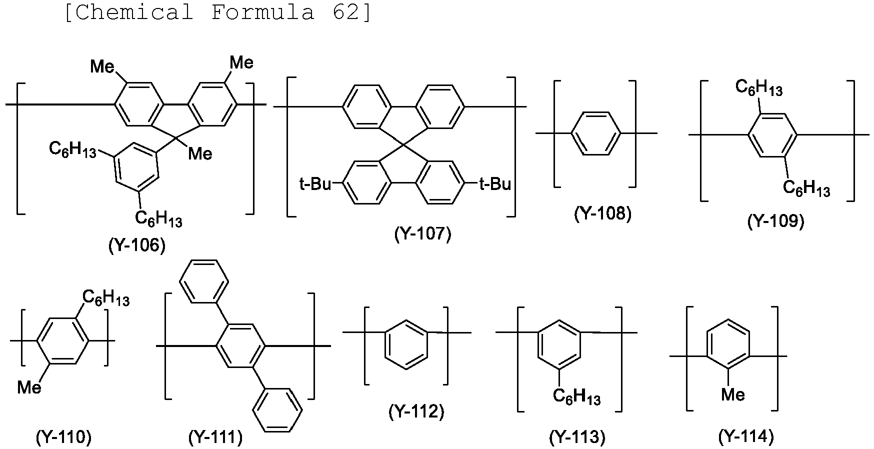

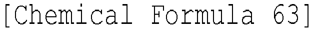

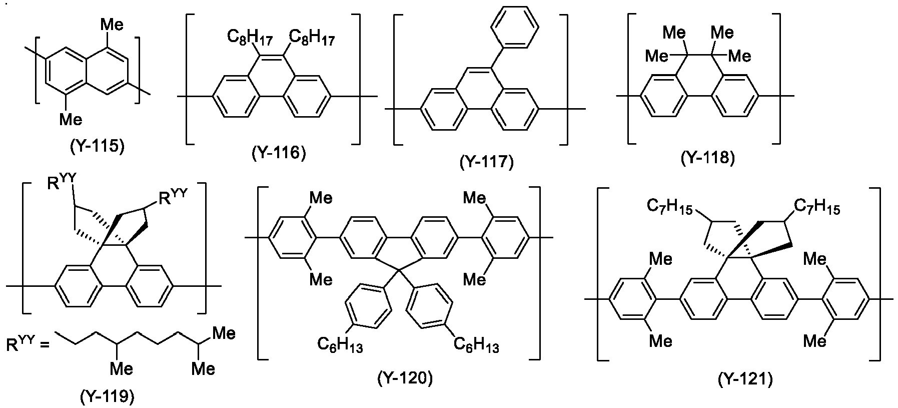

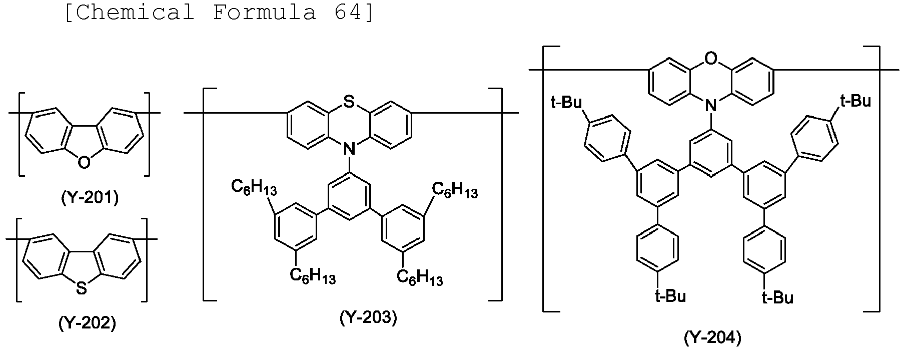

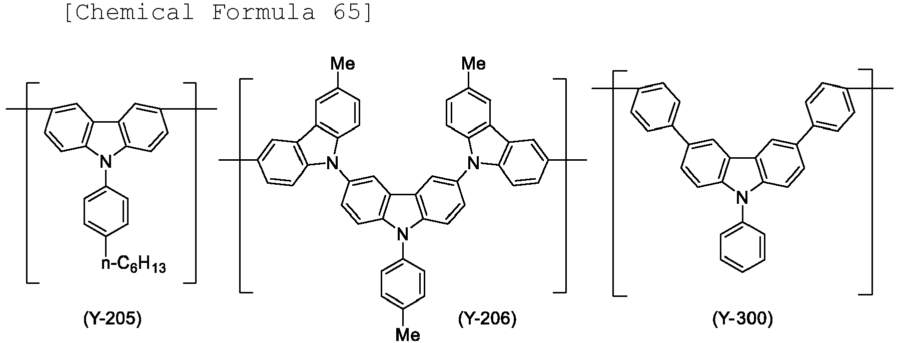

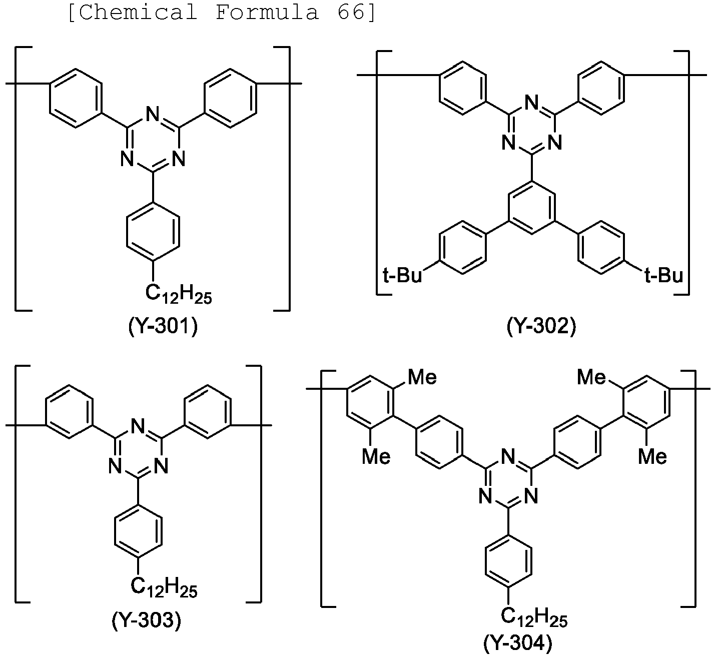

The amount of the constitutional unit represented by the formula (Y) in which Ar^{Y1} is an arylene group is preferably 0.5 to 90% by mol, more preferably 30 to 80% by mol, with respect to the total amount of constitutional units contained in the polymer host, since the light emitting device of the present invention is more excellent in external quantum efficiency.

The amount of the constitutional unit represented by the formula (Y) in which Ar^{Y1} is a divalent hetero ring group, or a divalent group in which at least one arylene group and at least one divalent hetero ring group are bonded directly is preferably 0.5 to 40% by mol, more preferably 3 to 30% by mol, with respect to the total amount of constitutional units contained in the polymer host, since the light emitting device of the present invention is excellent in charge transportability.

The constitutional unit represented by the formula (Y) may be contained only singly or in combination of two or more kinds thereof in the polymer host.

It is preferable that the polymer host further contains a constitutional unit represented by the formula (X) described below, since hole transportability is excellent. 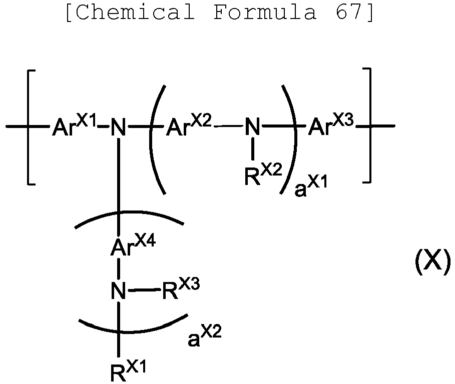 [wherein,
a^{X1} and a^{X2} each independently represent an integer of 0 or more.
Ar^{X1} and Ar^{X3} each independently represent an arylene group or a divalent hetero ring group, and the foregoing groups optionally have a substituent.
Ar^{X2} and Ar^{X4} each independently represent an arylene group, a divalent hetero ring group, or a divalent group in which at least one arylene group and at least one divalent hetero ring group are bonded directly, and the foregoing groups optionally have a substituent. When a plurality of Ar^{X2} and Ar^{X4} are present, they may be the same or different at each occurrence.
R^{X1}, R^{X2} and R^{X3} each independently represent a hydrogen atom, an alkyl group, a cycloalkyl group, an aryl group or a monovalent hetero ring group, and the foregoing groups optionally have a substituent. When a plurality of R^{X2} and R^{X3} are present, they may be the same or different at each occurrence.]

a^{X1} is preferably 2 or less, more preferably 1, since the light emitting device of the present invention is more excellent in external quantum efficiency.

a^{X2} is preferably 2 or less, more preferably 0, since the light emitting device of the present invention is more excellent in external quantum efficiency.

R^{X1}, R^{X2} and R^{X3} are each preferably an alkyl group, a cycloalkyl group, an aryl group or a monovalent hetero ring group, more preferably an aryl group, and the foregoing groups optionally have a substituent.

The arylene group represented by Ar^{X1} and Ar^{X3} is more preferably a group represented by the formula (A-1) or the formula (A-9), further preferably a group represented by the formula (A-1), and the foregoing groups optionally have a substituent.

The divalent hetero ring group represented by Ar^{X1} and Ar^{X3} is more preferably a group represented by the formula (AA-1), the formula (AA-2) or the formula (AA-7) to the formula (AA-26), and the foregoing groups optionally have a substituent.

Ar^{X1} and Ar^{X3} are each preferably an arylene group optionally having a substituent.

The arylene group represented by Ar^{X2} and Ar^{X4} is more preferably a group represented by the formula (A-1), the formula (A-6), the formula (A-7), the formula (A-9) to the formula (A-11) or the formula (A-19), and the foregoing groups optionally have a substituent.

The more preferable range of the divalent hetero ring group represented by Ar^{X2} and Ar^{X4} is the same as the more preferable range of the divalent hetero ring group represented by Ar^{X1} and Ar^{X3}.

The more preferable range and further preferable range of the arylene group and the divalent hetero ring group of the divalent group in which at least one arylene group and at least one divalent hetero ring group are bonded directly represented by Ar^{X2} and Ar^{X4} are the same as the more preferable range and further preferable range of the arylene group and the divalent hetero ring group represented by Ar^{X1} and Ar^{X3}, respectively.

The divalent group in which at least one arylene group and at least one divalent hetero ring group are bonded directly represented by Ar^{X2} and Ar^{X4} includes the same groups as the divalent group in which at least one arylene group and at least one divalent hetero ring group are bonded directly represented by Ar^{Y1} in the formula (Y).

Ar^{X2} and Ar^{X4} are each preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and the foregoing groups optionally further have a substituent.

The constitutional unit represented by the formula (X) is preferably a constitutional unit represented by the formula (X-1) to the formula (X-7), more preferably a constitutional unit represented by the formula (X-1) to the formula (X-6). 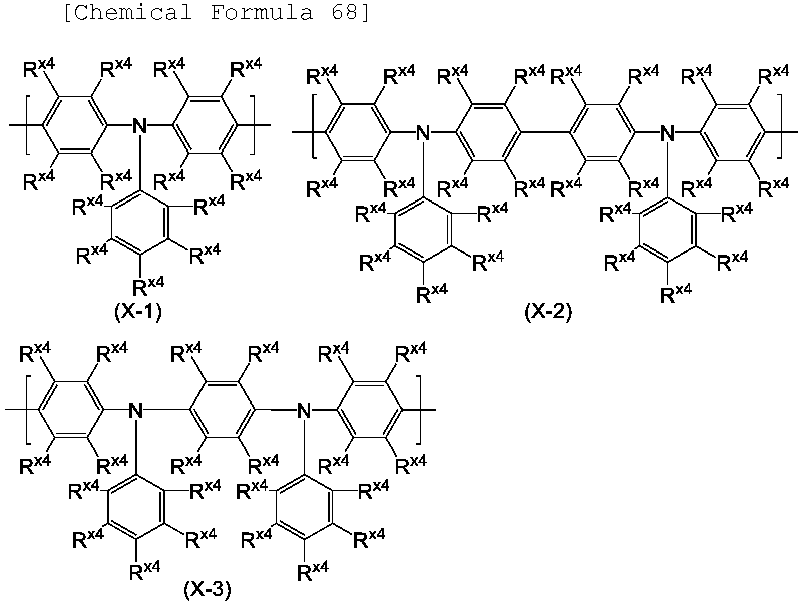 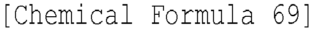 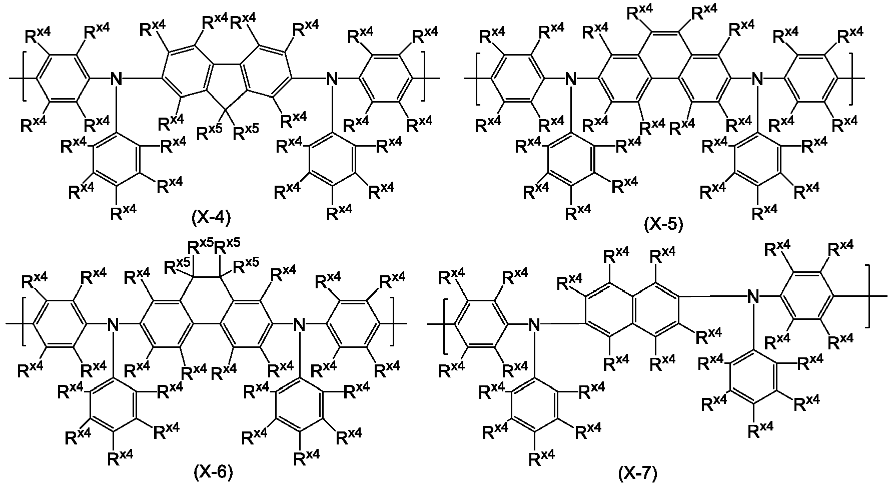 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent hetero ring group or a cyano group, and the foregoing groups optionally have a substituent. A plurality of R^{X4} may be the same or different. A plurality of R^{X5} may be the same or different, and the adjacent R^{X5} may be combined together to form a ring together with carbon atoms to which they are attached.]

The amount of the constitutional unit represented by the formula (X) is preferably 0.1 to 50% by mol, more preferably 1 to 40% by mol, further preferably 5 to 30% by mol, with respect to the total amount of constitutional units contained in the polymer host, since hole transportability is excellent.

The constitutional unit represented by the formula (X) includes, for example, constitutional units represented by the formula (X1-1) to the formula (X1-15), and it is preferably a constitutional unit represented by the formula (X1-3) to the formula (X1-10).

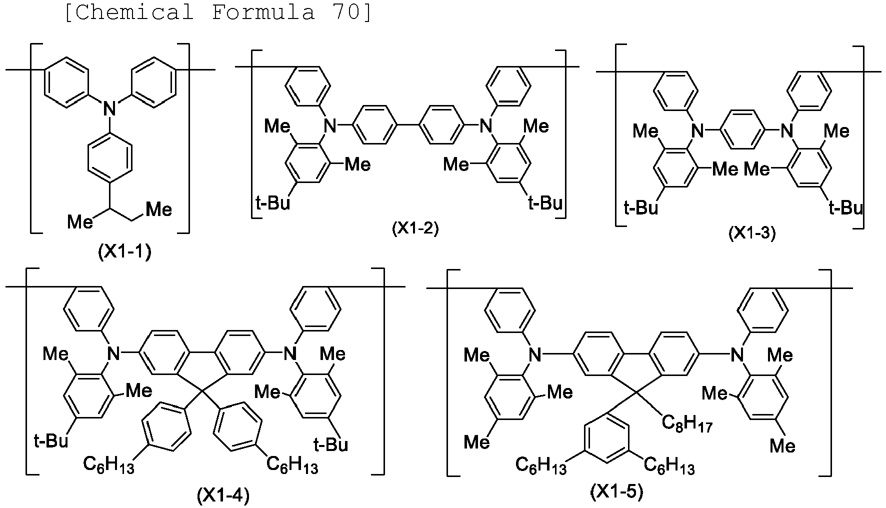

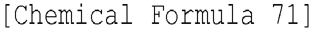

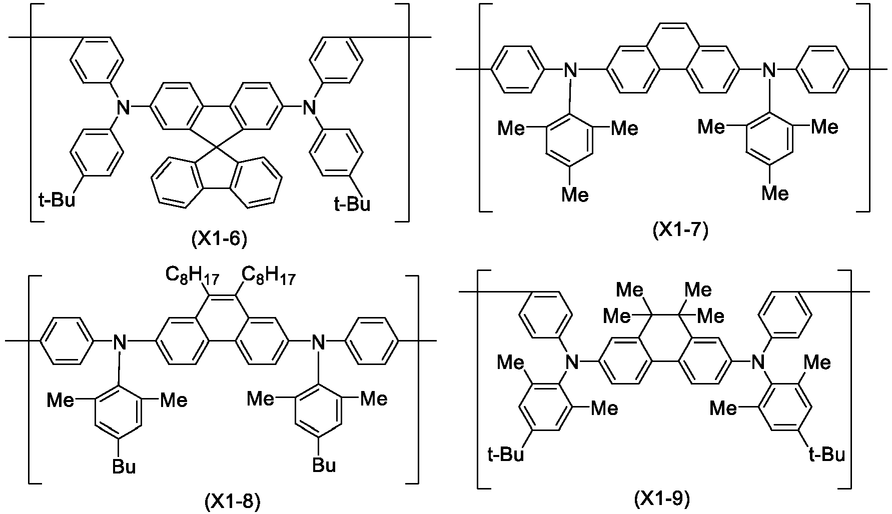

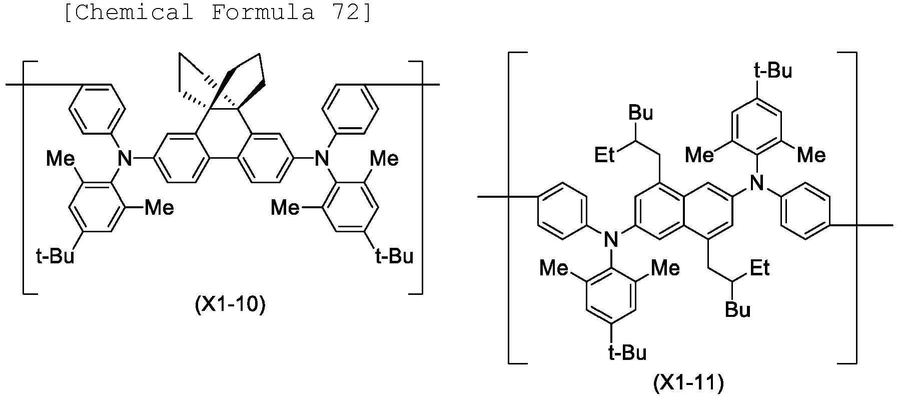

In the polymer host, the constitutional unit represented by the formula (X) may be contained only singly or in combination of two or more kinds thereof.

The polymer host includes, for example, polymer compounds P-1 to P-6.

**[Table 1]**

| polymer compound | constitutional unit and molar ratio thereof | | | | |
|---|---|---|---|---|---|
| | formula (Y) | | | formula (X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| P-1 | 0.1 to 99.9 | 0.1 to 99.9 | 0 | 0 | 0 to 30 |
| P-2 | 0.1 to 99.9 | 0 | 0.1 to 99.9 | 0 | 0 to 30 |
| P-3 | 0.1 to 99.8 | 0.1 to 99.8 | 0 | 0.1 to 99.8 | 0 to 30 |
| P-4 | 0.1 to 99.8 | 0.1 to 99.8 | 0.1 to 99.8 | 0 | 0 to 30 |
| P-5 | 0.1 to 99.8 | 0 | 0.1 to 99.8 | 0.1 to 99.8 | 0 to 30 |
| P-6 | 0.1 to 99.7 | 0.1 to 99.7 | 0.1 to 99.7 | 0.1 to 99.7 | 0 to 30 |

[in the table, p, q, r, s and t represent the molar ratio of each constitutional unit. p+q+r+s+t = 100 and 100 ≥ p+q+r+s ≥ 70. The other constitutional unit denotes a constitutional unit other than the constitutional unit represented by the formula (Y) and the constitutional unit represented by the formula (X).]

The polymer host may be any of a block copolymer, a random copolymer, an alternating copolymer or a graft copolymer, and may also be a compound in another form, and a copolymer in which several raw material monomers are copolymerized is preferable.

The polystyrene-equivalent number-average molecular weight of the polymer host is preferably 5×10³ to 1×10⁶, more preferably 1×10⁴ to 5×10⁵, more preferably 1.5×10⁴ to 1.5×10⁵.

### [Production method of polymer host]

The polymer host can be produced by using known polymerization methods described in Chemical Review (Chem. Rev.), vol. 109, pp. 897-1091 (2009) and the like, and exemplified are methods of polymerizing by a coupling reaction using a transition metal catalyst such as the Suzuki reaction, the Yamamoto reaction, the Buchwald reaction, the Stille reaction, the Negishi reaction, the Kumada reaction and the like.

The method of charging monomers in the above-described production method includes a method in which the whole monomer is charged in the reaction system at once, a method in which partial monomers are charged and reacted, then, the remaining monomers are charged at once, continuously or in parts, a method in which monomers are charged continuously or in parts, and the like.

The transition metal catalyst includes palladium catalysts, nickel catalysts and the like.

The post treatment of the polymerization reaction is conducted by using known methods, for example, a method of removing water-soluble impurities by liquid separation, a method of adding the reaction liquid after the polymerization reaction to a lower alcohol such as methanol and the like, filtrating the deposited precipitate, then, drying it, and other methods, singly or in combination. When the purity of the polymer host is low, it can be purified by a usual method such as, for example, crystallization, re-precipitation, continuous extraction with a Soxhlet extractor, column chromatography and the like.

### [First composition]

The first organic layer may be layer comprising a composition (hereinafter, referred to also as "first composition") containing a metal complex represented by the formula (1) and at least one material selected from the group consisting of the host material, the hole transporting material, the hole injection material, the electron transporting material, the electron injection material and the light emitting material (differing from the metal complex represented by the formula (1)) and an antioxidant.

### [Hole transporting material]

The hole transporting material is classified into a low molecular compound and a polymer compound, and it is preferably a polymer compound having a crosslinking group.

The low molecular compound includes, for example, aromatic amine compounds such as triphenylamine and derivatives thereof, N,N'-di-1-naphthyl-N,N'-diphenylbenzidine (a-NPD), N,N'-diphenyl-N,N'-di(m-tolyl)benzidine (TPD) and the like.

The polymer compound includes, for example, polyvinylcarbazole and derivatives thereof; and polyarylnene having an aromatic amine structure in the side chain or main chain and derivatives thereof. The polymer compound may also be a compound having an electron accepting site bound such as fullerene, tetrafluorotetracyanoquinodimethane, tetracyanoethylene and trinitrofluorenone and the like.

In the first composition, the compounding amount of the hole transporting material is, when the amount of the metal complex represented by the formula (1) is taken as 100 parts by mass, usually 1 to 400 parts by mass.

The hole transporting material may be used singly or in combination of two or more kinds thereof.

### [Electron transporting material]

The electron transporting material is classified into a low molecular compound and a polymer compound. The electron transporting material may have a crosslinking group.

The low molecular compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the first composition, the compounding amount of the electron transporting material is, when the amount of the metal complex represented by the formula (1) is taken as 100 parts by mass, usually 1 to 400 parts by mass.

The electron transporting material may be used singly or in combination of two or more kinds thereof.

### [Hole injection material and electron injection material]

The hole injection material and the electron injection material are each classified into a low molecular compound and a polymer compound. The hole injection material and the electron injection material may have a crosslinking group.

The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer containing an aromatic amine structure in the main chain or side chain, and the like.

In the first composition, the compounding amounts of the hole injection material and the electron injection material are each usually 1 to 400 parts by mass, when the amount of the metal complex represented by the formula (1) is taken as 100 parts by mass.

The hole injection material and the electron injection material each may be used singly or in combination of two or more kinds thereof.

### [Ion doping]

When the hole injection material or the electron injection material contains an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with an appropriate amount of ions. The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more kinds thereof.

### [Light emitting material]

The light emitting material is classified into a low molecular compound and a polymer compound. The light emitting material may have a crosslinking group.

The low molecular compound includes, for example, naphthalene and derivatives thereof, anthracene and derivatives thereof, perylene and derivatives thereof, and triplet light emitting complexes containing iridium, platinum or europium as the central metal.

The polymer compound includes polymer compounds containing, for example, an arylene group such as a phenylene group, a naphthalenediyl group, a fluorenediyl group, a phenanthrenediyl group, a dihydrophenanthrenediyl group, an anthracenediyl group, a pyrenediyl group and the like; an aromatic amine residue such as a group obtained by removing from an aromatic amine two hydrogen atoms, and the like; and a divalent hetero ring group such as a carbazolediyl group, a phenoxazinediyl group, a phenothiazinediyl group and the like.

The light emitting material is preferably a metal complex shown below or a metal complex represented by the formula (2), more preferably a metal complex represented by the formula (2).

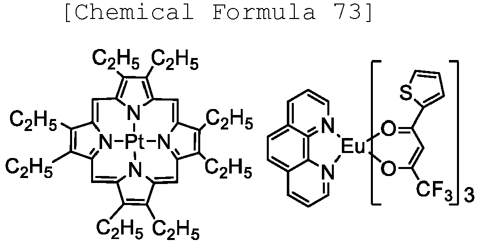

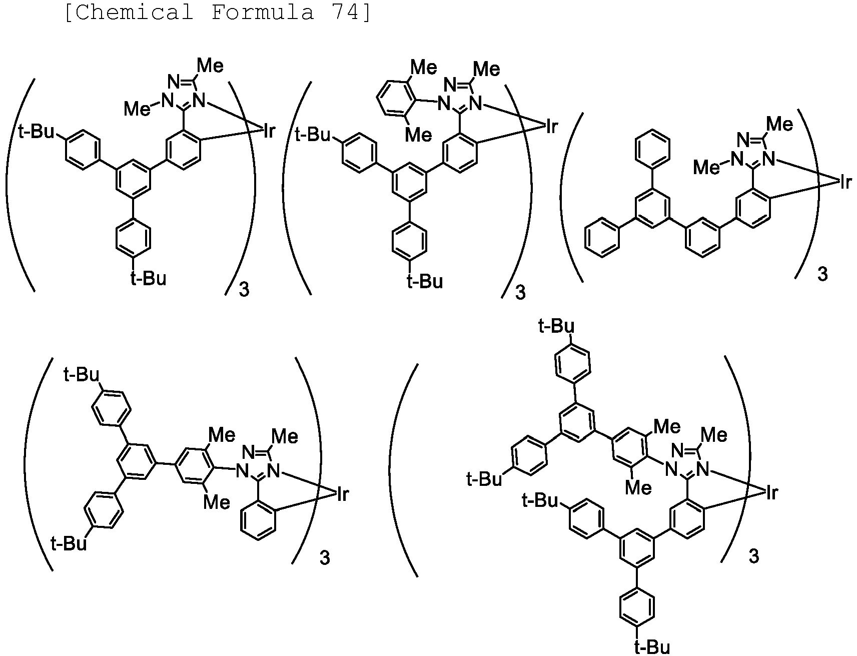

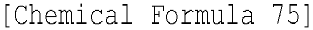

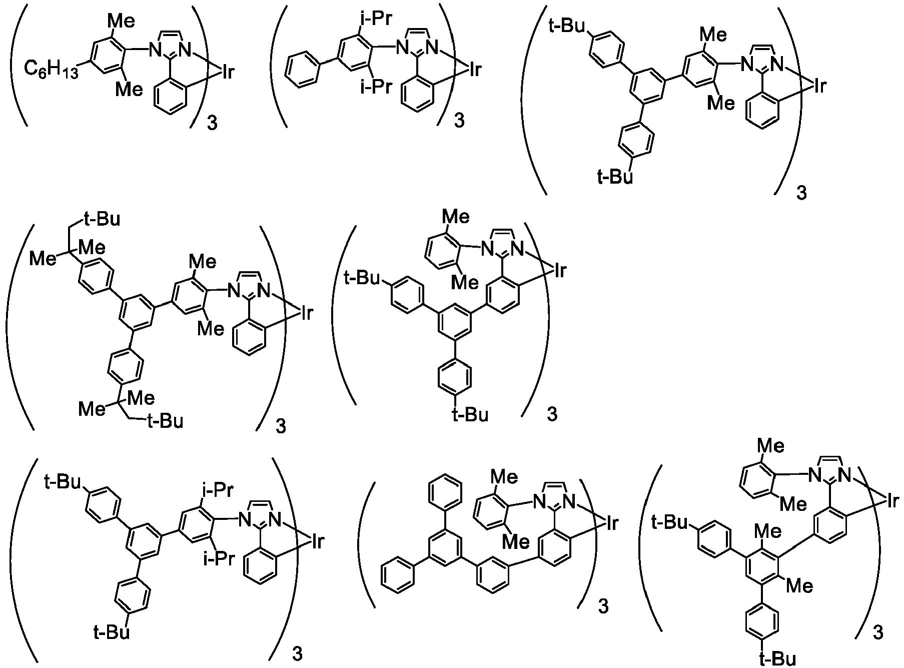

In the first composition, the content of the light emitting material is usually 0.01 to 400 parts by mass, preferably 0.1 to 100 parts by mass, more preferably 0.5 to 50 parts by mass, further preferably 1 to 10 parts by mass, when the amount of the metal complex represented by the formula (1) is taken as 100 parts by mass.

The light emitting material may be used singly or in combination of two or more kinds thereof.

### [Antioxidant]

The antioxidant may be a compound which is soluble in a solvent which is the same as the solvent for the metal complex represented by the formula (1) and does not inhibit light emission and charge transportation, and includes, for example, phenol type antioxidants and phosphorus-based antioxidants.

In the first composition, the compounding amount of the antioxidant is usually 0.001 to 10 parts by mass, when the amount of a metal complex represented by the formula (1) is taken as 100 parts by mass.

The antioxidant may be used singly or in combination of two or more kinds thereof.

### [First ink]

The composition containing a metal complex represented by the formula (1) and a solvent (hereinafter, referred to also as "first ink") can be suitably used for wet methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method and the like.

The viscosity of the first ink may be adjusted depending on the type of the wet method, and when applied to printing methods in which a solution passes through a discharge device such as an inkjet printing method and the like, the viscosity is preferably 1 to 20 mPa·s at 25°C since clogging and flight deflection during discharge scarcely occur.

The solvent contained in the first ink is preferably a solvent which can dissolve or uniformly disperse solid components in the ink. The solvent includes, for example, chlorine-based solvents such as 1,2-dichloroethane, 1,1,2-trichloroethane, chlorobenzene, o-dichlorobenzene and the like; ether solvents such as tetrahydrofuran, dioxane, anisole, 4-methylanisole and the like; aromatic hydrocarbon solvents such as toluene, xylene, mesitylene, ethylbenzene, n-hexylbenzene, cyclohexylbenzene and the like; aliphatic hydrocarbon solvents such as cyclohexane, methylcyclohexane, n-pentane, n-hexane, n-heptane, n-octane, n-nonane, n-decane, n-dodecane, bicyclohexyl and the like; ketone solvents such as acetone, methyl ethyl ketone, cyclohexanone, acetophenone and the like; ester solvents such as ethyl acetate, butyl acetate, ethylcellosolve acetate, methyl benzoate, phenyl acetate and the like; polyhydric alcohol solvents such as ethylene glycol, glycerin, 1,2-hexanediol and the like; alcohol solvents such as isopropyl alcohol, cyclohexanol and the like; sulfoxide solvents such as dimethyl sulfoxide and the like; and amide solvents such as N-methyl-2-pyrrolidone, N,N-dimethylformamide and the like. The solvent may be used each singly or in combination of two or more kinds thereof.

In the first ink, the content of the solvent is usually 1000 to 100000 parts by mass, preferably 2000 to 20000 parts by mass, when the amount of the metal complex represented by the formula (1) is taken as 100 parts by mass.

### (Second organic layer)

The second organic layer is a layer containing at least one selected from the group consisting of a metal complex represented by the formula (2), and a polymer compound (hereinafter, referred to also as "second organic layer polymer compound") containing a constitutional unit having a group obtained by removing from the metal complex represented by the formula (2) one or more hydrogen atoms (hereinafter, referred to as "metal complex constitutional unit"). In the second organic layer, the metal complex represented by the formula (2) may be contained singly or in combination of two or more kinds thereof. In the second organic layer, the second organic layer polymer compound may be contained singly or in combination of two or more kinds thereof.

### <Metal complex represented by the formula (2)>

The metal complex represented by the formula (2) is usually a metal complex showing phosphorescence at room temperature (25°C), preferably a metal complex showing light emission from triplet excited state at room temperature.

M² is preferably an iridium atom or a platinum atom, more preferably an iridium atom, since the light emitting device of the present invention is more excellent in external quantum efficiency.

When M² is a rhodium atom or an iridium atom, n³ is preferably 2 or 3, more preferably 3.

When M² is a palladium atom or a platinum atom, n³ is preferably 2.

E^{L} is preferably a carbon atom.

The number of carbon atoms of the aromatic hetero ring as Ring L¹, not including the number of carbon atoms of the substituent, is usually 2 to 60, preferably 3 to 30, more preferably 4 to 15. Ring L¹ is preferably a 6-membered aromatic hetero ring having one or more and four or less nitrogen atoms as a constituent atom, more preferably a 6-membered aromatic hetero ring having one or more and two or less nitrogen atoms as a constituent atom, and the foregoing rings optionally have a substituent.

Ring L¹ includes, for example, a pyridine ring, a diazabenzene ring, a triazine ring, an azanaphthalene ring, a diazanaphthalene ring and a triazanaphthalene ring, and it is preferably a pyridine ring, a diazabenzene ring, an azanaphthalene ring or a diazaphthalene ring, more preferably a pyridine ring, a pyrimidine ring, a quinoline ring or an isoquinoline ring, further preferably a pyridine ring or an isoquinoline ring, and the foregoing rings optionally have a substituent.

The examples and preferable range of the aromatic hydrocarbon ring as Ring L² are the same as the examples and preferable range of the aromatic hydrocarbon ring as Ring R².

The number of carbon atoms of the aromatic hetero ring as Ring L², not including the number of carbon atoms of the substituent, is usually 2 to 60, preferably 3 to 30, more preferably 4 to 15. The aromatic hetero ring as Ring L² includes a pyrrole ring, a diazole ring, a furan ring, a thiophene ring, a pyridine ring and a diazabenzene ring, and rings obtained by condensing one or more and five or less aromatic rings to these rings, and since the light emitting device of the present invention is more excellent in external quantum efficiency, it is preferably a pyridine ring, a diazabenzene ring, an azanaphthalene ring, a diazanaphthalene ring, an indole ring, a benzofuran ring, a benzothiophene ring, a carbazole ring, an azacarbazole ring, a diazacarbazole ring, a dibenzofuran ring or a dibenzothiophene ring, more preferably a pyridine ring, a diazabenzene ring, a carbazole ring, a dibenzofuran ring or a dibenzothiophene ring, further preferably a pyridine ring or a diazabenzene ring, and the foregoing rings optionally have a substituent. When Ring L² is a 6-membered aromatic hetero ring, E^{L} is preferably a carbon atom.

Ring L² is preferably a benzene ring, a fluorene ring, a dihydrophenanthrene ring, a pyridine ring, a diazabenzene ring, a carbazole ring, a dibenzofuran ring or a dibenzothiophene ring, more preferably a benzene ring, a pyridine ring or a diazabenzene ring, further preferably a benzene ring, and the foregoing rings optionally have a substituent, since the light emitting device of the present invention is further excellent in external quantum efficiency.

It is preferable that at least one of Ring L¹ and Ring L² has a group represented by the formula (1-T), since the light emitting device of the present invention is more excellent in external quantum efficiency.

"At least one of Ring L¹ and Ring L² has a group represented by the formula (1-T)" means that a group represented by the formula (1-T) is bonded directly to at least one of atoms (preferably, carbon atoms or nitrogen atoms) constituting Ring L¹ and Ring L². When a plurality of Ring L¹ and Ring L² are present in the metal complex represented by the formula (2), at least one of the plurality of Ring L¹ and Ring L² may have a group represented by the formula (1-T), however, it is preferable that all of a plurality of Ring L¹, all of a plurality of Ring L² or all of a plurality of Ring L¹ and Ring L² have a group represented by the formula (1-T), it is more preferable that all of a plurality of Ring L¹ or all of a plurality of Ring L² have a group represented by the formula (1-T), since the light emitting device of the present invention is more excellent in external quantum efficiency.

The number of the group represented by the formula (1-T) which at least one of Ring L¹ and Ring L² has in the metal complex represented by the formula (2) is usually 1 to 5, and since the metal complex represented by the formula (2) can be synthesized easily, it is preferably 1 to 3, more preferably 1 to 2, further preferably 1.

When M² is a rhodium atom or an iridium atom in the metal complex represented by the formula (2), the total number of the group represented by the formula (1-T) which Ring L¹ and Ring L² have is usually 1 to 30, and since the light emitting device of the present invention is more excellent in external quantum efficiency, it is preferably 1 to 18, more preferably 2 to 12, further preferably 3 to 6.

When M² is a palladium atom or a platinum atom in the metal complex represented by the formula (2), the total number of the group represented by the formula (1-T) which Ring L¹ and Ring L² have is usually 1 to 20, and since the light emitting device of the present invention is more excellent in external quantum efficiency, it is preferably 1 to 12, more preferably 1 to 8, further preferably 2 to 4.

The substituent which Ring L¹ and Ring L² optionally have other than the group represented by the formula (1-T) is preferably a cyano group, an alkenyl group or a cycloalkenyl group, and the foregoing groups optionally further have a substituent.

When a plurality of substituents which Ring L¹ optionally has are present, it is preferable that they are not combined together to form a ring together with atoms to which they are attached.

When a plurality of substituents which Ring L² optionally has are present, it is preferable that they are not combined together to form a ring together with atoms to which they are attached.

It is preferable that a substituent which Ring L¹ optionally has and a substituent which Ring L² optionally has are not combined together to form a ring together with atoms to which they are attached.

The examples and preferable range of the anionic bidentate ligand represented by A³-G²-A⁴ are the same as the examples and preferable range of the anionic bidentate ligand represented by A¹-G¹-A. In the anionic bidentate ligand represented by A³-G²-A⁴, * in the above-described formula represents a site binding to M². However, the anionic bidentate ligand represented by A³-G²-A⁴ is different from a ligand of which number is defined by subscript n³.

### [Group represented by the formula (1-T)]

The examples and preferable ranges of the aryl group, the monovalent hetero ring group and the substituted amino group represented by R^{1T} are the same as the examples and preferable ranges of the aryl group, the monovalent hetero ring group and the substituted amino group represented by R^{11A} to R^{13A}, respectively.

The examples and preferable range of the substituent which R^{1T} optionally has are the same as the examples and preferable range of the substituent which R^{11A} to R^{13A} optionally have.

R^{1T} is preferably an alkyl group, a cycloalkyl group, an aryl group, a monovalent hetero ring group or a substituted amino group, more preferably an alkyl group, a cycloalkyl group or a group represented by the formula (D-A) to the formula (D-C), further preferably an alkyl group or a group represented by the formula (D-A) or the formula (D-C), particularly preferably a group represented by the formula (D-A), and the foregoing groups optionally have a substituent, since the light emitting device of the present invention is more excellent in external quantum efficiency.

### (Metal complex represented by the formula (2-B))

The metal complex represented by the formula (2) is preferably a metal complex represented by the formula (2-B), since the light emitting device of the present invention is more excellent in external quantum efficiency.

Ring L^{1B} is preferably a pyridine ring, a pyrimidine ring, a quinoline ring or an isoquinoline ring, more preferably a pyridine ring or an isoquinoline ring, further preferably a pyridine ring, and the foregoing rings optionally have a substituent.

The substituent which Ring L^{1B} optionally has is preferably a group represented by the formula (1-T).

The examples and preferable range of the substituent which Ring L^{1B} optionally has other than the group represented by the formula (1-T) are the same as the examples and preferable range of the substituent which Ring L¹ and Ring L² optionally have other than the group represented by the formula (1-T).

When a plurality of substituents which Ring L^{1B} optionally has are present, it is preferable that they are not combined together to form a ring together with atoms to which they are attached.

When Ring L^{2B} is a pyridine ring, a pyridine ring in which E^{21B} is a nitrogen atom, a pyridine ring in which E^{22B} is a nitrogen atom, or a pyridine ring in which E^{23B} is a nitrogen atom is preferable, a pyridine ring in which E^{22B} is a nitrogen atom is more preferable.

When Ring L^{2B} is a diazabenzene ring, a pyrimidine ring in which E^{21B} and E^{23B} are each a nitrogen atom, or a pyrimidine ring in which E^{22B} and E^{24B} are each a nitrogen atom is preferable, a pyrimidine ring in which E^{22B} and E^{24B} are each a nitrogen atom is more preferable.

E^{21B} to E^{24B} are each preferably a carbon atom.

Ring L^{2B} is preferably a benzene ring.

It is preferable that at least one of Ring L^{1B} has a group represented by the formula (1-T) or at least one of R^{21B} to R^{24B} is a group represented by the formula (1-T), since the light emitting device of the present invention is more excellent in external quantum efficiency.

When at least one of Ring L^{1B} has a group represented by the formula (1-T), a group represented by the formula (1-T) may be bonded directly to at least one of atoms (preferably, carbon atoms or nitrogen atoms) constituting Ring L^{1B}. When at least one of Ring L^{1B} has a group represented by the formula (1-T) and when a plurality of Ring L^{1B} are present, at least one of the plurality of Ring L^{1B} may have a group represented by the formula (1-T), and since the light emitting device of the present invention is more excellent in external quantum efficiency, it is preferable that at least two of the plurality of Ring L^{1B} have a group represented by the formula (1-T), it is more preferable that all of the plurality of Ring L^{1B} have a group represented by the formula (1-T).

When at least one of R^{21B} to R^{24B} is a group represented by the formula (1-T), it is preferable that at least one of R^{22B} and R^{23B} is a group represented by the formula (1-T), it is more preferable that R^{22B} or R^{23B} is a group represented by the formula (1-T), it is further preferable that R^{22B} is a group represented by the formula (1-T), since the light emitting device of the present invention is more excellent in external quantum efficiency.

It is preferable that at least one of R^{21B} and R^{24B} is a hydrogen atom, it is more preferable that R^{21B} or R^{24B} is a hydrogen atom, it is further preferable that R^{21B} and R^{24B} are each a hydrogen atom, since the metal complex represented by the formula (2-B) can be synthesized easily.

The total number of the group represented by the formula (1-T) which the metal complex represented by the formula (2-B) has is the same as the total number of the group represented by the formula (1-T) which Ring L¹ and Ring L² have in the metal complex represented by the formula (2).

It is preferable that R^{21B} and R^{22B}, R^{22B} and R^{23B}, R^{23B} and R^{24B}, and a substituent which Ring L^{1B} optionally has and R^{21B} are each not combined together to form a ring together with atoms to which they are attached.

The metal complex represented by the formula (2-B) is preferably a metal complex represented by the formula (2-B1) to the formula (2-B5), more preferably a metal complex represented by the formula (2-B1) to the formula (2-B3), further preferably a metal complex represented by the formula (2-B1) or the formula (2-B2), particularly preferably a metal complex represented by the formula (2-B1), since the light emitting device of the present invention is more excellent in external quantum efficiency. 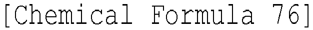 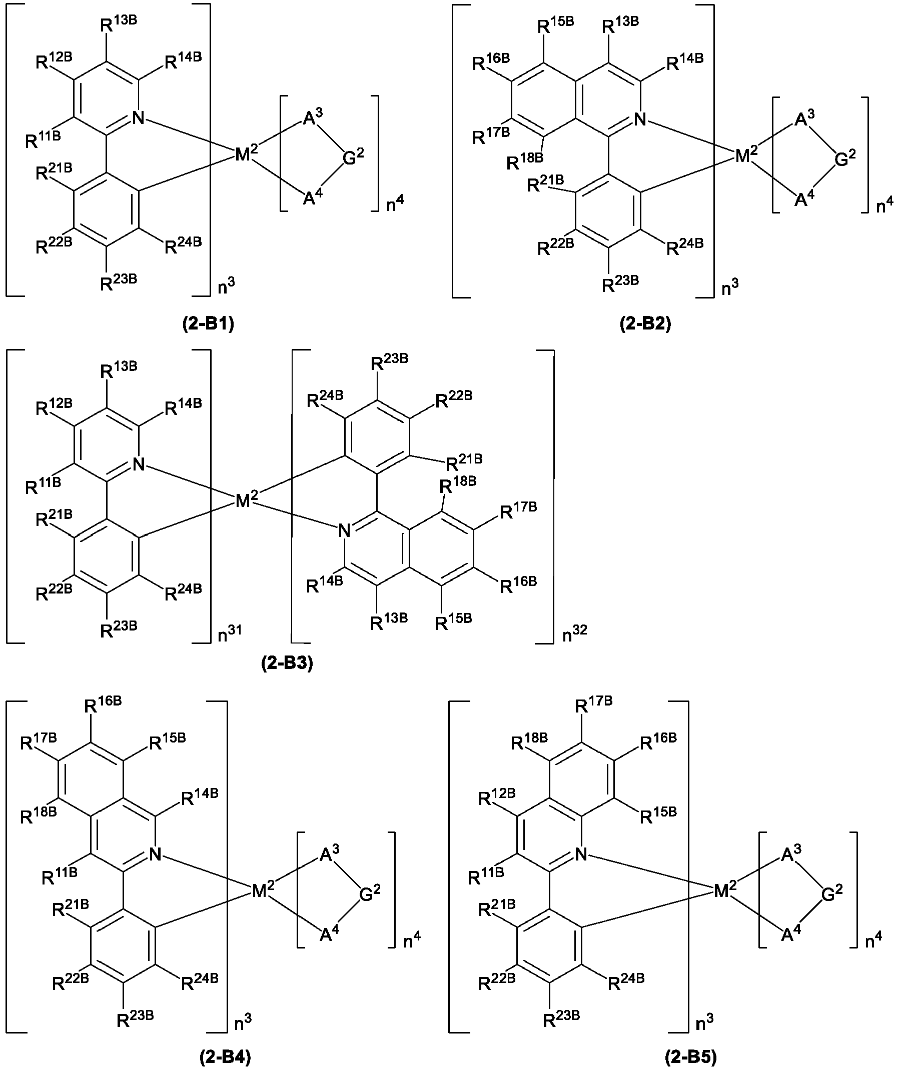 [wherein,
M², n³, n⁴, R^{21B}, R^{22B}, R^{23B}, R^{24B} and A³-G²-A⁴ represent the same meaning as described above.
n³¹ and n³² each independently represent an integer of 1 or more, provided that n³¹+n³² is 3 when M² is a rhodium atom or an iridium atom, while n³¹+n³² is 2 when M² is a palladium atom or a platinum atom.
R^{11B}, R^{12B}, R^{13B}, R^{14B}, R^{15B}, R^{16B}, R^{17B} and R^{18B} each independently represent a hydrogen atom or the above-described group represented by the formula (1-T). When a plurality of R^{11B}, R^{12B}, R^{13B}, R^{14B}, R^{15B}, R^{16B}, R^{17B} and R^{18B} are present, they may be the same or different at each occurrence.
In the formula (2-B1) and the formula (2-B3), R^{11B} and R^{12B}, R^{12B} and R^{13B}, R^{13B} and R^{14B}, and, R^{11B} and R^{21B} each may be combined together to form a ring together with atoms to which they are attached. In the formula (2-B2) and the formula (2-B3), R^{13B} and R^{14B}, R^{13B} and R^{15B}, R^{15B} and R^{16B}, R^{16B} and R^{17B}, R^{17B} and R^{18B}, and, R^{18B} and R^{21B} each may be combined together to form a ring together with atoms to which they are attached. In the formula (2-B4), R^{11B} and R^{18B}, R^{14B} and R^{15B}, R^{15B} and R^{16B}, R^{16B} and R^{17B}, R^{17B} and R^{18B}, and, R^{11B} and R^{21B} each may be combined together to form a ring together with atoms to which they are attached. In the formula (2-B5), R^{11B} and R^{12B}, R^{12B} and R^{18B}, R^{15B} and R^{16B}, R^{16B} and R^{17B}, R^{17B} and R^{18B}, and, R^{11B} and R^{21B} each may be combined together to form a ring together with atoms to which they are attached.]

In the formula (2-B1), it is preferable that at least one of R^{11B} to R^{14B} and R^{21B} to R^{24B} is a group represented by the formula (1-T), since the light emitting device of the present invention is more excellent in external quantum efficiency. In the formula (2-B1), when at least one of R^{11B} to R^{14B} is a group represented by the formula (1-T), it is preferable that at least one of R^{12B} and R^{13B} is a group represented by the formula (1-T), it is more preferable that R^{12B} or R^{13B} is a group represented by the formula (1-T), it is further preferable that R^{13B} is a group represented by the formula (1-T).

In the formula (2-B1), it is preferable that at least one of R^{12B}, R^{13B}, R^{22B} and R^{23B} is a group represented by the formula (1-T), it is more preferable that at least one of R^{13B}, R^{22B} and R^{23B} is a group represented by the formula (1-T), it is further preferable that at least one of R^{13B} and R^{22B} is a group represented by the formula (1-T), it is particularly preferable that R^{13B} or R^{22B} is a group represented by the formula (1-T), since the light emitting device of the present invention is further excellent in external quantum efficiency.

In the formula (2-B2), it is preferable that at least one of R^{13B} to R^{18B} and R^{21B} to R^{24B} is a group represented by the formula (1-T), it is more preferable that at least one of R^{12B}, R^{13B}, R^{22B} and R^{23B} is a group represented by the formula (1-T), it is further preferable that at least one of R^{22B} and R^{23B} is a group represented by the formula (1-T), it is particularly preferable that R^{22B} or R^{23B} is a group represented by the formula (1-T), since the light emitting device of the present invention is more excellent in external quantum efficiency.

In the formula (2-B3), it is preferable that at least one of R^{11B} to R^{18B} and R^{21B} to R^{24B} is a group represented by the formula (1-T), it is more preferable that at least one of R^{12B}, R^{13B}, R^{22B} and R^{23B} is a group represented by the formula (1-T), it is further preferable that at least one of R^{13B} and R^{22B} is a group represented by the formula (1-T), it is particularly preferable that R^{13B} or R^{22B} is a group represented by the formula (1-T), since the light emitting device of the present invention is more excellent in external quantum efficiency.

In the formula (2-B4), it is preferable that at least one of R^{11B}, R^{14B} to R^{18B} and R^{21B} to R^{24B} is a group represented by the formula (1-T), it is more preferable that at least one of R^{22B} and R^{23B} is a group represented by the formula (1-T), since the light emitting device of the present invention is more excellent in external quantum efficiency.

In the formula (2-B5), it is preferable that at least one of R^{11B}, R^{12B}, R^{15B} to R^{18B} and R^{21B} to R^{24B} is a group represented by the formula (1-T), it is more preferable that at least one of R^{22B} and R^{23B} is a group represented by the formula (1-T), since the light emitting device of the present invention is more excellent in external quantum efficiency.

In the formula (2-B1) and the formula (2-B3), it is preferable that R^{11B} and R^{12B}, R^{12B} and R^{13B}, R^{13B} and R^{14B}, and R^{11B} and R^{21B} are each not combined together to form a ring together with atoms to which they are attached. In the formula (2-B2) and the formula (2-B3), it is preferable that R^{13B} and R^{14B}, R^{13B} and R^{15B}, R^{15B} and R^{16B}, R^{16B} and R^{17B}, R^{17B} and R^{18B}, and R^{18B} and R^{21B} are each not combined together to form a ring together with atoms to which they are attached. In the formula (2-B4), it is preferable that R^{11B} and R^{18B}, R^{14B} and R^{15B}, R^{15B} and R^{16B}, R^{16B} and R^{17B}, R^{17B} and R^{18B}, and R^{11B} and R^{21B} are each not combined together to form a ring together with atoms to which they are attached. In the formula (2-B5), it is preferable that R^{11B} and R^{12B}, R^{12B} and R^{18B}, R^{15B} and R^{16B}, R^{16B} and R^{17B}, R^{17B} and R^{18B}, and R^{11B} and R^{21B} are each not combined together to form a ring together with atoms to which they are attached.

The total numbers of the group represented by the formula (1-T) which metal complexes represented by the formula (2-B1) to the formula (2-B5) have are the same as the total number of the group represented by the formula (1-T) which Ring L¹ and Ring L² have in the metal complex represented by the formula (2).

The metal complex represented by the formula (2) includes, for example, metal complexes represented by the following formulae and a metal complex G1 described later.

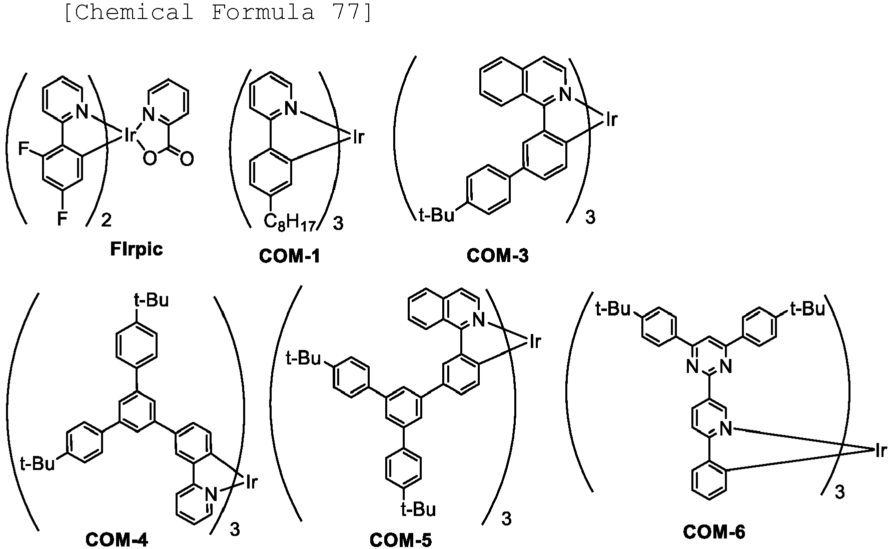

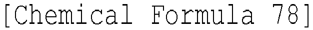

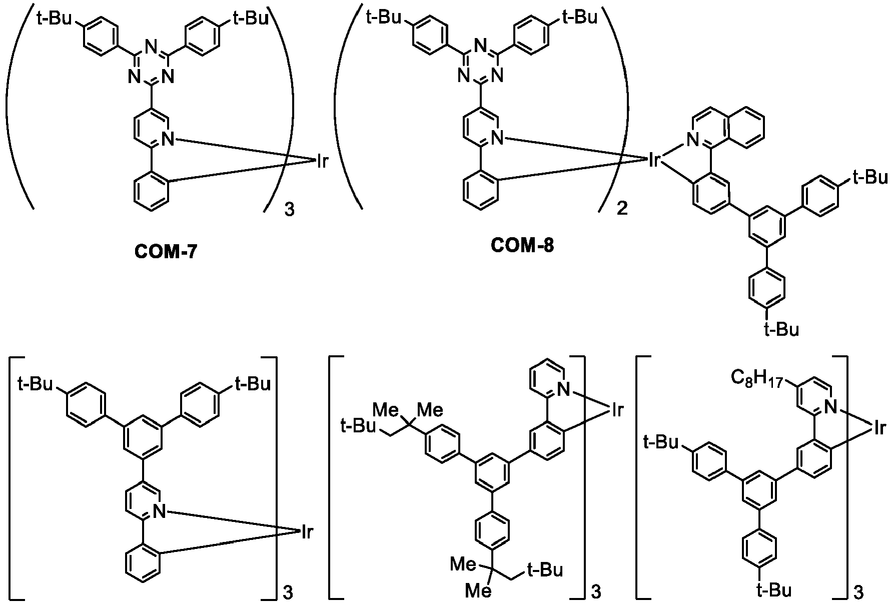

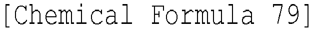

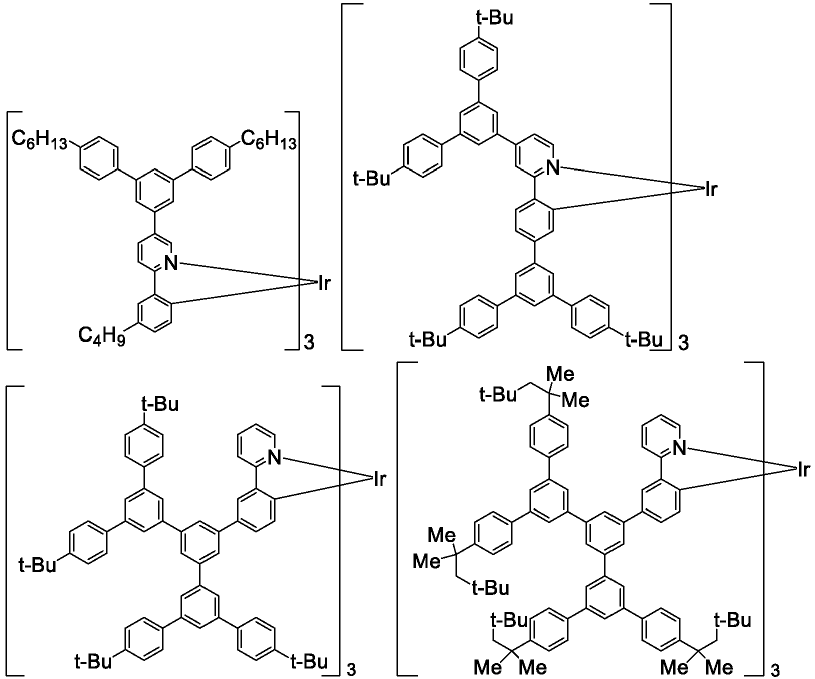

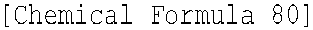

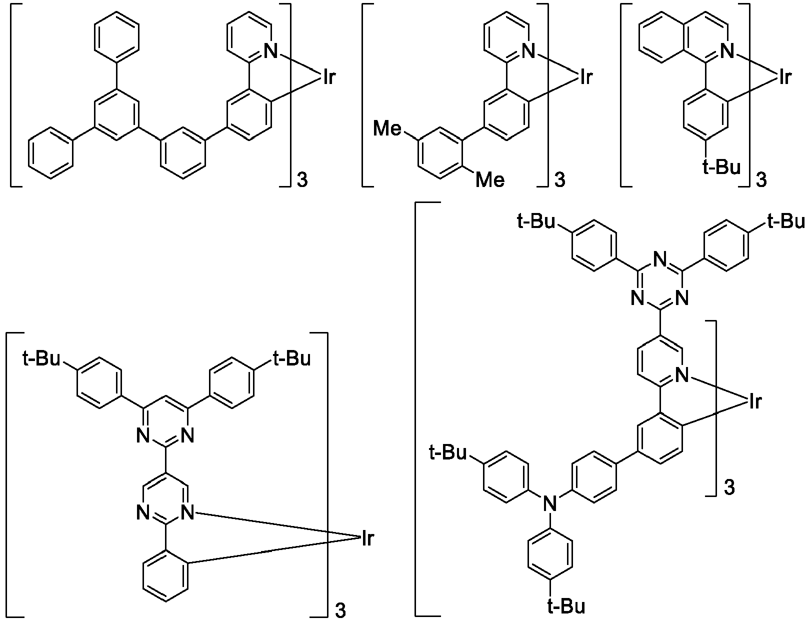

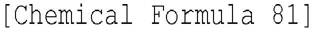

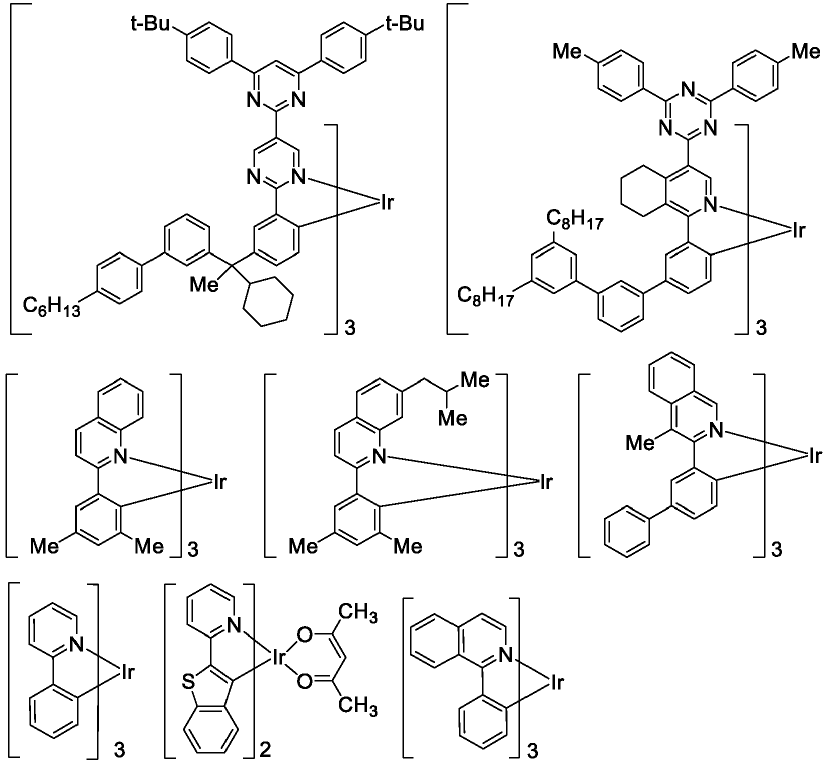

The metal complex represented by the formula (2) is available from Aldrich, Luminescence Technology Corp., American Dye Source and the like. Additionally, it can be synthesized according to methods described in, for example, "Journal of the American Chemical Society, Vol. 107, 1431-1432 (1985)", "Journal of the American Chemical Society, Vol. 106, 6647-6653 (1984)", Japanese Translation of PCT International Application Publication (JP-T) No. 2004-530254, Japanese Unexamined Patent Application Publication (JP-A) No. 2008-179617, JP-A No. 2011-105701, JP-T No. 2007-504272, International Publication WO 2006/121811.

The metal complex constitutional unit is preferably a constitutional unit containing a group obtained by removing from a metal complex represented by the formula (2) one or more and five or less hydrogen atoms, more preferably a constitutional unit containing a group obtained by removing from a metal complex represented by the formula (2) one or more and three or less hydrogen atoms, further preferably a constitutional unit represented by the formula (1-1B), a constitutional unit represented by the formula (1-2B), a constitutional unit represented by the formula (1-3B) or a constitutional unit represented by the formula (1-4B), particularly preferably a constitutional unit represented by the formula (1-1B), a constitutional unit represented by the formula (1-2B) or a constitutional unit represented by the formula (1-3B), especially preferably a constitutional unit represented by the formula (1-3B), since the light emitting device of the present invention is excellent in external quantum efficiency and synthesis thereof is easy.

### (Constitutional unit represented by the formula (1-1B))

R^{A} is preferably an aryl group or a monovalent hetero ring group, more preferably an aryl group, and the foregoing groups optionally have a substituent.

R^{B} is preferably a hydrogen atom, an alkyl group, a cycloalkyl group, an aryl group or a monovalent hetero ring group, more preferably a hydrogen atom, an alkyl group, a cycloalkyl group or an aryl group, further preferably a hydrogen atom or an alkyl group, particularly preferably a hydrogen atom, and the foregoing groups optionally have a substituent.

L^{C} is preferably -C(R^{B})₂-, an arylene group or a divalent hetero ring group, more preferably -C(R^{B})₂- or an arylene group, further preferably an arylene group, particularly preferably a group represented by the formula (A-1) or (A-2), and the foregoing groups optionally have a substituent.

The examples and preferable ranges of the arylene group and the divalent hetero ring group represented by L^{C} are the same as the examples and preferable ranges of the arylene group and the divalent hetero ring group represented by Ar^{Y1}, respectively.

The examples and preferable range of the substituent which R^{A}, R^{B} and L^{C} optionally have are the same as the examples and preferable range of the substituent which a group represented by Ar^{Y1} optionally has, respectively.

n^{c1} is usually an integer of 0 to 10, preferably an integer of 0 to 5, more preferably an integer of 0 to 2, further preferably 0 or 1, particularly preferably 0.

When the second organic layer polymer compound is a polymer compound containing a constitutional unit represented by the formula (1-1B), the constitutional unit represented by the formula (1-1B) is an end constitutional unit.

"End constitutional unit" denotes an end constitutional unit of a polymer compound, and the end constitutional unit is preferably a constitutional unit derived from an endcapping agent in production of the polymer compound.

M^{1B} is more preferably a group represented by the formula (BM-1). 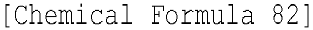 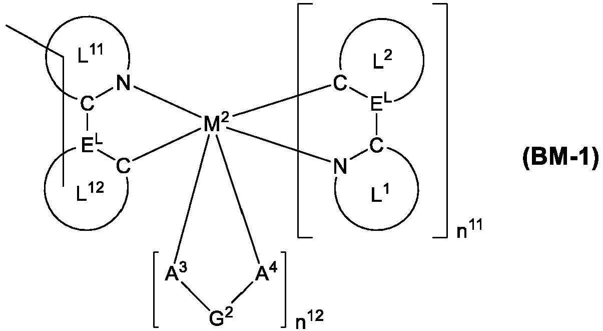 [wherein,
M², E^{L}, Ring L¹, Ring L² and A³-G²-A⁴ represent the same meaning as described above.
Ring L¹¹ represents a 6-membered aromatic hetero ring, and the foregoing rings optionally have a substituent. When a plurality of the substituents are present, they may be the same or different and may be combined together to form a ring together with atoms to which they are attached.
Ring L¹² represents an aromatic hydrocarbon ring or an aromatic hetero ring, and the foregoing rings optionally have a substituent. When a plurality of the substituents are present, they may be the same or different and may be combined together to form a ring together with atoms to which they are attached.
One of Ring L¹¹ and Ring L¹² has one connecting bond.
n¹¹ and n¹² each independently represent an integer of 0 or more, provided that n¹¹+n¹² is 1 or 2 and n¹¹+n¹² is 2 when M² is a rhodium atom or an iridium atom, while n¹¹+n¹² is 1 when M² is a palladium atom or a platinum atom.]

When M² is a rhodium atom or an iridium atom, it is preferable that n¹¹ is 2.

When M² is a palladium atom or a platinum atom, it is preferable that n¹¹ is 1.

When Ring L¹¹ has no connecting bond, the definition, examples and preferable range of Ring L¹¹ are the same as the definition, examples and preferable range of Ring L¹ described above.

When Ring L¹¹ has a connecting bond, the definition, examples and preferable range of the ring portion obtained by removing the connecting bond of Ring L¹¹ are the same as the definition, examples and preferable range of Ring L¹ described above.

When Ring L¹² has no connecting bond, the definition, examples and preferable range of Ring L¹² are the same as the definition, examples and preferable range of Ring L² described above.

When Ring L¹² has a connecting bond, the definition, examples and preferable range of the ring portion obtained by removing the connecting bond of Ring L¹² are the same as the definition, examples and preferable range of Ring L² described above.

The definition, examples and preferable range of the substituent which Ring L¹¹ and Ring L¹² optionally have are the same as the definition, examples and preferable range of the substituent which Ring L¹ and Ring L² optionally have.

### [Constitutional unit represented by the formula (1-2B)]

L^{d} is preferably -C(R^{B})₂-, an arylene group or a divalent hetero ring group, more preferably an arylene group or a divalent hetero ring group, further preferably an arylene group, particularly preferably a group represented by the formula (A-1) or (A-2), and the foregoing groups optionally have a substituent.

L^{e} is preferably -C(R^{B})₂-, an arylene group or a divalent hetero ring group, more preferably -C(R^{B})₂- or an arylene group, further preferably an arylene group, particularly preferably a group represented by the formula (A-1) or (A-2), and the foregoing groups optionally have a substituent.

The examples and preferable ranges of the arylene group and the divalent hetero ring group represented by L^{d} and L^{e} are the same as the examples and preferable ranges of the arylene group and the divalent hetero ring group represented by Ar^{Y1}, respectively.

n^{d1} and n^{e1} are each usually an integer of 0 to 10, preferably an integer of 0 to 5, more preferably an integer of 0 to 2, further preferably 0 or 1, particularly preferably 0.

Ar^{1M} is preferably a group obtained by removing from a benzene ring, a naphthalene ring, a fluorene ring, a phenanthrene ring, a dihydrophenanthrene ring, a pyridine ring, a diazabenzene ring, a triazine ring, a carbazole ring, a phenoxazine ring or a phenothiazine ring three hydrogen atoms bonding directly to carbon atoms or hetero atoms constituting the ring, more preferably a group obtained by removing from a benzene ring, a naphthalene ring, a fluorene ring, a phenanthrene ring or a dihydrophenanthrene ring three hydrogen atoms bonding directly to carbon atoms constituting the ring, further preferably a group obtained by removing from a benzene ring or a fluorene ring three hydrogen atoms bonding directly to carbon atoms constituting the ring, particularly preferably a group obtained by removing from a benzene ring three hydrogen atoms bonding directly to carbon atoms constituting the ring, and the foregoing groups optionally have a substituent.

The examples and preferable range of the substituent which L^{d}, L^{e} and Ar^{1M} optionally have are the same as the examples and preferable range of the substituent which a group represented by Ar^{Y1} described above optionally has, respectively.

### [Constitutional unit represented by the formula (1-3B)]

M^{2B} is more preferably a group represented by the formula (BM-2) or (BM-3), further preferably a group represented by the formula (BM-2). 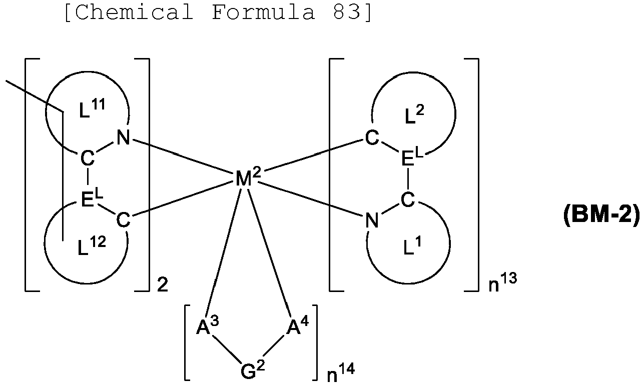 [wherein,
M², E^{L}, Ring L¹, Ring L², Ring L¹¹, Ring L¹² and A³-G²-A⁴ represent the same meaning as described above. A plurality of Ring L¹¹ may be the same or different. A plurality of Ring L¹² may be the same or different.
n¹³ and n¹⁴ each independently represent an integer of 0 or more, provided that n¹³+n¹⁴ is 0 or 1, and n¹³+n¹⁴ is 1 when M² is a rhodium atom or an iridium atom, while n¹³+n¹⁴ is 0 when M² is a palladium atom or a platinum atom.]

When M² is a rhodium atom or an iridium atom, it is preferable that n¹³ is 1. 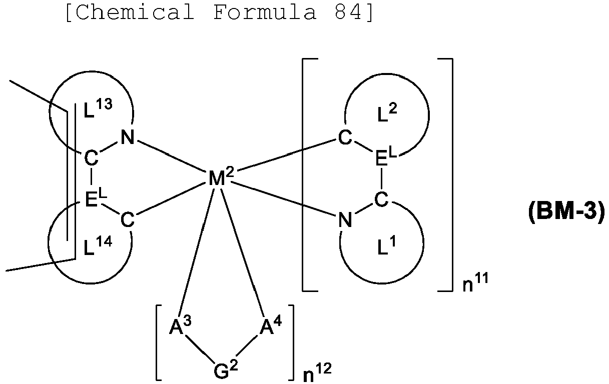 [wherein,
M², E^{L}, Ring L¹, Ring L², A³-G²-A⁴, n¹¹ and n¹² represent the same meaning as described above.
Ring L¹³ represents a 6-membered aromatic hetero ring, and the foregoing rings optionally have a substituent. When a plurality of the substituents are present, they may be the same or different and may be combined together to form a ring together with atoms to which they are attached.
Ring L¹⁴ represents an aromatic hydrocarbon ring or an aromatic hetero ring, and the foregoing rings optionally have a substituent. When a plurality of the substituents are present, they may be the same or different and may be combined together to form a ring together with atoms to which they are attached.
One of Ring L¹³ and Ring L¹⁴ has two connecting bonds, or each of Ring L¹³ and Ring L¹⁴ has one connecting bond, respectively.]

When Ring L¹³ has no connecting bond, the definition, examples and preferable range of Ring L¹³ are the same as the definition, examples and preferable range of Ring L¹.

When Ring L¹³ has a connecting bond, the definition, examples and preferable range of the ring portion obtained by removing the connecting bond of Ring L¹³ are the same as the definition, examples and preferable range of Ring L¹.

When Ring L¹⁴ has no connecting bond, the definition, examples and preferable range of Ring L¹⁴ are the same as the definition, examples and preferable range of Ring L².

When Ring L¹⁴ has a connecting bond, the definition, examples and preferable range of the ring portion obtained by removing the connecting bond of Ring L¹⁴ are the same as the definition, examples and preferable range of Ring L².

The definition, examples and preferable range of the substituent which Ring L¹³ and Ring L¹⁴ optionally have are the same as the definition, examples and preferable range of the substituent which Ring L¹ and Ring L² optionally have.

It is preferable that each of Ring L¹³ and Ring L¹⁴ has one connecting bond, respectively.

### [Constitutional unit represented by the formula (1-4B)]

M^{3B} is preferably a group represented by the formula (BM-4). 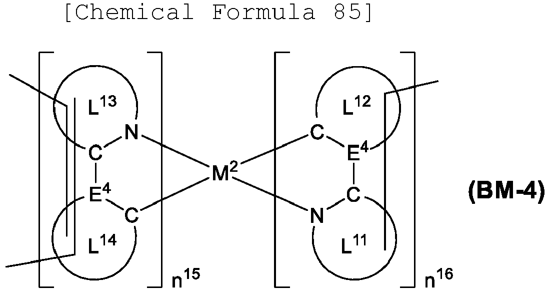 [wherein,
M², E^{L}, Ring L¹¹, Ring L¹², Ring L¹³ and Ring L¹⁴ represent the same meaning as described above.
n¹⁵ represents 0 or 1 and n¹⁶ represents 1 or 3, provided that n¹⁵ is 0 and n¹⁶ is 3 when M² is a rhodium atom or an iridium atom, while n¹⁵ is 1 and n¹⁶ is 1 when M² is a palladium atom or a platinum atom.]

The metal complex constitutional unit includes, for example, constitutional units represented by the formulae (1G-1) to (1G-13), (2G-1) to (2G-16), (3G-1) to (3G-23) or (4G-1) to (4G-6). 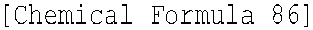 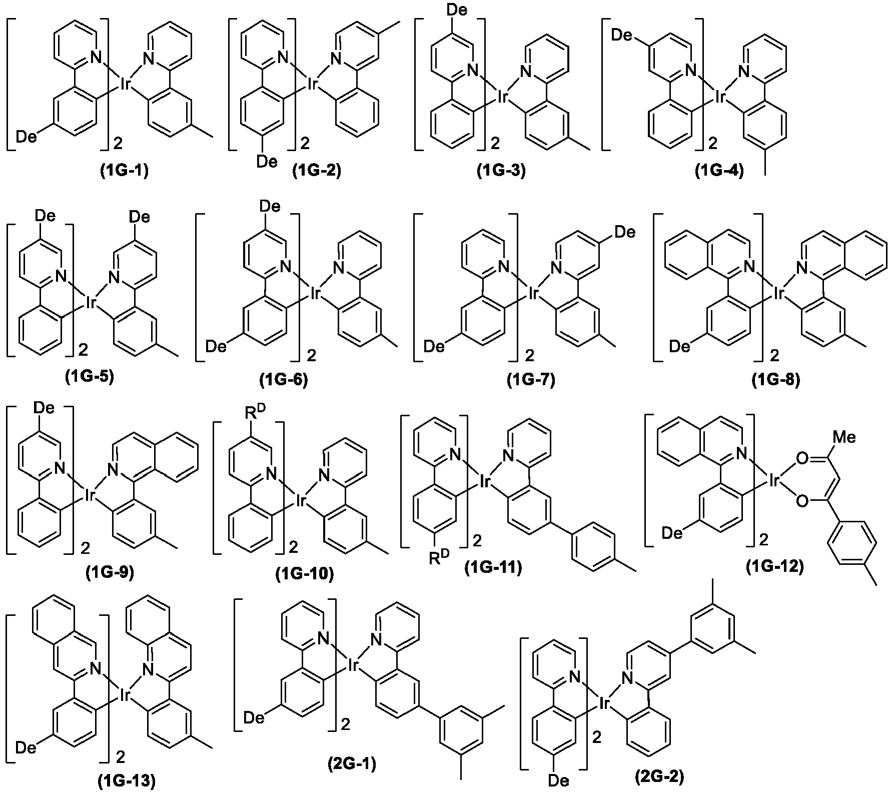 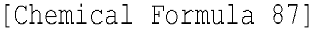 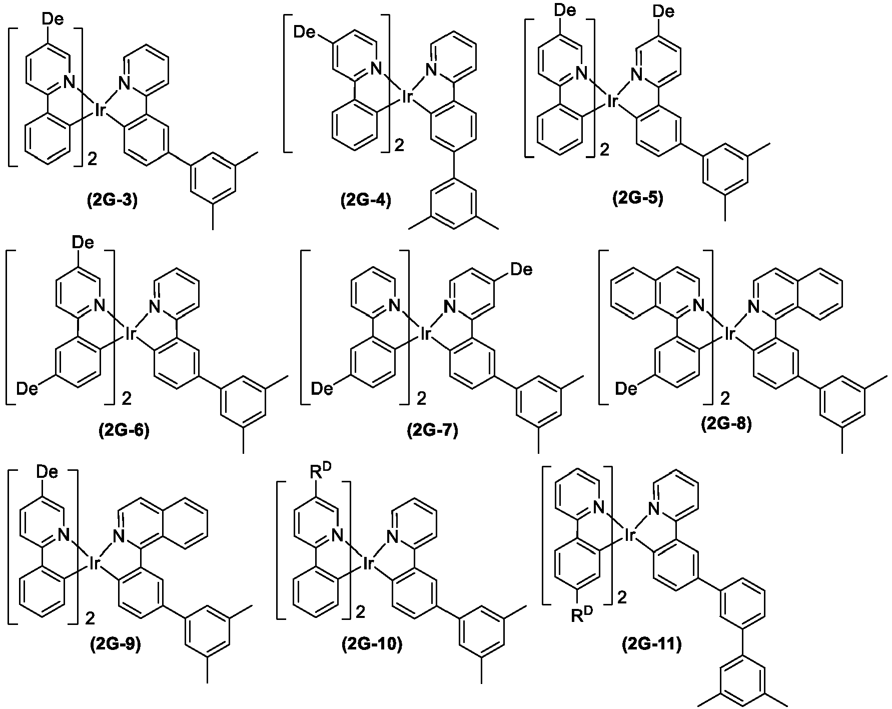 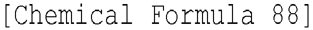 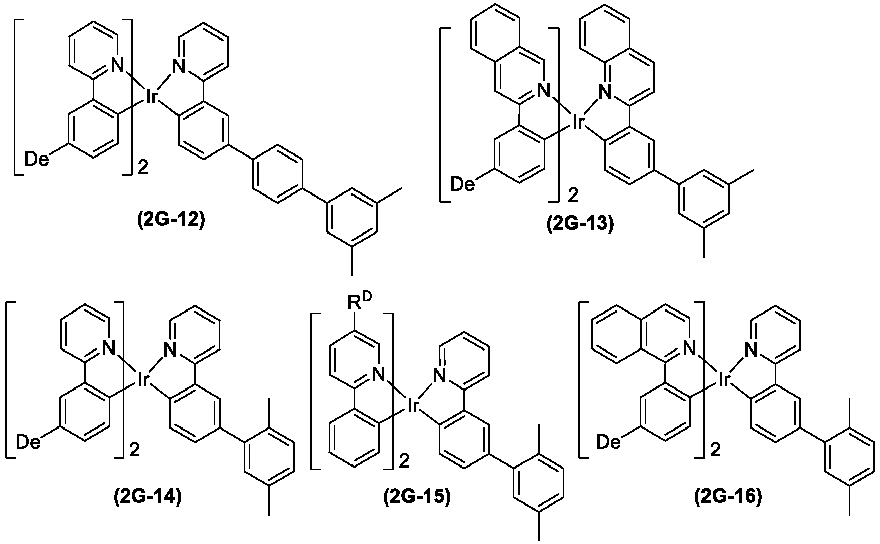 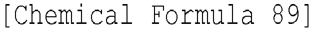 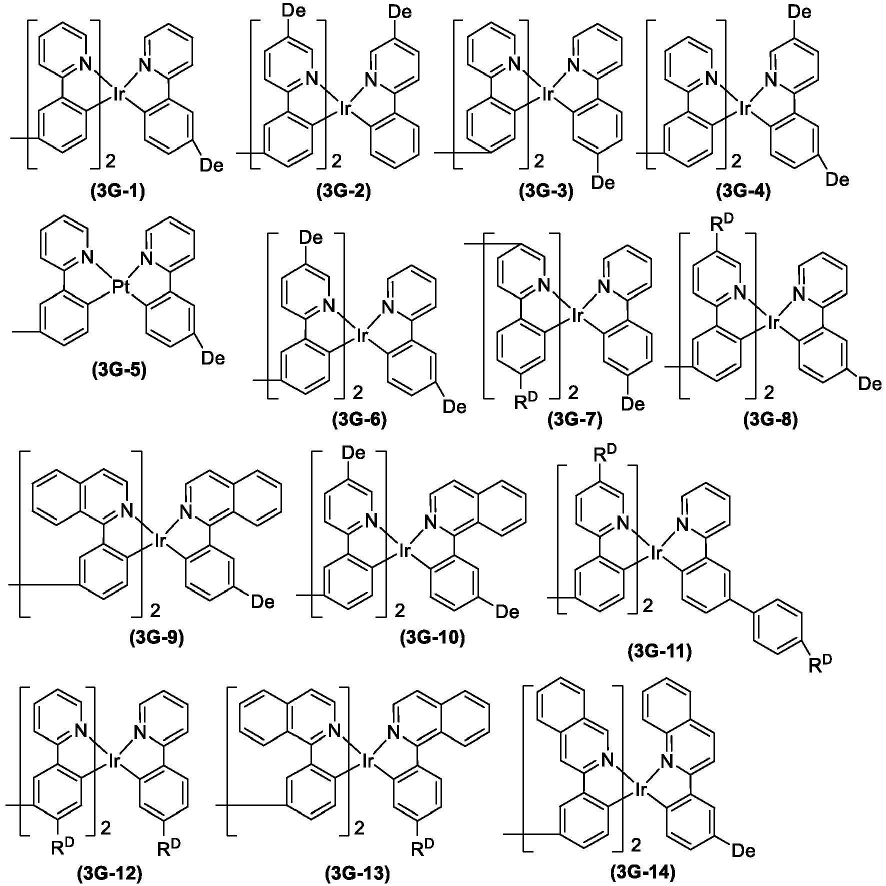 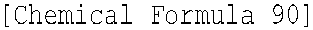 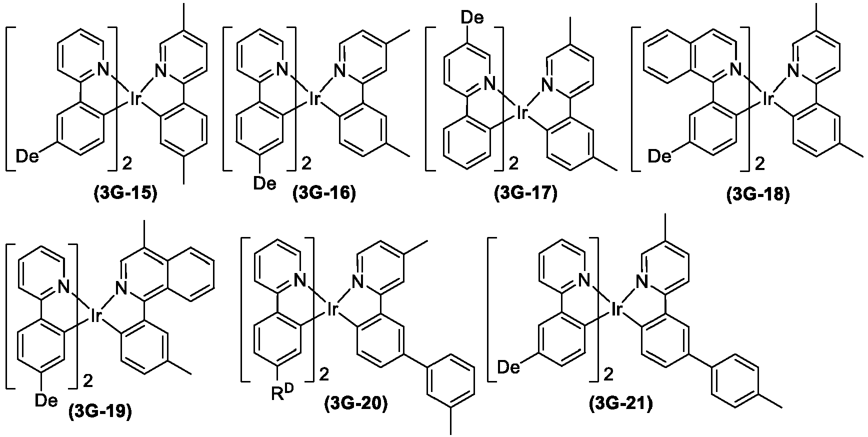 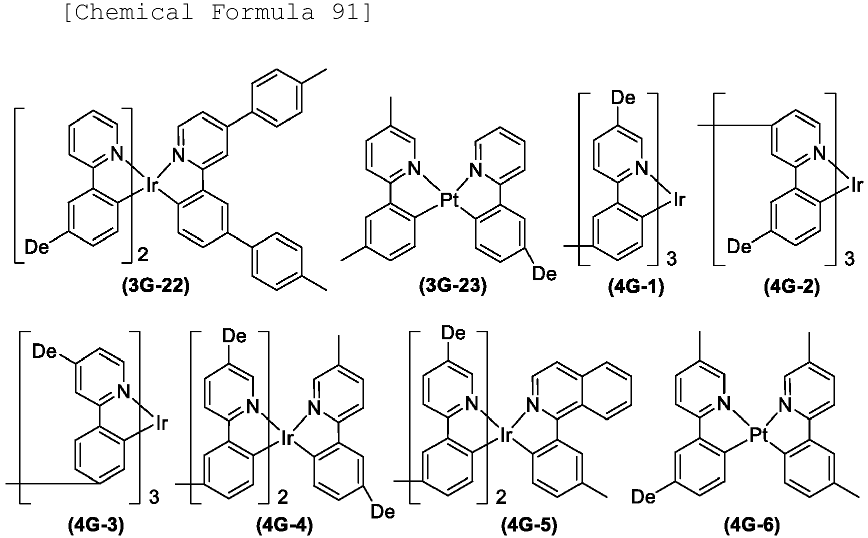 [wherein, R^{D} represents the same meaning as described above. De represents a group represented by the formula (D-A), (D-B) or (D-C).]

The amount of the metal complex constitutional unit is preferably 0.01 to 50% by mol, more preferably 0.1 to 30% by mol, further preferably 0.5 to 10% by mol, particularly preferably 1 to 5% by mol, with respect to the total amount of constitutional units contained in the second organic layer polymer compound, since the light emitting device of the present invention is excellent in external quantum efficiency. The metal complex constitutional unit may be contained only singly or in combination of two or more kinds thereof in the second organic layer polymer compound.

The second organic layer polymer compound is preferably a crosslinked body of a polymer compound containing a metal complex constitutional unit and a constitutional unit having a crosslinking group (hereinafter, referred to as "second (') organic layer polymer compound"), since the light emitting device of the present invention can be formed by a wetting method and lamination of the light emitting device is possible.

The amount of the constitutional unit having a crosslinking group is preferably 0.5 to 80% by mol, more preferably 3 to 65% by mol, further preferably 5 to 50% by mol, with respect to the total amount of constitutional units contained in the second (') organic layer polymer compound, since the second (') organic layer polymer compound is excellent in stability and crosslinkability. The constitutional unit having a crosslinking group may be contained only singly or in combination of two or more kinds thereof, in the second (') organic layer polymer compound.

### [The constitutional unit having crosslinking group]

In the constitutional unit having a crosslinking group, the crosslinking group is preferably a crosslinking group selected from Group A of crosslinking group, since the light emitting device of the present invention is excellent in external quantum efficiency.

The crosslinking group selected from Group A of crosslinking group is preferably a crosslinking group represented by the formula (XL-1) to the formula (XL-4), the formula (XL-7) to the formula (XL-10) or the formula (XL-14) to the formula (XL-19), more preferably a crosslinking group represented by the formula (XL-1), the formula (XL-3), the formula (XL-9), the formula (XL-10) or the formula (XL-16) to the formula (XL-19), further preferably a crosslinking group represented by the formula (XL-1) or the formula (XL-16) to the formula (XL-19), particularly preferably a crosslinking group represented by the formula (XL-1) or the formula (XL-17), since the light emitting device of the present invention is more excellent in external quantum efficiency.

The constitutional unit having at least one crosslinking group selected from Group A of crosslinking group in the second (') organic layer polymer compound is preferably a constitutional unit represented by the formula (Z) or a constitutional unit represented by the formula (Z'), more preferably a constitutional unit represented by the formula (Z), and may also be a constitutional unit represented by the following formula.

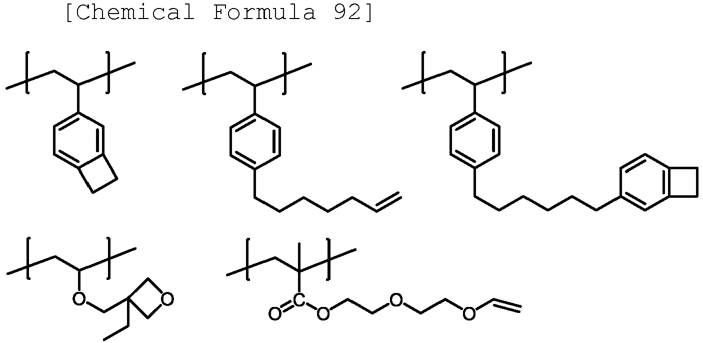

When the second (') organic layer polymer compound contains two or more kinds of constitutional units having at least one crosslinking group selected from Group A of crosslinking group, it is preferable that crosslinking groups are mutually different in at least two kinds of constitutional units having at least one crosslinking group selected from Group A of crosslinking group. The combination of mutually different crosslinking groups is preferably a combination of a crosslinking group represented by the formula (XL-1), the formula (XL-2), the formula (XL-5) to the formula (XL-8) or the formula (XL-14) to the formula (XL-16) with a crosslinking group represented by the formula (XL-3), the formula (XL-4), the formula (XL-13) or the formula (XL-17) to the formula (XL-19), more preferably a combination of a crosslinking group represented by the formula (XL-1) or the formula (XL-16) with a crosslinking group represented by the formula (XL-17) to the formula (XL-19), further preferably a combination of a crosslinking group represented by the formula (XL-1) with a crosslinking group represented by the formula (XL-17).

### (Constitutional unit represented by the formula (Z))

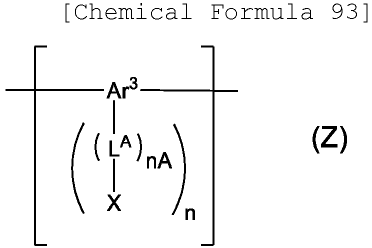

[wherein,
nA represents an integer of 0 to 5, and n represents 1 or 2. When a plurality of nA are present, they may be the same or different.
Ar³ represents an aromatic hydrocarbon group or a hetero ring group, and the foregoing groups optionally have a substituent.
L^{A} represents an alkylene group, a cycloalkylene group, an arylene group, a divalent hetero ring group, a group represented by -NR'-, an oxygen atom or a sulfur atom, and the foregoing groups optionally have a substituent. R' represents a hydrogen atom, an alkyl group, a cycloalkyl group, an aryl group or a monovalent hetero ring group, and the foregoing groups optionally have a substituent. When a plurality of L^{A} are present, they may be the same or different.
X represents a crosslinking group selected from Group A of crosslinking group. When a plurality of X are present, they may be the same or different.]

nA is preferably an integer of 0 to 3, more preferably an integer of 0 to 2, further preferably 1 or 2, since the light emitting device of the present invention is more excellent in external quantum efficiency.

n is preferably 2, since the light emitting device of the present invention is more excellent in external quantum efficiency.

Ar³ is preferably an aromatic hydrocarbon group optionally having a substituent, since the light emitting device of the present invention is more excellent in external quantum efficiency.

The number of carbon atoms of the aromatic hydrocarbon group represented by Ar³, not including the number of carbon atoms of the substituent, is usually 6 to 60, preferably 6 to 30, more preferably 6 to 18.

The examples and preferable range of the arylene group portion obtained by removing n substituents from the aromatic hydrocarbon group represented by Ar³ are the same as the examples and preferable range of the arylene group represented by Ar^{Y1}.

The number of carbon atoms of the hetero ring group represented by Ar³, not including the number of carbon atoms of the substituent, is usually 2 to 60, preferably 3 to 30, more preferably 4 to 18.

The examples and preferable range of the divalent hetero ring group portion obtained by removing n substituents from the hetero ring group represented by Ar³ are the same as the examples and preferable range of the divalent hetero ring group represented by Ar^{Y1}.

The examples and preferable range of the substituent which the group represented by Ar³ optionally has are the same as the examples and preferable range of the substituent which the group represented by Ar^{Y1} optionally has.

The number of carbon atoms of an alkylene group, not including the number of carbon atoms of the substituent, is usually 1 to 20, preferably 1 to 15, more preferably 1 to 10. The number of carbon atoms of a cycloalkylene group, not including the number of carbon atoms of the substituent, is usually 3 to 20.

The alkylene group and the cycloalkylene group include, for example, a methylene group, an ethylene group, a propylene group, a butylene group, a hexylene group, a cyclohexylene group and an octylene group, and the foregoing groups optionally have a substituent.

The examples and preferable range of the arylene group represented by L^{A} are the same as the examples and preferable range of the arylene group represented by Ar^{Y1}, and since the light emitting device of the present invention is more excellent in external quantum efficiency, the arylene group represented by L^{A} is preferably a phenylene group or a fluorenediyl group, more preferably a m-phenylene group, a p-phenylene group, a fluorene-2,7-diyl group or a fluorene-9,9-diyl group, and the foregoing groups optionally further have a substituent.

The examples and preferable range of the divalent hetero ring group represented by L^{A} are the same as the examples and preferable range of the divalent hetero ring group represented by Ar^{Y1}.

L^{A} is preferably an arylene group or an alkylene group, more preferably a phenylene group, a fluorenediyl group or an alkylene group, and the foregoing groups optionally have a substituent, since production of the second (') organic layer polymer compound is easy.

The substituent which the group represented by L^{A} optionally has is preferably an alkyl group, a cycloalkyl group, an alkoxy group, a cycloalkoxy group, an aryl group, a monovalent hetero ring group, a substituted amino group, a fluorene atom, a cyano group or a crosslinking group selected from Group A of crosslinking group, more preferably an alkyl group, a cycloalkyl group, an alkoxy group, a cycloalkoxy group, an aryl group, a monovalent hetero ring group or a crosslinking group selected from Group A of crosslinking group, further preferably an alkyl group, a cycloalkyl group, an aryl group or a monovalent hetero ring group, particularly preferably an alkyl group, a cycloalkyl group or an aryl group, and the foregoing groups optionally further have a substituent.

X is preferably a crosslinking group represented by the formula (XL-1) to the formula (XL-4), the formula (XL-7) to the formula (XL-10) or the formula (XL-16) to the formula (XL-19), more preferably a crosslinking group represented by the formula (XL-1), the formula (XL-3), the formula (XL-9), the formula (XL-10) or the formula (XL-16) to the formula (XL-19), further preferably a crosslinking group represented by the formula (XL-1) or the formula (XL-16) to the formula (XL-19), particularly preferably a crosslinking group represented by the formula (XL-1) or the formula (XL-17), since the light emitting device of the present invention is more excellent in external quantum efficiency.

The amount of the constitutional unit represented by the formula (Z) is preferably 0.5 to 80% by mol, more preferably 3 to 65% by mol, further preferably 5 to 50% by mol, with respect to the total amount of constitutional units contained in the second (') organic layer polymer compound, since the second (') organic layer polymer compound is excellent in stability and crosslinkability.

The constitutional unit represented by the formula (Z) may be contained only singly or in combination of two or more kinds thereof, in the second (') organic layer polymer compound.

When the second (') organic layer polymer compound contains two or more kinds of the constitutional units represented by the formula (Z), it is preferable that the crosslinking groups represented by X are mutually different in at least two kinds of the constitutional units represented by the formula (Z). The preferable range of the combination of the mutually different crosslinking groups represented by X is the same as the preferable range of the combination of the mutually different crosslinking groups described above.

### (Constitutional unit represented by the formula (Z'))

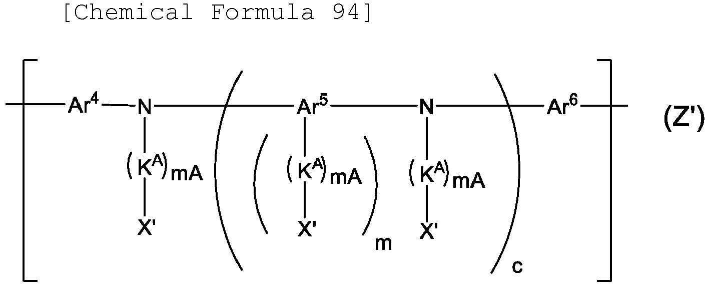

[wherein,
mA represents an integer of 0 to 5, m represents an integer of 1 to 4, and c represents an integer of 0 or 1. When a plurality of mA are present, they may be the same or different.
Ar⁵ represents an aromatic hydrocarbon group, a hetero ring group, or a group in which an aromatic hydrocarbon ring and a hetero ring are bonded directly, and the foregoing groups optionally have a substituent.
Ar⁴ and Ar⁶ each independently represent an arylene group or a divalent hetero ring group, and the foregoing groups optionally have a substituent.
Ar⁴, Ar⁵ and Ar⁶ may be bonded directly or via an oxygen atom or a sulfur atom to groups other than these groups bonded to a nitrogen atom to which these groups are attached, to form a ring, respectively.
K^{A} represents an alkylene group, a cycloalkylene group, an arylene group, a divalent hetero ring group, a group represented by -NR'-, an oxygen atom or a sulfur atom, and the foregoing groups optionally have a substituent. R' represents a hydrogen atom, an alkyl group, a cycloalkyl group, an aryl group or a monovalent hetero ring group, and the foregoing groups optionally have a substituent. When a plurality of K^{A} are present, they may be the same or different.
X' represents a crosslinking group selected from Group A of crosslinking group, a hydrogen atom, an alkyl group, a cycloalkyl group, an aryl group or a monovalent hetero ring group, and the foregoing groups optionally have a substituent. When a plurality of X' are present, they may be the same or different, provided that at least one X' is a crosslinking group selected from Group A of crosslinking group.]

mA is preferably an integer of 0 to 3, more preferably an integer of 0 to 2, further preferably 0 or 1, particularly preferably 0, since the light emitting device of the present invention is more excellent in external quantum efficiency.

m is preferably 1 or 2, more preferably 2, since the light emitting device of the present invention is more excellent in external quantum efficiency.

c is preferably 0, since production of the second (') organic layer polymer compound is easy and since the light emitting device of the present invention is more excellent in external quantum efficiency.

Ar⁵ is preferably an aromatic hydrocarbon group optionally having a substituent, since the light emitting device of the present invention is more excellent in external quantum efficiency.

The definition and examples of the arylene group portion obtained by removing m substituents from the aromatic hydrocarbon group represented by Ar⁵ are the same as the definition and examples of the arylene group represented by Ar^{X2} in the formula (X).

The definition and examples of the divalent hetero ring group portion obtained by removing m substituents from the hetero ring group represented by Ar⁵ are the same as the definition and examples of the divalent hetero ring group portion represented by Ar^{X2} in the formula (X).

The definition and examples of the divalent group obtained by removing m substituents from the group in which an aromatic hydrocarbon ring and a hetero ring are bonded directly the represented by Ar⁵ are the same as the definition and examples of the divalent group in which an arylene group and a divalent hetero ring group are bonded directly represented by Ar^{X2} in the formula (X).

Ar⁴ and Ar⁶ are each preferably an arylene group optionally having a substituent, since the light emitting device of the present invention is more excellent in external quantum efficiency.

The definition and examples of the arylene group represented by Ar⁴ and Ar⁶ are the same as the definition and examples of the arylene group represented by Ar^{X1} and Ar^{X3} in the formula (X).

The definition and examples of the divalent hetero ring group represented by Ar⁴ and Ar⁶ are the same as the definition and examples of the divalent hetero ring group represented by Ar^{X1} and Ar^{X3} in the formula (X).

The examples and preferable range of the substituent which the group represented by Ar⁴ to Ar⁶ optionally has are the same as the examples and preferable range of the substituent which the group represented by Ar^{Y1} optionally has.

The definitions and examples of the alkylene group, the cycloalkylene group, the arylene group and the divalent hetero ring group represented by K^{A} are the same as the definitions and examples of the alkylene group, the cycloalkylene group, the arylene group and the divalent hetero ring group represented by L^{A}, respectively.

K^{A} is preferably a phenylene group or a methylene group, since production of the second (') organic layer polymer compound is easy.

The definition and examples of the crosslinking group represented by X' are the same as the definition and examples of the crosslinking group represented by X.

The amount of the constitutional unit represented by the formula (Z') is preferably 0.5 to 50% by mol, more preferably 3 to 30% by mol, further preferably 5 to 20% by mol, with respect to the total amount of constitutional units contained in the second (') organic layer polymer compound, since the second (') organic layer polymer compound is excellent in stability and since the second (') organic layer polymer compound is excellent in crosslinkability.

The constitutional unit represented by the formula (Z') may be contained only singly or in combination of two or more kinds thereof in the second organic layer polymer compound.

When the second (') organic layer polymer compound contains two or more kinds of constitutional units represented by the formula (Z'), it is preferable that the crosslinking groups represented by X' are mutually different in at least two kinds of the constitutional units represented by the formula (Z'). The preferable range of the combination of the mutually different crosslinking groups represented by X' is the same as the preferable range of the combination of the mutually different crosslinking groups described above.

### (Preferable embodiment of constitutional unit represented by the formula (Z) or (Z'))

The constitutional unit represented by the formula (Z) includes, for example, constitutional units represented by the formula (Z-1) to the formula (Z-30), and the constitutional unit represented by the formula (Z') includes, for example, constitutional units represented by the formula (Z'-1) to the formula (Z'-9). Of them, preferable are constitutional units represented by the formula (Z-1) to the formula (Z-30), more preferable are constitutional units represented by the formula (Z-1) to the formula (Z-15), the formula (Z-19), the formula (Z-20), the formula (Z-23), the formula (Z-25) or the formula (Z-30), further preferable are constitutional units represented by the formula (Z-1) to the formula (Z-9) or the formula (Z-30), since the second (') organic layer polymer compound is excellent in crosslinkability.

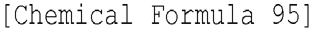

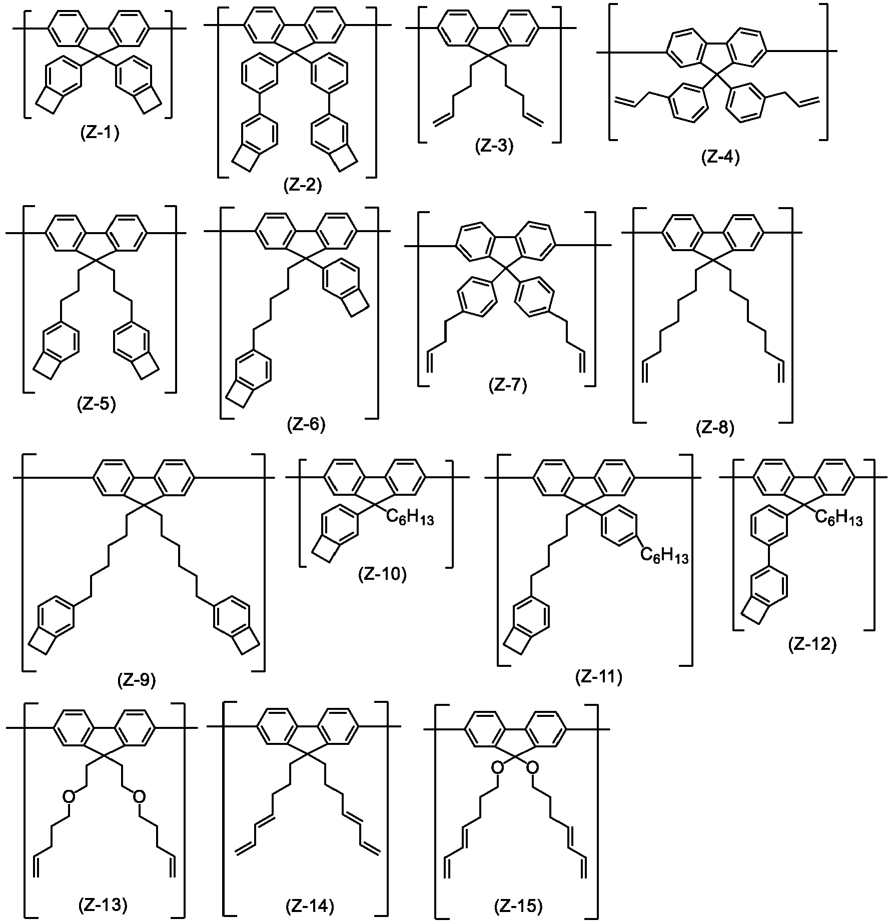

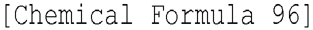

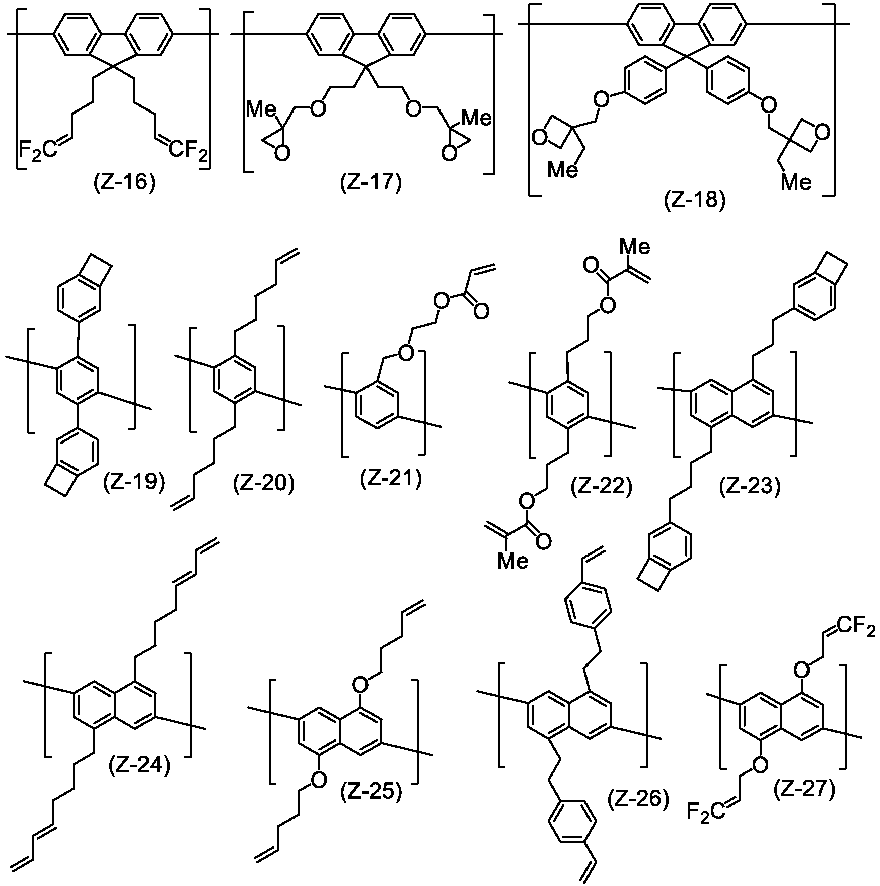

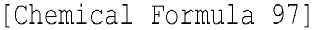

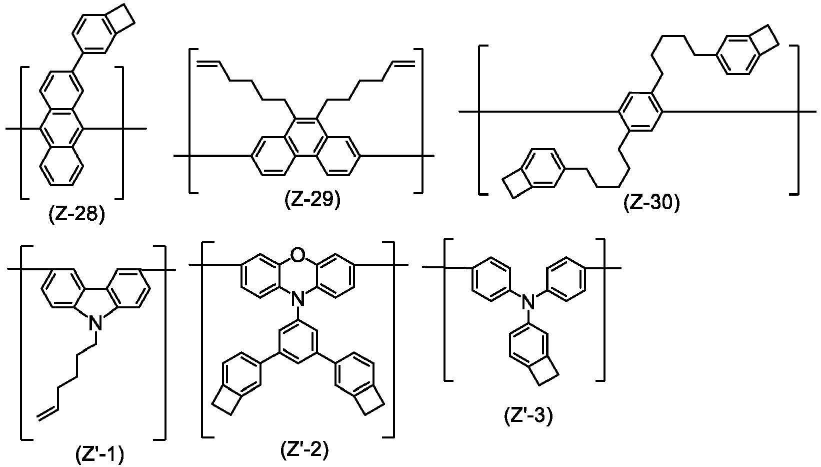

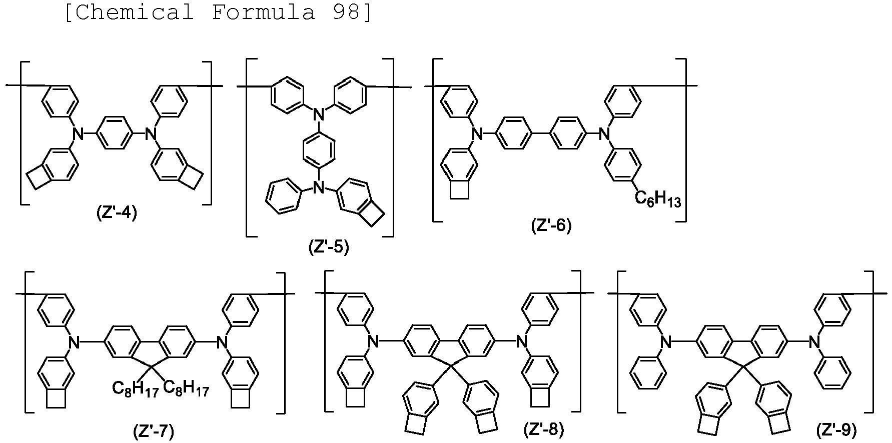

It is preferable that the second organic layer polymer compound further contains a constitutional unit represented by the formula (X), since hole transportability is excellent.

The definition, examples and preferable range of the constitutional unit represented by the formula (X) which the second organic layer polymer compound may contain are the same as the definition, examples and preferable range of the constitutional unit represented by the formula (X) which the polymer host may contain described above.

When the second organic layer polymer compound contains a constitutional unit represented by the formula (X), the amount of the constitutional unit represented by the formula (X) contained in the second organic layer polymer compound is preferably 1 to 90% by mol, more preferably 10 to 70% by mol, further preferably 30 to 50% by mol, with respect to the total amount of constitutional units contained in the second organic layer polymer compound, since hole transportability is more excellent.

The constitutional unit represented by the formula (X) may be contained only singly or in combination of two or more kinds thereof in the second organic layer polymer compound. The constitutional unit represented by the formula (X) may be contained only singly or in combination of two or more kinds thereof in the second (') organic layer polymer compound.

It is preferable that the second organic layer polymer compound further contains a constitutional unit represented by the formula (Y), since the light emitting device of the present invention is excellent in external quantum efficiency.

The definition, examples and preferable range of the constitutional unit represented by the formula (Y) which the second organic layer polymer compound may contain are the same as the definition, examples and preferable range of the constitutional unit represented by the formula (Y) which the polymer host may contain described above.

When the second organic layer polymer compound contains a constitutional unit represented by the formula (Y) and Ar^{Y1} is an arylene group, the amount of the constitutional unit represented by the formula (Y) contained in the second organic layer polymer compound is preferably 0.5 to 90% by mol, more preferably 30 to 80% by mol, with respect to the total amount of constitutional units contained in the second organic layer polymer compound, since the light emitting device of the present invention is more excellent in external quantum efficiency.

When the second organic layer polymer compound contains a constitutional unit represented by the formula (Y) and Ar^{Y1} is a divalent hetero ring group, or a divalent group in which an arylene group and a divalent hetero ring group are bonded directly, the amount of the constitutional unit represented by the formula (Y) contained in the second organic layer polymer compound is preferably 0.5 to 50% by mol, more preferably 3 to 30% by mol, with respect to the total amount of constitutional units contained in the second organic layer polymer compound, since the light emitting device of the present invention is more excellent in charge transportability.

The constitutional unit represented by the formula (Y) may be contained only singly or in combination of two or more kinds thereof in the second organic layer polymer compound. The constitutional unit represented by the formula (Y) may be contained only singly or in combination of two or more kinds thereof in the second (') organic layer polymer compound.

The second organic layer polymer compound includes, for example, polymer compounds P-15 to P-29. In the present specification, "other" constitutional unit denotes a constitutional unit other than the metal complex constitutional unit, the constitutional unit having a crosslinking group, the constitutional unit represented by the formula (X) and the constitutional unit represented by the formula (Y).

**[Table 2]**

| polymer compound | constitutional unit and molar ratio thereof | | | | | |
|---|---|---|---|---|---|---|
| | metal complex constitutional unit | constitutional unit having crosslinking group | | formula (X) | formula (Y) | other |
| | | formula (Z) | formula (Z') | | | |
| | p'" | q'" | r'" | s'" | t'" | u'" |
| P-15 | 0.1 to 99.9 | 0 | 0 | 0.1 to 99.9 | 0 | 0 to 30 |
| P-16 | 0.1 to 99.9 | 0 | 0 | 0 | 0.1 to 99.9 | 0 to 30 |
| P-17 | 0.1 to 99.8 | 0 | 0 | 0.1 to 99.8 | 0.1 to 99.8 | 0 to 30 |
| P-18 | 0.1 to 99.9 | 0.1 to 99.9 | 0 | 0 | 0 | 0 to 30 |
| P-19 | 0.1 to 99.9 | 0 | 0.1 to 99.9 | 0 | 0 | 0 to 30 |
| P-20 | 0.1 to 99.8 | 0.1 to 99.8 | 0.1 to 99.8 | 0 | 0 | 0 to 30 |
| P-21 | 0.1 to 99.8 | 0.1 to 99.8 | 0 | 0.1 to 99.8 | 0 | 0 to 30 |
| P-22 | 0.1 to 99.8 | 0.1 to 99.8 | 0 | 0 | 0.1 to 99.8 | 0 to 30 |
| P-23 | 0.1 to 99.8 | 0 | 0.1 to 99.8 | 0.1 to 99.8 | 0 | 0 to 30 |
| P-24 | 0.1 to 99.8 | 0 | 0.1 to 99.8 | 0 | 0.1 to 99.8 | 0 to 30 |
| P-25 | 0.1 to 99.7 | 0.1 to 99.7 | 0.1 to 99.7 | 0.1 to 99.7 | 0 | 0 to 30 |
| P-26 | 0.1 to 99.7 | 0.1 to 99.7 | 0.1 to 99.7 | 0 | 0.1 to 99.7 | 0 to 30 |
| P-27 | 0.1 to 99.7 | 0.1 to 99.7 | 0 | 0.1 to 99.7 | 0.1 to 99.7 | 0 to 30 |
| P-28 | 0.1 to 99.7 | 0 | 0.1 to 99.7 | 0.1 to 99.7 | 0.1 to 99.7 | 0 to 30 |
| P-29 | 0.1 to 99.6 | 0.1 to 99.6 | 0.1 to 99.6 | 0.1 to 99.6 | 0.1 to 99.6 | 0 to 30 |

[in the table, p"', q"', r"', s"', t"' and u"' represent the molar ratio of each constitutional unit. p"'+q"'+r"'+s"'+t"'+u'" = 100 and 70 ≤ p"'+q"'+r"'+s"'+t'" ≤ 100.]

The second organic layer polymer compound may be any of a block copolymer, a random copolymer, an alternating copolymer and a graft copolymer, and may also be a compound in another form, and a copolymer in which several raw material monomers are copolymerized is preferable.

The polystyrene-equivalent number-average molecular weight of the second organic layer polymer compound is preferably 5×10³ to 1×10⁶, more preferably 1×10⁴ to 5×10⁵, more preferably 1.5×10⁴ to 1×10⁵.

### (Production method of second organic layer polymer compound)

The second organic layer polymer compound can be produced by the same method as the production method of the polymer host described above. It can be produced according methods described in, for example, JP-A No. 2003-171659, International Publication WO 2006/003000, JP-A No. 2010-43243, JP-A No. 2011-105701, International Publication WO 2013/021180, JP-A No. 2015-174931 and JP-A No. 2015-174932, as other production methods than described above.

The second organic layer is preferably a layer containing a metal complex represented by the formula (2) and a second organic layer polymer compound, or a layer containing a second organic layer polymer compound, more preferably a layer containing a second organic layer polymer compound, since the light emitting device of the present invention is more excellent in external quantum efficiency.

When the second organic layer contains a metal complex represented by the formula (2) and a second organic layer polymer compound, the content of the metal complex represented by the formula (2) is usually 0.01 to 99 parts by mass, preferably 0.1 to 50 parts by mass, more preferably 0.5 to 20 parts by mass, further preferably 1 to 10 parts by mass, when the sum of the metal complex represented by the formula (2) and the second organic layer polymer compound is taken as 100 parts by mass.

The second organic layer may be a layer containing a composition containing at least one selected from the group consisting of a metal complex represented by the formula (2) and a second organic layer polymer compound, and a crosslinked body of a compound having a crosslinking group (hereinafter, referred to as "second composition"), and is preferably a layer containing a composition containing a metal complex represented by the formula (2) and a compound having a crosslinking group, since the light emitting device of the present invention is excellent in external quantum efficiency and since the light emitting device of the present invention can be fabricated by a wet method.

The second organic layer polymer compound is different from the compound having a crosslinking group. In the second composition, the crosslinked body of the compound having a crosslinking group may be contained singly or in combination of two or more kinds thereof.

In the second composition, the content of the crosslinked body of the compound having a crosslinking group is usually 1 to 99 parts by mass, preferably 10 to 95 parts by mass, more preferably 30 to 90 parts by mass, further preferably 50 to 85 parts by mass, when the sum of the crosslinked body of the compound having a crosslinking group and the metal complex represented by the formula (2) and the second organic layer polymer compound is taken as 100 parts by mass.

The compound having a crosslinking group includes, for example, low molecular compounds having a crosslinking group and polymer compounds containing a constitutional unit having a crosslinking group, and since the light emitting device of the present invention is more excellent in external quantum efficiency, it is preferably a low molecular compound having at least one crosslinking group selected from Group A of crosslinking group (hereinafter, referred to as "second composition low molecular compound") or a polymer compound containing a constitutional unit having at least one crosslinking group selected from Group A of crosslinking group (hereinafter, referred to as "second composition polymer compound"), and the second composition polymer compound is more preferable.

The second (') organic layer polymer compound is different from the second composition polymer compound (namely, the second composition polymer compound is a polymer compound containing no metal complex constitutional unit).

The examples and preferable range of the crosslinking group in the compound having a crosslinking group are the same as the examples and preferable range of the crosslinking group in the constitutional unit having a crosslinking group.

### [Second composition polymer compound]

The definition, examples and preferable range of the constitutional unit having at least one crosslinking group selected from Group A of crosslinking group in the second composition polymer compound are the same as the definition, examples and preferable range of the constitutional unit having at least one crosslinking group selected from Group A of crosslinking group in the second (') organic layer polymer compound.

The amount of the constitutional unit having at least one crosslinking group selected from Group A of crosslinking group is preferably 0.5 to 80% by mol, more preferably 3 to 65% by mol, further preferably 5 to 50% by mol, with respect to the total amount of constitutional units contained in the second composition polymer compound, since the second composition polymer compound is excellent in stability and crosslinkability.

The constitutional unit having at least one crosslinking group selected from Group A of crosslinking group may be contained only singly or in combination of two or more kinds thereof in the second composition polymer compound.

In the second composition polymer compound, the constitutional unit having at least one crosslinking group selected from Group A of crosslinking group is preferably a constitutional unit represented by the formula (Z) or a constitutional unit represented by the formula (Z'), more preferably a constitutional unit represented by the formula (Z) .

When the second composition polymer compound contains a constitutional unit represented by the formula (Z), the amount of the constitutional unit represented by the formula (Z) is preferably 0.5 to 80% by mol, more preferably 3 to 65% by mol, further preferably 5 to 50% by mol, with respect to the total amount of constitutional units contained in the second composition polymer compound, since the second composition polymer compound is excellent in stability and crosslinkability. The constitutional unit represented by the formula (Z) may be contained only singly or in combination of two or more kinds thereof in the second composition polymer compound.

When the second composition polymer compound contains a constitutional unit represented by the formula (Z'), the amount of the constitutional unit represented by the formula (Z') is preferably 0.5 to 50% by mol, more preferably 3 to 30% by mol, further preferably 5 to 20% by mol, with respect to the total amount of constitutional units contained in the second composition polymer compound, since the second composition polymer compound is excellent in stability and since the second composition polymer compound is excellent in crosslinkability. The constitutional unit represented by the formula (Z') may be contained only singly or in combination of two or more kinds thereof in the second composition polymer compound.

It is preferable that the second composition polymer compound further contains a constitutional unit represented by the formula (X), since hole transportability is excellent. The definition, examples and preferable range of the constitutional unit represented by the formula (X) which the second composition polymer compound may contain are the same as the definition, examples and preferable range of the constitutional unit represented by the formula (X) which the polymer host may contain described above.

When the second composition polymer compound contains a constitutional unit represented by the formula (X), the amount of the constitutional unit represented by the formula (X) contained in the second composition polymer compound is preferably 1 to 90% by mol, more preferably 10 to 70% by mol, further preferably 30 to 50% by mol, with respect to the total amount of constitutional units contained in the second composition polymer compound, since hole transportability is more excellent. The constitutional unit represented by the formula (X) may be contained only singly or in combination of two or more kinds thereof in the second composition polymer compound.

It is preferable that the second composition polymer compound further contains a constitutional unit represented by the formula (Y), since the light emitting device of the present invention is excellent in external quantum efficiency. The definition, examples and preferable range of the constitutional unit represented by the formula (Y) which the second composition polymer compound may contain are the same as the definition, examples and preferable range of the constitutional unit represented by the formula (Y) which the polymer host may contain described above.

When the second composition polymer compound contains a constitutional unit represented by the formula (Y) and Ar^{Y1} is an arylene group, the amount of the constitutional unit represented by the formula (Y) contained in the second composition polymer compound is preferably 0.5 to 90% by mol, more preferably 30 to 80% by mol, with respect to the total amount of constitutional units contained in the second composition polymer compound, since the light emitting device of the present invention is more excellent in external quantum efficiency. When the second composition polymer compound contains a constitutional unit represented by the formula (Y) and Ar^{Y1} is a divalent hetero ring group, or a divalent group in which an arylene group and a divalent hetero ring group are bonded directly, the amount of the constitutional unit represented by the formula (Y) contained in the second composition polymer compound is preferably 0.5 to 50% by mol, more preferably 3 to 30% by mol, with respect to the total amount of constitutional units contained in the second composition polymer compound, since the light emitting device of the present invention is more excellent in charge transportability.

The constitutional unit represented by the formula (Y) may be contained only singly or in combination of two or more kinds thereof in the second composition polymer compound.

The second composition polymer compound includes, for example, polymer compounds P-7 to P-14. In the present specification, "other" constitutional unit denotes a constitutional unit other than the constitutional unit having a crosslinking group, the constitutional unit represented by the formula (X) and the constitutional unit represented by the formula (Y).

**[Table 3]**

| polymer compound | constitutional unit and molar ratio thereof | | | | |
|---|---|---|---|---|---|
| | constitutional unit having crosslinking group | | formula (X) | formula (Y) | |
| | formula (Z) | formula (Z') | | | other |
| | p' | q' | r' | s' | t' |
| P-7 | 0.1 to 99.9 | 0.1 to 99.9 | 0 | 0 | 0 to 30 |
| P-8 | 0.1 to 99.9 | 0 | 0.1 to 99.9 | 0 | 0 to 30 |
| P-9 | 0.1 to 99.9 | 0 | 0 | 0.1 to 99.9 | 0 to 30 |
| P-10 | 0 | 0.1 to 99.9 | 0.1 to 99.9 | 0 | 0 to 30 |
| P-11 | 0 | 0.1 to 99.9 | 0 | 0.1 to 99.9 | 0 to 30 |
| P-12 | 0.1 to 99.8 | 0.1 to 99.8 | 0.1 to 99.8 | 0 | 0 to 30 |
| P-13 | 0.1 to 99.8 | 0.1 to 99.8 | 0 | 0.1 to 99.8 | 0 to 30 |
| P-14 | 0.1 to 99.7 | 0.1 to 99.7 | 0.1 to 99.7 | 0.1 to 99.7 | 0 to 30 |

[in the table, p', q', r', s' and t' represent the molar ratio of each constitutional unit. p'+q'+r'+s'+t' = 100 and 70 ≤ p'+q'+r'+s' ≤ 100.]

The second composition polymer compound may be any of a block copolymer, a random copolymer, an alternating copolymer and a graft copolymer, and may also be a compound in another form, and a copolymer in which several raw material monomers are copolymerized is preferable.

The polystyrene-equivalent number-average molecular weight of the second composition polymer compound is preferably 5×10³ to 1×10⁶, more preferably 1×10⁴ to 5×10⁵, further preferably 1.5×10⁴ to 1×10⁵.

### (Production method of second composition polymer compound)

The second composition polymer compound can be produced by the same method as the production method of the polymer host described above.

### [Second composition low molecular compound]

The second composition low molecular compound is preferably a low molecular compound represented by the formula (3). 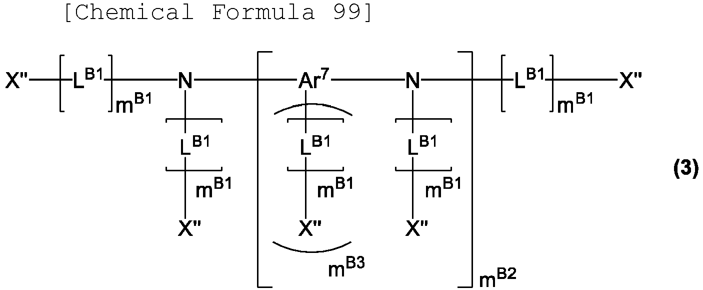 [wherein,
m^{B1}, m^{B2} and m^{B3} each independently represent an integer of 0 or more. A plurality of m^{B1} may be the same or different. When a plurality of m^{B3} are present, they may be the same or different.
Ar⁷ represents an aromatic hydrocarbon group, a hetero ring group, or a group in which an aromatic hydrocarbon ring and a hetero ring are bonded directly, and the foregoing groups optionally have a substituent. When a plurality of Ar⁷ are present, they may be the same or different.
L^{B1} represents an alkylene group, a cycloalkylene group, an arylene group, a divalent hetero ring group, a group represented by -N(R"')-, an oxygen atom or a sulfur atom, and the foregoing groups optionally have a substituent. R"' represents a hydrogen atom, an alkyl group, a cycloalkyl group, an aryl group or a monovalent hetero ring group, and the foregoing groups optionally have a substituent. When a plurality of L^{B1} are present, they may be the same or different.
X" represents a crosslinking group, a hydrogen atom, an alkyl group, a cycloalkyl group, an aryl group or a monovalent hetero ring group, and the foregoing groups optionally have a substituent. A plurality of X" may be the same or different, provided that at least one of the plurality of X" is a crosslinking group.]

m^{B1} is usually an integer of 0 to 10, and since synthesis of the second composition low molecular compound is easy, it is preferably an integer of 0 to 5, more preferably an integer of 0 to 2, further preferably 0 or 1, particularly preferably 0.

m^{B2} is usually an integer of 0 to 10, and since synthesis of the second composition low molecular compound is easy and since the light emitting device of the present invention is more excellent in external quantum efficiency, it is preferably an integer of 0 to 5, more preferably an integer of 0 to 3, further preferably 1 or 2, particularly preferably 1.

m^{B3} is usually an integer of 0 to 5, and since synthesis of the second composition low molecular compound is easy, it is preferably an integer of 0 to 4, more preferably an integer of 0 to 2, further preferably 0.

The definition and examples of the arylene group portion obtained by removing m^{B3} substituents from the aromatic hydrocarbon group represented by Ar⁷ are the same as the definition and examples of the arylene group represented by Ar^{X2} in the formula (X).

The definition and examples of the divalent hetero ring group portion obtained by removing m^{B3} substituents from the hetero ring group represented by Ar⁷ are the same as the definition and examples of the divalent hetero ring group portion represented by Ar^{X2} in the formula (X).

The definition and examples of the divalent group obtained by removing m^{B3} substituents from the group in which an aromatic hydrocarbon ring and a hetero ring are bonded directly represented by Ar⁷ are the same as the definition and examples of the divalent group in which an arylene group and a divalent hetero ring group are bonded directly represented by Ar^{X2} in the formula (X).

The definition and examples of the substituent which a group represented by Ar⁷ optionally has are the same as the definition and examples of the substituent which a group represented by Ar^{X2} optionally has in the formula (X).

Ar⁷ is preferably an aromatic hydrocarbon group, and this aromatic hydrocarbon group optionally has a substituent, since the light emitting device of the present invention is more excellent in external quantum efficiency.

The definitions and examples of the alkylene group, the cycloalkylene group, the arylene group and the divalent hetero ring group represented by L^{B1} are the same as the definitions and examples of the alkylene group, the cycloalkylene group, the arylene group and the divalent hetero ring group represented by L^{A}, respectively.

L^{B1} is preferably an alkylene group, an arylene group or an oxygen atom, more preferably an alkylene group or an arylene group, further preferably a phenylene group, a fluorenediyl group or an alkylene group, particularly preferably a phenylene group or an alkylene group, and the foregoing groups optionally have a substituent, since synthesis of the second composition low molecular compound is easy.

X" is preferably a crosslinking group represented by any one of the formula (XL-1) to the formula (XL-19), an aryl group or a monovalent hetero ring group, more preferably a crosslinking group represented by the formula (XL-1), the formula (XL-3), the formula (XL-7) to the formula (XL-10) or the formula (XL-16) to the formula (XL-19) or an aryl group, further preferably a crosslinking group represented by the formula (XL-1) or the formula (XL-16) to the formula (XL-19), a phenyl group, a naphthyl group or a fluorenyl group, particularly preferably a crosslinking group represented by the formula (XL-16) or the formula (XL-17), a phenyl group or a naphthyl group, especially preferably a crosslinking group represented by the formula (XL-16) or a naphthyl group, and the foregoing groups optionally have a substituent.

The second composition low molecular compound includes, for example, low molecular compounds represented by the formula (3-1) to the formula (3-16), and it is preferably a low molecular compound represented by the formula (3-1) to the formula (3-10), more preferably a low molecular compound represented by the formula (3-5) to the formula (3-9) .

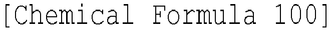

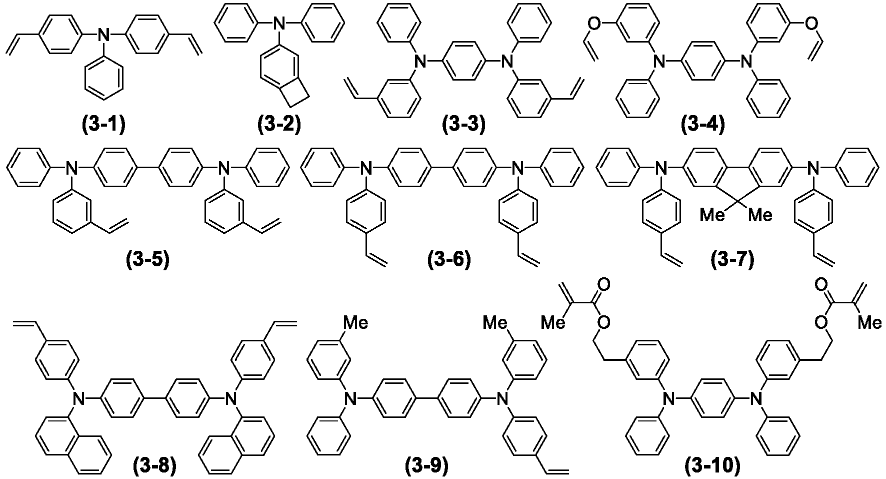

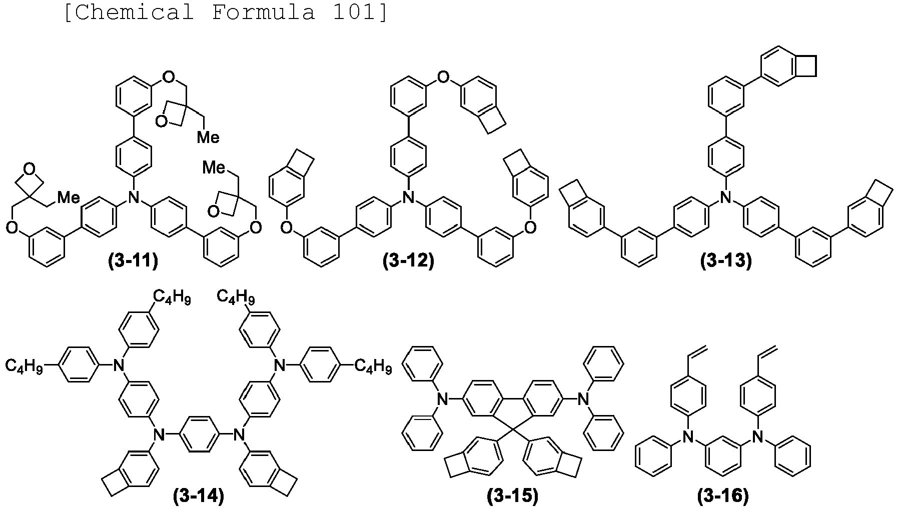

The second composition low molecular compound is available from Aldrich, Luminescence Technology Corp., American Dye Source and the like. Additionally, it can be synthesized according to methods described in, for example, International Publication WO 1997/033193, International Publication WO 2005/035221 and International Publication WO 2005/049548.

### (Third composition)

The second organic layer may be a layer containing a composition containing at least one selected from the group consisting of a metal complex represented by the formula (2) and a second organic layer polymer compound, and at least one selected from the group consisting of a crosslinked body of a compound having a crosslinking group, a hole transporting material, a hole injection material, an electron transporting material, an electron injection material, a light emitting material (differing from the metal complex represented by the formula (2) and the second organic layer polymer compound) and an antioxidant (hereinafter, referred to also as "third composition"). The crosslinked body of the compound having a crosslinking group is different from the hole transporting material, the hole injection material, the electron transporting material, the electron injection material and the light emitting material.

The examples and preferable ranges of the hole transporting material, the electron transporting material, the hole injection material, the electron injection material and the light emitting material contained in the third composition are the same as the examples and preferable ranges of the hole transporting material, the electron transporting material, the hole injection material, the electron injection material and the light emitting material contained in the first composition.

In third composition, the contents of the hole transporting material, the electron transporting material, the hole injection material, the electron injection material and the light emitting material are each usually 1 to 1000 parts by mass, preferably 5 to 500 parts by mass, when the sum of the metal complex represented by the formula (2) and the second organic layer polymer compound is taken as 100 parts by mass.

The examples and preferable range of the antioxidant contained in the third composition are the same as the examples and preferable range of the antioxidant contained in the first composition. In the third composition, the content of the antioxidant is usually 0.001 to 10 parts by mass, when the sum of the metal complex represented by the formula (2) and the second organic layer polymer compound is taken as 100 parts by mass.

### (Second ink)

The second organic layer can be formed by using, for example, a composition containing a metal complex represented by the formula (2) and a second organic layer polymer compound, and a solvent (hereinafter, referred to as "second ink"). The second ink can be suitably used for the wet method described in the column of the first ink. The preferable range of the viscosity of the second ink is the same as the preferable range of the viscosity of the first ink. The examples and preferable range of the solvent contained in the second ink are the same as the examples and preferable range of the solvent contained in the first ink.

In the second ink, the content of the solvent is usually 1000 to 100000 parts by mass, preferably 2000 to 20000 parts by mass, when the amount of the second organic layer polymer compound is taken as 100 parts by mass.

### <Layer constitution of light emitting device>

The light emitting device of the present invention may have a layer other than the anode, the cathode, the first organic layer and the second organic layer.

In the light emitting device of the present invention, it is preferable that the first organic layer and the second organic layer are adjacent, since the light emitting device of the present invention is more excellent in external quantum efficiency.

In the light emitting device of the present invention, the second organic layer is preferably a layer disposed between the anode and the first organic layer, since the light emitting device of the present invention is more excellent in external quantum efficiency.

In the light emitting device of the present invention, the first organic layer is preferably a light emitting layer (hereinafter, referred to as "first light emitting layer").

In the light emitting device of the present invention, the second organic layer is usually a hole transporting layer, a light emitting layer (namely, a light emitting layer different from the first light emitting layer, and hereinafter, referred to as "second light emitting layer") or an electron transporting layer, preferably a hole transporting layer or a second light emitting layer, more preferably a second light emitting layer.

When the light emitting device of the present invention has a first light emitting layer and a second light emitting layer, the emission color of the light emitting device can be adjusted and it is also possible to adjust the emission color to white by controlling the emission color of the first light emitting layer and the emission color of the second light emitting layer.

For example, when the first light emitting layer is a first organic layer and the second light emitting layer is a second organic layer, the emission color can be adjusted and it is also possible to adjust the emission color to white by controlling the content of the metal complex represented by the formula (1) in the first organic layer and the content of the metal complex represented by the formula (2) or the second organic layer polymer compound in the second organic layer.

The emission color of a light emitting device can be confirmed by determining the chromaticity coordinate (CIE chromaticity coordinate) by measuring the emission chromaticity of the light emitting device. For white emission color, for example, X of chromaticity coordinate is in a range of 0.20 to 0.5 and Y of chromaticity coordinate is in a range of 0.20 to 0.55, and it is preferable that X of chromaticity coordinate is in a range of 0.30 to 0.50 and Y of chromaticity coordinate is in a range of 0.30 to 0.50.

From the standpoint of adjusting the emission color of the light emitting device of the present invention (particularly, meaning the standpoint of adjusting the emission color to white, hereinafter, referred to simply as "the same standpoint"), the maximum peak wavelength of the emission spectrum of the metal complex represented by the formula (1) is preferably 380 nm or more and less than 495 nm, more preferably 400 nm or more and less than 495 nm, further preferably 420 nm or more and 490 nm or less, particularly preferably 440 nm or more and 490 nm or less.

From the same standpoint, it is preferable that the first organic layer is a layer containing a metal complex represented by the formula (1) and a light emitting material. In this case, the maximum peak wavelength of the emission spectrum of the light emitting material is preferably 495 nm or more and less than 750 nm, more preferably 500 nm or more and 570 nm or less, further preferably 505 nm or more and 550 nm or less.

From the same standpoint, it is preferable that the second organic layer is a layer containing a metal complex represented by the formula (2). In this case, the maximum peak wavelength of the emission spectrum of the metal complex represented by the formula (2) is preferably 495 nm or more and less than 750 nm, more preferably 550 nm or more and 680 nm or less, further preferably 570 nm or more and 640 nm or less.

From the same standpoint, it is preferable that the second organic layer is a layer containing the second organic layer polymer compound. In this case, the maximum peak wavelength of the emission spectrum of a metal complex corresponding to the residual group of a metal complex represented by the formula (2) is preferably 495 nm or more and less than 750 nm, more preferably 550 nm or more and 680 nm or less, further preferably 570 nm or more and 640 nm or less.

The maximum peak wavelength and the maximum wavelength of the emission spectrum of a compound can be evaluated by dissolving the compound in an organic solvent such as xylene, toluene, chloroform, tetrahydrofuran and the like to prepare a dilute solution (1×10⁻⁶ to 1×10⁻³% by mass) and measuring the PL spectrum of the dilute solution at room temperature. The organic solvent for dissolving the compound is preferably toluene or xylene.

When the second organic layer is a second light emitting layer disposed between an anode and a first organic layer, in the light emitting device of the present invention, it is preferable that at least one layer out of a hole injection layer and a hole transporting layer is further present between an anode and a second organic layer, since the light emitting device of the present invention is more excellent in external quantum efficiency. When the second organic layer is a second light emitting layer disposed between an anode and a first organic layer, it is preferable that at least one layer out of an electron injection layer and an electron transporting layer is further present between a cathode and a first organic layer, since the light emitting device of the present invention is more excellent in external quantum efficiency.

When the second organic layer is a second light emitting layer disposed between a cathode and a first organic layer, in the light emitting device of the present invention, it is preferable that at least one layer out of a hole injection layer and a hole transporting layer is further present between an anode and a first organic layer, since the light emitting device of the present invention is more excellent in external quantum efficiency. When the second organic layer is a second light emitting layer disposed between a cathode and a first organic layer, it is preferable that at least one layer out of an electron injection layer and an electron transporting layer is further present between a cathode and a second organic layer, since the light emitting device of the present invention is more excellent in external quantum efficiency.

When the second organic layer is a hole transporting layer disposed between an anode and a first organic layer, in the light emitting device of the present invention, it is preferable that a hole injection layer is further present between an anode and a second organic layer, since the light emitting device of the present invention is more excellent in external quantum efficiency. When the second organic layer is a hole transporting layer disposed between an anode and a first organic layer, it is preferable that at least one layer out of an electron injection layer and an electron transporting layer is further present between a cathode and a first organic layer, since the light emitting device of the present invention is more excellent in external quantum efficiency.

When the second organic layer is an electron transporting layer disposed between a cathode and a first organic layer, in the light emitting device of the present invention, it is preferable that at least one layer out of a hole injection layer and a hole transporting layer is further present between an anode and a first organic layer, since the light emitting device of the present invention is more excellent in external quantum efficiency. When the second organic layer is an electron transporting layer disposed between a cathode and a first organic layer, it is preferable that an electron injection layer is further present between a cathode and a second organic layer, since the light emitting device of the present invention is more excellent in external quantum efficiency.

The specific layer constitution of the light emitting device of the present invention includes, for example, layer constitutions represented by the following (D1) to (D15). The light emitting device of the present invention usually has a substrate, and an anode may be first laminated on the substrate, or a cathode may be first laminated on the substrate.

(D1) anode/second light emitting layer (second organic layer)/first light emitting layer (first organic layer)/cathode
(D2) anode/hole transporting layer (second organic layer)/first light emitting layer (first organic layer)/cathode
(D3) anode/hole injection layer/second light emitting layer (second organic layer)/first light emitting layer (first organic layer)/cathode
(D4) anode/hole injection layer/second light emitting layer (second organic layer)/first light emitting layer (first organic layer)/electron transporting layer/cathode
(D5) anode/hole injection layer/second light emitting layer (second organic layer)/first light emitting layer (first organic layer)/electron injection layer/cathode
(D6) anode/hole injection layer/second light emitting layer (second organic layer)/first light emitting layer (first organic layer)/electron transporting layer/electron injection layer/cathode
(D7) anode/hole injection layer/hole transporting layer (second organic layer)/first light emitting layer (first organic layer)/cathode
(D8) anode/hole injection layer/hole transporting layer (second organic layer)/first light emitting layer (first organic layer)/electron transporting layer/cathode
(D9) anode/hole injection layer/hole transporting layer (second organic layer)/first light emitting layer (first organic layer)/electron injection layer/cathode
(D10) anode/hole injection layer/hole transporting layer (second organic layer)/first light emitting layer (first organic layer)/electron transporting layer/electron injection layer/cathode
(D11) anode/hole injection layer/hole transporting layer/second light emitting layer (second organic layer)/first light emitting layer (first organic layer)/electron transporting layer/electron injection layer/cathode
(D12) anode/hole injection layer/hole transporting layer (second organic layer)/first light emitting layer (first organic layer)/second light emitting layer/electron transporting layer/electron injection layer/cathode
(D13) anode/hole injection layer/hole transporting layer/first light emitting layer (first organic layer)/second light emitting layer (second organic layer)/electron transporting layer/electron injection layer/cathode
(D14) anode/hole injection layer/hole transporting layer/first light emitting layer (first organic layer)/electron transporting layer (second organic layer)/electron injection layer/cathode
(D15) anode/hole injection layer/hole transporting layer (second organic layer)/second light emitting layer/first light emitting layer (first organic layer)/electron transporting layer/electron injection layer/cathode

In the above-described (D1) to (D15), "/" means that layers before and behind that are laminated adjacently. For example, "second light emitting layer (second organic layer)/first light emitting layer (first organic layer)" means that a second light emitting layer (second organic layer) and a first light emitting layer (first organic layer) are laminated adjacently.

Layer constitutions represented by (D3) to (D12) are preferable, layer constitutions represented by (D3) to (D10) are more preferable, layer constitutions represented by (D3) to (D6) are further preferable, since the light emitting device of the present invention is more excellent in external quantum efficiency.

In the light emitting device of the present invention, if necessary, two or more layers of the anode, the hole injection layer, the hole transporting layer, the second light emitting layer, the electron transporting layer, the electron injection layer and the cathode may be provided, respectively.

When a plurality of the anodes, the hole injection layers, the hole transporting layers, the second light emitting layers, the electron transporting layers, the electron injection layers and the cathodes are present, the materials constituting them each may be the same or different.

The thicknesses of the anode, the hole injection layer, the hole transporting layer, the first organic layer, the second organic layer, the second light emitting layer, the electron transporting layer, the electron injection layer and the cathode are each usually 1 nm to 1 µm, preferably 2 nm to 500 nm, further preferably 5 nm to 150 nm.

In the light emitting device of the present invention, the order, number and thickness of layers to be laminated may be adjusted in view of the light emission efficiency and device life of the light emitting device.

### [Second light emitting layer]

The second light emitting layer is a second organic layer or a layer containing a light emitting material. When the second light emitting layer is a layer containing a light emitting material, the light emitting material contained in the second light emitting layer includes, for example, light emitting materials which may be contained in the above-described first composition. The light emitting material contained in the second light emitting layer may be contained singly or in combination of two or more kinds thereof.

When the light emitting device of the present invention has a second light emitting layer and if the hole transporting layer described later and the electron transporting layer described later are each not a second organic layer, it is preferable that the second light emitting layer is a second organic layer.

### [Hole transporting layer]

The hole transporting layer is a second organic layer or a layer containing a hole transporting material. When the hole transporting layer is a layer containing a hole transporting material, the hole transporting material includes, for example, hole transporting materials which may be contained in the first composition described above. The hole transporting material contained in the hole transporting layer may be contained singly or in combination of two or more kinds thereof.

When the light emitting device of the present invention has a hole transporting layer and if the above-described second light emitting layer and the electron transporting layer described later are each not a second organic layer, it is preferable that the hole transporting layer is a second organic layer.

### [Electron transporting layer]

The electron transporting layer is a second organic layer or a layer containing an electron transporting material, preferably a layer containing an electron transporting material. When the electron transporting layer is a layer containing an electron transporting material, the electron transporting material contained in the electron transporting layer includes, for example, electron transporting materials which may be contained in the first composition described above. The electron transporting material contained in the electron transporting layer may be contained singly or in combination of two or more kinds thereof.

When the light emitting device of the present invention has an electron transporting layer and if the above-described second light emitting layer and the above-described hole transporting layer are each not a second organic layer, it is preferable that the electron transporting layer is a second organic layer.

### [Hole injection layer and electron injection layer]

The hole injection layer is a layer containing a hole injection material. The hole injection material contained in the hole injection layer includes, for example, hole injection materials which may be contained in the first composition described above. The hole injection material contained in the hole injection layer may be contained singly or in combination of two or more kinds thereof.

The electron injection layer is a layer containing an electron injection material. The electron injection material contained in the electron injection layer includes, for example, electron injection materials which may be contained in the first composition described above. The electron injection material contained in the electron injection layer may be contained singly or in combination of two or more kinds thereof.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; argentine-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

In the light emitting device of the present invention, at least one of the anode and the cathode is usually transparent or semi-transparent, and it is preferable that the anode is transparent or semi-transparent.

The method for forming the anode and the cathode includes, for example, a vacuum vapor deposition method, a sputtering method, an ion plating method, a plating method and a lamination method.

### [Production method of light emitting device]

The method for forming a first organic layer, a second organic layer and other layers in the light emitting device of the present invention includes, for example, a vacuum vapor deposition method from a powder and a method by film formation from a solution or melted state when a low molecular compound is used, and, for example, a method by film formation from a solution or melted state when a polymer compound is used.

The first organic layer, the second organic layer and other layers can be formed by wet methods such as a spin coat method, an inkjet printing method and the like using the above-described various inks and inks containing various materials. The first organic layer and the second organic layer may also be formed by dry methods such as a vacuum vapor deposition method and the like.

When the first organic layer is formed by a wet method, it is preferable to use the first ink.

When the second organic layer is formed by a wet method, it is preferable to use a second ink. For example, when the second ink contains a second (') organic layer polymer compound or a compound having a crosslinking group, the second (') organic layer polymer compound or the compound having a crosslinking group contained in the second organic layer can be crosslinked by forming the second organic layer, then, performing heating or light irradiation. When the second (') organic layer polymer compound is contained in cross-linked state (crosslinked body of the second (') organic layer polymer compound) or the compound having a crosslinking group is contained in cross-linked state (crosslinked body of the compound having a crosslinking group) in the second organic layer, the second organic layer is substantially insolubilized in a solvent. Thus, the second organic layer can be suitably used for lamination of a light emitting device.

When the second organic layer is Layer C' and Layer C' is formed by a wet method, it is preferable to use an ink of Layer C'. When the second organic layer is formed by a wet method using the ink of Layer C', it is possible to crosslink the compound having a crosslinking group contained in the second organic layer by performing heating or light irradiation (preferably, heating) after formation of the layer. When the compound having a crosslinking group is contained in crosslinked state (in the form of a crosslinked body of the compound having a crosslinking group) in the second organic layer, the second organic layer is substantially insolubilized in a solvent. Hence, the second organic layer can be suitably used for lamination of a light emitting device.

The temperature of heating for causing crosslinking is usually 25°C to 300°C, preferably 50°C to 260°C, more preferably 130°C to 230°C, further preferably 180°C to 210°C.

The time of heating is usually 0.1 minute to 1000 minutes, preferably 0.5 minutes to 500 minutes, more preferably 1 minute to 120 minutes, further preferably 10 minutes to 60 minutes.

The kind of the light used for irradiation includes, for example, ultraviolet, near-ultraviolet and visible light.

The method for analyzing components contained in the first organic layer and the second organic layer includes, for example, chemical separation and analysis methods such as extraction and the like, instrumental analysis methods such as infrared spectroscopy (IR), nuclear magnetic resonance spectroscopy (NMR), mass spectrometry (MS) and the like, and analysis methods combining chemical separation and analysis methods with instrumental analysis methods.

By performing solid-liquid extraction on the first organic layer and the second organic layer using an organic solvent such as toluene, xylene, chloroform, tetrahydrofuran and the like, the components can be separated into components substantially insoluble in an organic solvent (insoluble component) and components soluble in an organic solvent (soluble component). The insoluble component can be analyzed by infrared spectroscopy or nuclear magnetic resonance spectroscopy and the soluble component can be analyzed by nuclear magnetic resonance spectroscopy or mass spectrometry.

### [Application of light emitting device]

In order to obtain planar light emission using a light emitting device, the planar anode and the planar cathode may be arranged so as to overlap each other. In order to obtain patterned light emission, there are a method of installing a mask having a patterned window on the surface of a planar light emitting device, a method in which a layer to be formed as a non-light emitting part is formed extremely thick so as to cause substantially non light emission and a method of forming an anode or a cathode, or both electrodes in a pattern. A segment type display capable of displaying numerals, letters and the like can be obtained by forming a pattern by any one of these methods and disposing several electrodes so that several electrodes can be turned on and off independently. In order to obtain a dot matrix display, both the anode and the cathode may be formed in a stripe shape and arranged so as to be orthogonal to each other. Partial color display and multicolor display become possible by a method of separately coating plural kinds of polymer compounds having different emission colors or a method using a color filter or a fluorescence conversion filter. The dot matrix display can be driven passively or can be driven actively in combination with a TFT and the like. These displays can be used for displays of computers, televisions, portable terminals, and the like. The planar light emitting device can be suitably used as a planar light source for backlight of a liquid crystal display, or as a planar light source for illumination. If a flexible substrate is used, it can be used as a curved light source and a curved display.

### EXAMPLES

The present invention will be illustrated further in detail by examples below, but the present invention is not limited to these examples.

In examples, the polystyrene-equivalent number-average molecular weight (Mn) and the polystyrene-equivalent weight-average molecular weight (Mw) of a polymer compound were determined by size exclusion chromatography (SEC) described below using tetrahydrofuran as a mobile phase.

A polymer compound to be measured was dissolved at a concentration of about 0.05% by mass in tetrahydrofuran, and 10 µL of the solution was injected into SEC. The mobile phase was run at a flow rate of 1.0 mL/min. As the column, PLgel MIXED-B (manufactured by Polymer Laboratories) was used. As the detector, UV-VIS detector (manufactured by Tosoh Corp., trade name: UV-8320GPC) was used.

LC-MS was measured by the following method.

A measurement sample was dissolved in chloroform or tetrahydrofucan so as to give a concentration of about 2 mg/mL, and about 1 µL of the solution was injected into LC-MS (manufactured by Agilent, trade name: 1290 Infinity LC and 6230 TOF LC/MS). As the mobile phase for LC-MS, acetonitrile and tetrahydrofuran were used while changing the ratio of them and run at a flow rate of 1.0 mL/min. As the column, SUMIPAX ODS Z-CLUE (manufactured by Sumika Chemical Analysis Service, Ltd., internal diameter: 4.6 mm, length: 250 mm, particle diameter: 3 µm) was used.

TLC-MS was measured by the following method.

A measurement sample was dissolved in any of toluene, tetrahydrofuran or chloroform solvent at any concentration, and the solution was applied on a TLC plate for DART (manufactured by Techno Applications, trade name: YSK5-100), and TLC-MS was measured using a TLC-MS apparatus (manufactured by JEOL Ltd., trade name:JMS-T100TD (The AccuTOF TLC)). The temperature of a helium gas in measurement was regulated in a range of 200 to 400°C.

NMR was measured by the following method.

Five to ten milligrams of a measurement sample was dissolved in about 0.5 mL of deuterated chloroform (CDCl₃), deuterated tetrahydrofuran, deuterated dimethyl sulfoxide, deuterated acetone, deuterated N,N-dimethylformamide, deuterated toluene, deuterated methanol, deuterated ethanol, deuterated 2-propanol or deuterated methylene chloride, and NMR was measured using an NMR apparatus (manufactured by JEOL RESONANCE, trade name: JNM-ECZ400S/L1, or Bruker Corporation, trade name: AVANCE600).

As an indicator of the purity of the compound, the value of high performance liquid chromatography (HPLC) area percentage was used. This value is a value by HPLC (manufactured by Shimadzu Corp., trade name: LC-20A) at UV = 254 nm unless otherwise stated. In this procedure, the compound to be measured was dissolved in tetrahydrofuran or chloroform so as to give a concentration of 0.01 to 0.2% by mass, and the solution was injected into HPLC in an amount of 1 to 10 µL depending on the concentration. As the mobile phase of HPLC, acetonitrile and tetrahydrofuran were used at a ratio of acetonitrile/tetrahydrofuran changing from 100/0 to 0/100 (volume ratio), and the solution was run at a flow rate of 1.0 mL/min. As the column, SUMIPAX ODSZ-CLUE (manufactured by Sumika Chemical Analysis Service, Ltd., internal diameter: 4.6 mm, length: 250 mm, particle diameter: 3 µm) or an ODS column having the equivalent performance was used. As the detector, a photo diode array detector (manufactured by Shimadzu Corp., trade name: SPD-M20A) was used.

In the present example, the maximum peak wavelength of the emission spectrum of the metal complex was measured by spectrophotometer (manufactured by JASCO Corporation, FP-6500) at room temperature. The compound was dissolved in xylene at a concentration of about 0.8×10⁻⁴% by mass to prepared a xylene solution which was then used as a sample. As the excitation light, UV light having a wavelength of 325 nm was used.

### <Synthesis Example M1> Synthesis of compounds M1 to M5 and CM1 to CM5

Compounds M1, M2 and M3 were synthesized according to a method described in International Publication WO 2013/146806.

A compound M4 was synthesized according to a method described in International Publication WO 2015/145871.

A compound M5 was synthesized according to a method described in International Publication WO 2005/049546.

A compound CM1 was synthesized according to a method described in JP-A No. 2010-189630.

A compound CM2 was synthesized according to a method described in JP-A No. 2008-106241.

A compound CM3 was synthesized according to a method described in JP-A No. 2010-215886.

A compound CM4 was synthesized with reference to a method described in International Publication WO 2002/045184.

A compound CM5 was synthesized according to a method described in International Publication WO 2011/049241.

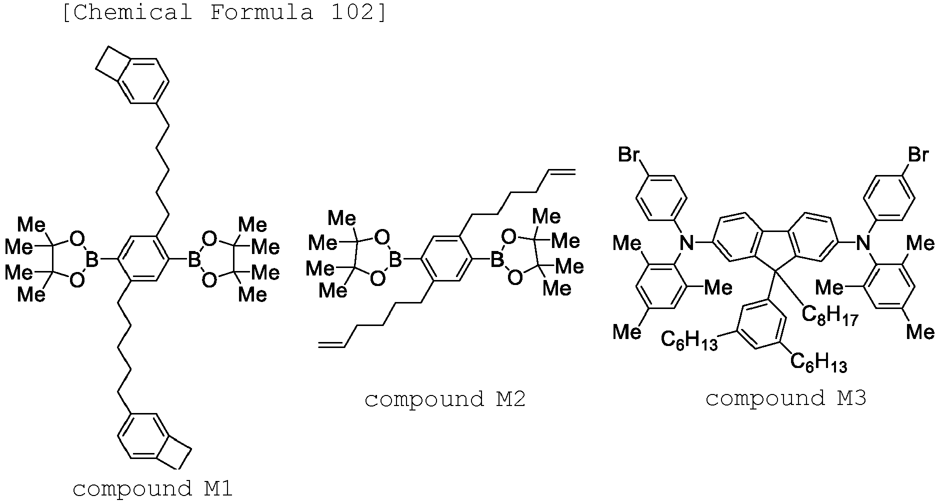

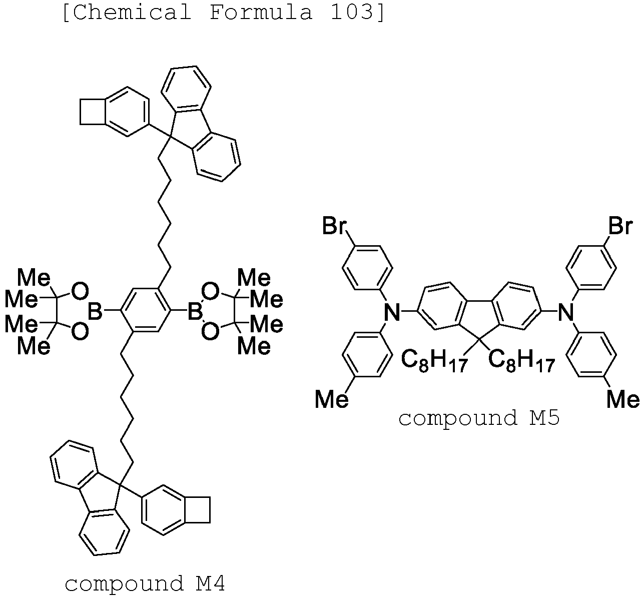

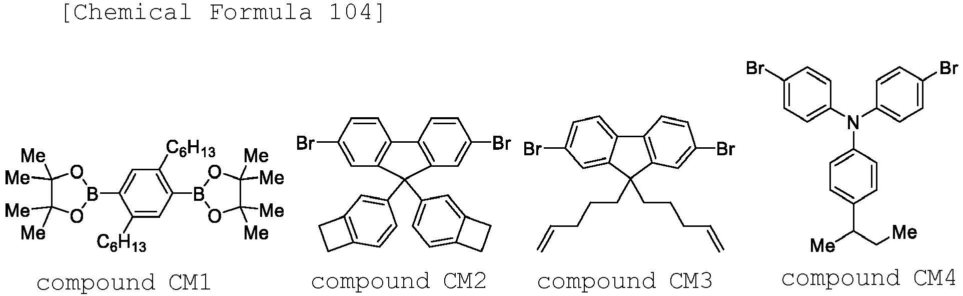

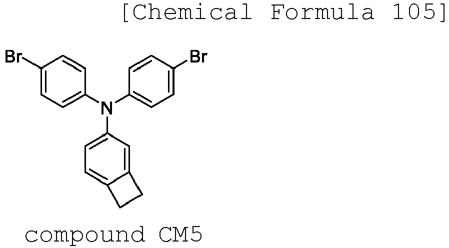

### <Synthesis Example RM1> Synthesis of metal complexes RM1 and RM2

A metal complex RM1 was synthesized according to a method described in International Publication WO 2009/157424.

A metal complex RM2 was synthesized according to a method described in JP-A No. 2011-105701.

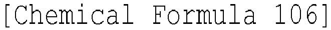

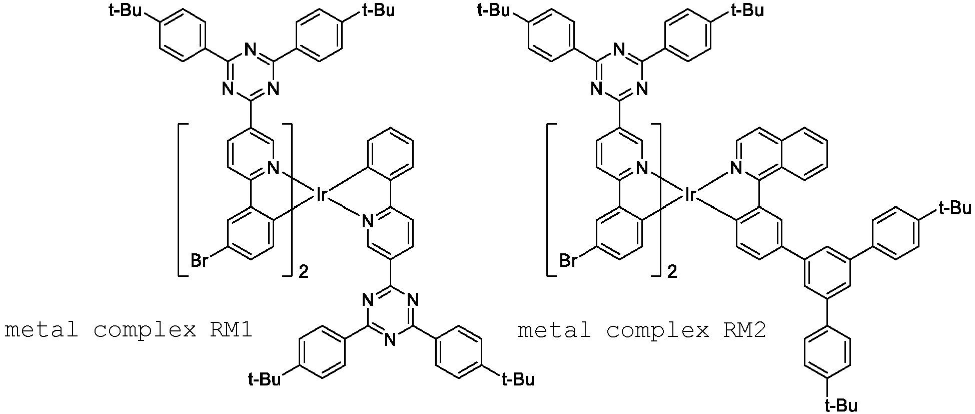

### <Metal complex G1> Synthesis of metal complex G1

A metal complex G1 was synthesized with reference to a method described in International Publication WO 2009/131255. The maximum peak wavelength of the emission spectrum of the compound G1 was 514 nm.

### <Compound HM-1 and compound HTM-1>Acquisition of compound HM-1 and compound HTM-1

A compound HM-1 and a compound HTM-1 were purchased from Luminescence Technology Corp.

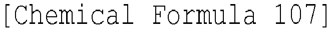

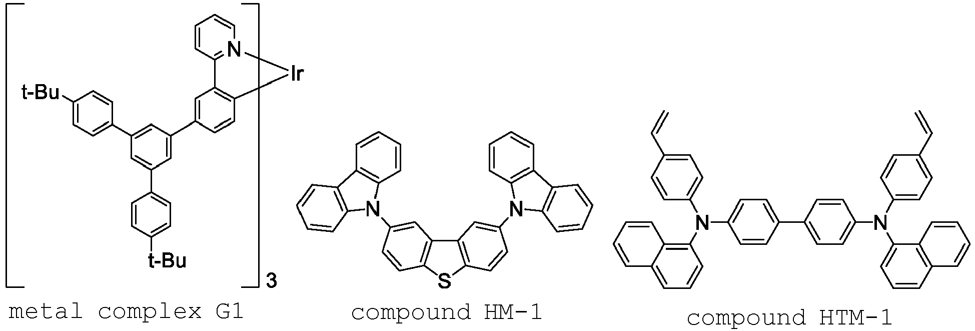

### <Synthesis Example R1> Synthesis of metal complexes R1 to R4

A metal complex R1 was purchased from American Dye Source, Inc.

A metal complex R2 was synthesized with reference to a method described in JP-A No. 2006-188673.

A metal complex R3 was synthesized according to a method described in JP-A No. 2008-179617.

A metal complex R4 was synthesized according to a method described in JP-A No. 2011-105701.

### <Metal complex R5> Acquisition of metal complex R5

A metal complex R5 was purchased from Luminescence Technology Corp.

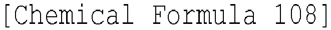

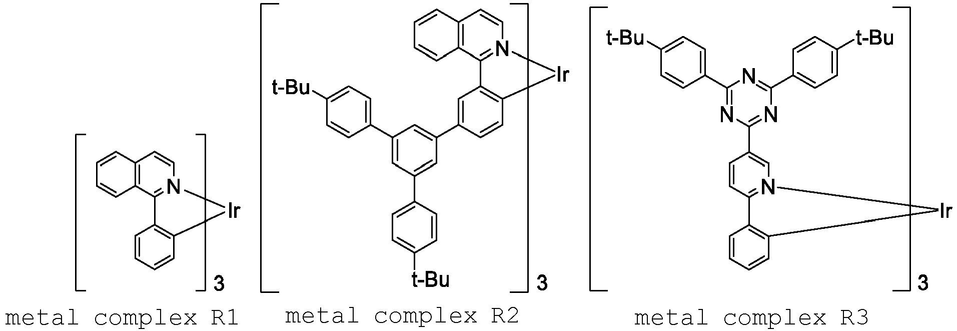

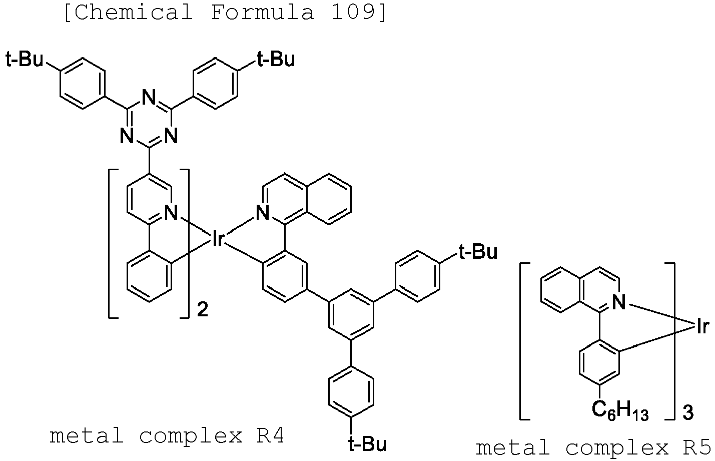

The maximum peak wavelength of the emission spectrum of the metal complex R1 was 618 nm.

The maximum peak wavelength of the emission spectrum of the metal complex R2 was 619 nm.

The maximum peak wavelength of the emission spectrum of the metal complex R3 was 594 nm.

The maximum peak wavelength of the emission spectrum of the metal complex R4 was 611 nm.

The maximum peak wavelength of the emission spectrum of the metal complex R5 was 620 nm.

### <Synthesis Example HTL1> Synthesis of polymer compound HTL-1

An inert gas atmosphere was prepared in a reaction vessel, then, the compound M1 (2.52 g), the compound M2 (0.470 g), the compound M3 (4.90 g), the metal complex RM1 (0.530 g), dichlorobis(tris-o-methoxyphenylphosphine)palladium (4.2 mg) and toluene (158 mL) were added, and the mixture was heated at 100°C. A 20% by mass tetraethylammonium hydroxide aqueous solution (16 mL) was dropped into the reaction liquid, and the solution was refluxed for 8 hours. After the reaction, to this were added phenylboronic acid (116 mg) and dichlorobis(tris-o-methoxyphenylphosphine)palladium (4.2 mg), and the solution was refluxed for 15 hours. Thereafter, to this was added a sodium diethyldithiacarbamate aqueous solution, and the mixture was stirred at 85°C for 2 hours. After cooling, the reaction liquid was washed with 3.6% by mass hydrochloric acid, 2.5% by mass ammonia water and water, and the resultant solution was dropped into methanol, to generate a precipitate. The precipitate was dissolved in toluene, and purified by passing through an alumina column and a silica gel column in this order. The resultant solution was dropped into methanol, stirred, then, the resultant precipitate was collected by filtration, and dried, to obtain 6.02 g of a polymer compound HTL-1. The polymer compound HTL-1 had an Mn of 3.8×10⁴ and an Mw of 4.5×10⁵.

The polymer compound HTL-1 is a copolymer constituted of a constitutional unit derived from the compound M1, a constitutional unit derived from the compound M2, a constitutional unit derived from the compound M3, a constitutional unit derived from the metal complex RM1 at a molar ratio of 40:10:47:3, according to the theoretical values calculated from the amounts of the charged raw materials.

The emission spectrum of the polymer compound HTL-1 had maximum peak wavelengths at 404 nm and 600 nm, and the maximum peak wavelength of the emission spectrum of the polymer compound HTL-1 was 404 nm. The maximum peak wavelength at 600 nm is the maximum peak wavelength of the emission spectrum of a metal complex corresponding to the residual group of the metal complex RM1.

### <Synthesis Example HTL2> Synthesis of polymer compound HTL-2

A polymer compound HTL-2 was synthesized according to a method described in International Publication WO 2015/145871 using the compound M4, the compound M2 and the compound M5. The polymer compound HTL-2 had an Mn of 2.3×10⁴ and an Mw of 1.2×10⁵.

The polymer compound HTL-2 is a copolymer constituted of a constitutional unit derived from the compound M4, a constitutional unit derived from the compound M2, a constitutional unit derived from the compound M5 at a molar ratio of 45:5:50, according to the theoretical values calculated from the amounts of the charged raw materials.

### <Synthesis Example HTL3> Synthesis of polymer compound HTL-3

A polymer compound HTL-3 was synthesized according to a method described in JP-A No. 2016-111355 using the compound M4, the compound M2, the compound M5 and the metal complex RM1. The polymer compound HTL-3 had an Mn of 3.0×10⁴ and an Mw of 2.7×10⁵.

The polymer compound HTL-3 is a copolymer constituted of a constitutional unit derived from the compound M4, a constitutional unit derived from the compound M2, a constitutional unit derived from the compound M5, a constitutional unit derived from the metal complex RM1 at a molar ratio of 40:10:47:3, according to the theoretical values calculated from the amounts of the charged raw material.

The emission spectrum of the polymer compound HTL-3 had maximum peak wavelengths at 407 nm and 599 nm, and the maximum peak wavelength of the emission spectrum of the polymer compound HTL-3 was 407 nm. The maximum peak wavelength at 599 nm is the maximum peak wavelength of the emission spectrum of a metal complex corresponding to the residual group of the metal complex RM1.

### <Synthesis Example HTL4> Synthesis of polymer compound HTL-4

A polymer compound HTL-4 was synthesized according to a method described in JP-A No. 2015-110751 using the compound CM1, the compound CM4, the compound CM2 and the compound CM3. The polymer compound HTL-4 had an Mn of 5.5×10⁴ and an Mw of 1.9×10⁵.

The polymer compound HTL-4 is a copolymer constituted of a constitutional unit derived from the compound CM1, a constitutional unit derived from the compound CM4, a constitutional unit derived from the compound CM2, a constitutional unit derived from the compound CM3 at a molar ratio of 50:40:5:5, according to the theoretical values calculated from the amounts of the charged raw materials.

### <Synthesis Example HTL5> Synthesis of polymer compound HTL-5

A polymer compound HTL-5 was synthesized according to a method described in International Publication WO 2017/099012 using the compound CM1, the compound CM4, the compound CM5, the compound CM3 and the metal complex RM1. The polymer compound HTL-5 had an Mn of 3.3×10⁴ and an Mw of 2.4×10⁵.

The polymer compound HTL-5 is a copolymer constituted of a constitutional unit derived from the compound CM1, a constitutional unit derived from the compound CM4, a constitutional unit derived from the compound CM5, a constitutional unit derived from the compound CM3, a constitutional unit derived from the metal complex RM1 at a molar ratio of 50:32:10:5:3, according to the theoretical values calculated from the amounts of the charged raw materials.

The emission spectrum of the polymer compound HTL-5 had maximum peak wavelengths at 399 nm and 599 nm, and the maximum peak wavelength of the emission spectrum of the polymer compound HTL-5 was 399 nm. The maximum peak wavelength at 599 nm is the maximum peak wavelength of the emission spectrum of a metal complex corresponding to the residual group of the metal complex RM1.

### <Synthesis Example HTL6> Synthesis of polymer compound HTL-6

A polymer compound HTL-6 was synthesized according to a method described in International Publication WO 2017/099012 using the compound CM1, the compound CM4, the compound CM5, the compound CM3 and the metal complex RM2. The polymer compound HTL-6 had an Mn of 6.0×10⁴ and an Mw of 4.9×10⁵.

The polymer compound HTL-6 is a copolymer constituted of a constitutional unit derived from the compound CM1, a constitutional unit derived from the compound CM4, a constitutional unit derived from the compound CM5, a constitutional unit derived from the compound CM3, a constitutional unit derived from the metal complex RM2 at a molar ratio of 50:32:10:5:3, according to the theoretical values calculated from the amounts of the charged raw materials.

The emission spectrum of the polymer compound HTL-6 had maximum peak wavelengths at 399 nm and 614 nm, and the maximum peak wavelength of the emission spectrum of the polymer compound HTL-6 was 399 nm. The maximum peak wavelength at 614 nm is the maximum peak wavelength of the emission spectrum of a metal complex corresponding to the residual group of the metal complex RM2.

### <Synthesis Example ET1> Synthesis of polymer compound ET1

According to a method described in JP-A No. 2012-33845, a compound ET1-1 and a compound ET1-2 were synthesized, and a polymer compound ETla was synthesized using the synthesized compounds. The polymer compound ETla had an Mn of 5.2×10⁴.

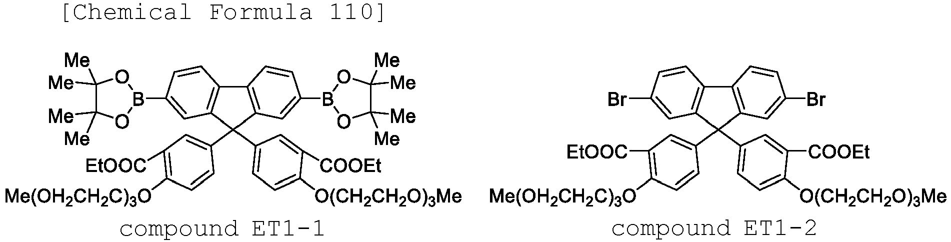

The polymer compound ETla is a copolymer constituted of a constitutional unit derived from the compound ET1-1, a constitutional unit derived from the compound ET1-2 at a molar ratio of 50:50, according to the theoretical values calculated from the amounts of the charged raw materials.

An inert gas atmosphere was prepared in a reaction vessel, then, the polymer compound ETla (200 mg), tetrahydrofuran (20 mL) and ethanol (20 mL) were added, and the mixture was heated at 55°C. Thereafter, to this was added cesium hydroxide (200 mg) dissolved in water (2 mL), and the mixture was stirred at 55°C for 6 hours. Thereafter, the solution was cooled down to room temperature, then, concentrated under reduced pressure, to obtain a solid. The resultant solid was washed with water, then, dried under reduced pressure, to obtain a polymer compound ET1 (150 mg, pale yellow solid). According to the NMR spectrum of the resultant polymer compound ET1, it was confirmed that a signal derived from an ethyl group at an ethyl ester portion of the polymer compound ETla has completely disappeared.

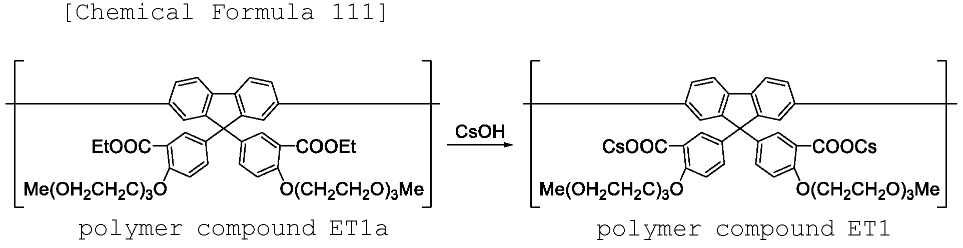

### <Synthesis Example B1> Synthesis of metal complex B1

Metal complexes BC1 and BC2 were synthesized according to a method described in International Publication WO 2016/185183. The maximum peak wavelength of the emission spectrum of the metal complexes BC1 and BC2 was 463 nm.

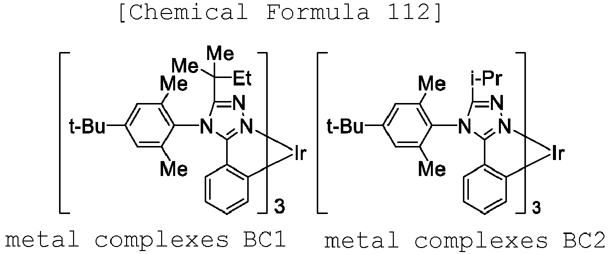

### <Synthesis Example B1> Synthesis of metal complex B1

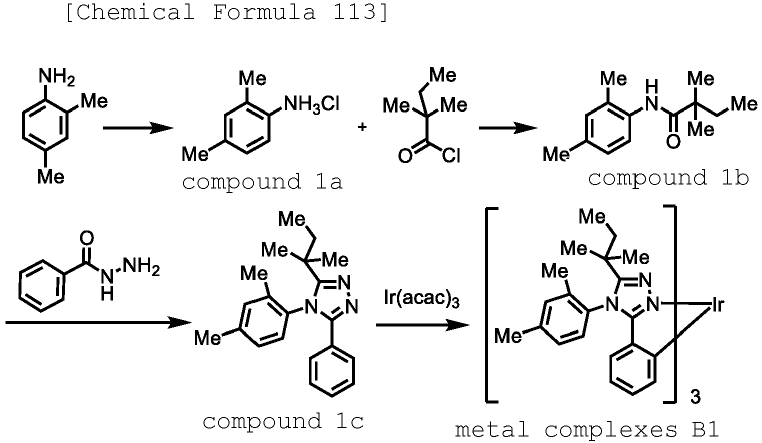

A nitrogen gas atmosphere was prepared in a reaction vessel, then, 2,4-dimethylaniline (200 g) and cyclopentyl methyl ether (400 mL) were added, and the mixture was stirred. Thereafter, the reaction vessel was cooled using an ice bath, then, a 16% by mass hydrogen chloride cyclopentyl methyl ether solution (357 g) was dropped into this. After dropping, stirring at room temperature was continued for 1 hour, and the deposited solid was collected by filtration, and the resultant solid was washed with hexane (150 mL). The resultant solid was crystallized using 2-propanol, and further, dried at room temperature under reduced pressure, to obtain a compound 1a (220 g, pale red solid).

A nitrogen gas atmosphere was prepared in a reaction vessel, then, the compound 1a (140 g), chloroform (2100 mL) and triethylamine (267 mL) were added, and the mixture was stirred. Thereafter, the reaction vessel was cooled using an ice bath, then, 2,2-dimethylbutyryl chloride (113 mL) was dropped into this. After dropping, stirring at room temperature was continued for 1 hour, then, to this was added a saturated sodium carbonate aqueous solution (400 mL), and the mixture was stirred at room temperature. The resultant reaction mixture was liquid-separated, then, the resultant organic layer was washed with a saturated sodium carbonate aqueous solution and ion exchanged water in series. Thereafter, the resultant organic layer was dried over magnesium sulfate, then, filtrated. The resultant filtrate was concentrated, then, to this was added heptane and the mixture was stirred for 1 hour, and the resultant solid was collected by filtration. Thereafter, the resultant solid was dried at 40°C under reduced pressure, to obtain a compound 1b (164 g, white solid). The HPLC area percentage value of the compound 1b was 99.5% or more.

The NMR measurement results of the compound 1b were as described below.

¹H-NMR (CDCl₃, 400 MHz) δ (ppm): 0.94 (3H, t), 1.29 (6H, s), 1.67 (2H, q), 2.21 (3H, s), 2.28 (3H, s), 6.99 (1H, s), 7.00 (1H, d), 7.12 (1H, br), 7.65 (1H, d).

An argon gas atmosphere was prepared in a reaction vessel, then, the compound 1b (60 g), monochlorobenzene (480 mL), 2-fluoropyridine (26 mL) and trifluoromethanesulfonic anhydride (50 mL) were added, and the mixture was stirred at room temperature for 30 minutes. Thereafter, to this was added benzhydrazide (41 g), then, the mixture was stirred at 90°C for 3 hours. Thereafter, the resultant reaction liquid was cooled down to room temperature, then, to this was added a sodium hydrogen carbonate aqueous solution (500 mL), and an organic layer was extracted. The resultant organic layer was washed with ion exchanged water, then, the resultant organic layer was concentrated under reduced pressure, to obtain a solid. The resultant solid was purified by silica gel column chromatography (a mixed solvent of chloroform and tetrahydrofuran), then, crystallized using a mixed solvent of 2-propanol and heptane. Thereafter, the resultant solid was dried at 50°C under reduced pressure, to obtain a compound 1c (70 g, yield 80%) as a white solid. The HPLC area percentage value of the compound 1c was 99.5% or more.

The measurement results of LC-MS and NMR of the compound 1c were as described below.

LC-MS (APCI, positive): m/z = 320 [M+H]⁺
¹H-NMR (600 MHz, CD₂Cl₂) δ (ppm): 7.42-7.37 (m, 2H), 7.35-7.31 (m, 2H), 7.29-7.25 (m, 2H), 7.19 (d, 1H), 7.07 (s, 1H), 2.40 (s, 3H), 1.79-1.72 (m, 4H), 1.57-1.45 (m, 1H), 1.34 (s, 3H), 1.15 (s, 3H), 0.89 (t, 3H).

An argon gas atmosphere was prepared in a reaction vessel, then, trisacetylacetonatoiridium (15.3 g), the compound 1c (40.0 g) and pentadecane (40 mL) were added, and the mixture was stirred for 50 hours under reflux with heating. Thereafter, to this was added toluene and the mixture was filtrated through a filter paved with silica gel, then, from the resultant silica gel, a yellow solution containing a metal complex B1 was extracted using a mixed solvent of toluene and ethyl acetate. The resultant solution was concentrated under reduced pressure, to obtain a solid. The resultant solid was purified by silica gel column chromatography (toluene solvent), then, crystallized using a mixed solvent of toluene and methanol. Thereafter, the resultant solid was dried at 50°C under reduced pressure, to obtain a metal complex B1 (30.5 g). The HPLC area percentage value of the metal complex B1 was 99.3%.

The measurement results of LC-MS of the metal complex B1 were as described below.

LC-MS (APCI, positive): m/z = 1149 [M+H]⁺
The maximum peak wavelength of the emission spectrum of the metal complex B1 was 463 nm.

### <Synthesis Example B2> Synthesis of metal complex B2

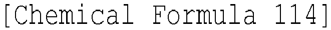

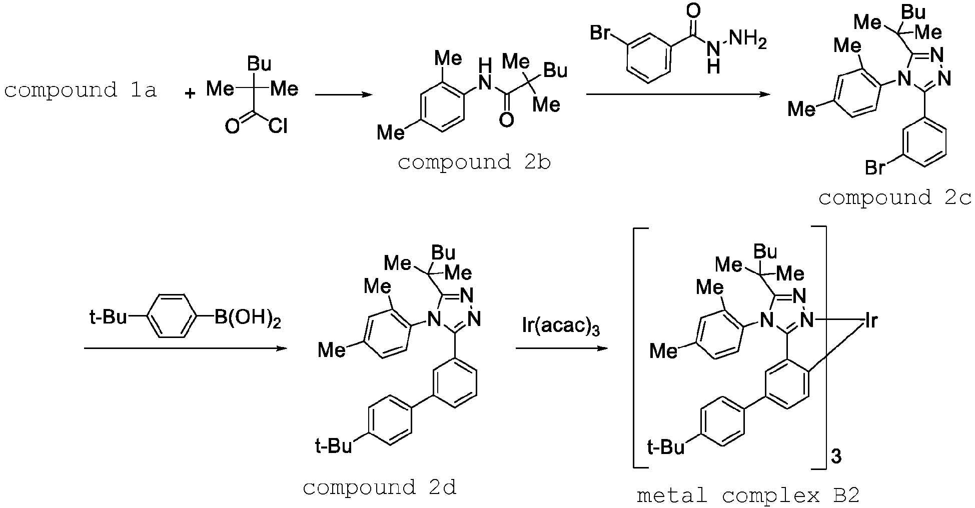

An argon gas atmosphere was prepared in a reaction vessel, then, 2,2'-dimethylhexanoic acid (40 g), chloroform (240 mL), N,N'-dimethylformamide (0.21 mL) and thionyl chloride (20 mL) were added, and the mixture was stirred at 45°C for 3 hours. Thereafter, the reaction vessel was cooled using a water bath, to obtain a reaction liquid containing 2,2'-dimethylhexanoyl chloride.

An argon gas atmosphere was prepared in a reaction vessel separately prepared, then, the compound 1a (41.5 g), chloroform (400 mL) and triethylamine (75 mL) were added, and the reaction vessel was cooled using an ice bath. Thereafter, the reaction liquid containing 2,2'-dimethylhexanoyl chloride obtained above was dropped into this. After dropping, stirring at room temperature was continued for 1 hour, then, to this was added a 2 mol/L sodium carbonate aqueous solution (280 mL), and the mixture was stirred at room temperature. The resultant reaction mixture was liquid-separated, to obtain an organic layer. The resultant organic layer was washed with ion exchanged water (280 mL). Thereafter, the resultant organic layer was dried over anhydrous magnesium sulfate, then, filtrated. The resultant filtrate was concentrated under reduced pressure, to obtain a compound 2b (60 g, yield 88%) as a pale yellow oil. The above-described operation was repeated, to secure a necessary amount of the compound 2b. The HPLC area percentage value of the compound 2b was 99.5% or more.

The measurement results of TLC-MS of the compound 2b were as described below.

TLC/MS (DART, positive): m/z = 248 [M+H]⁺

An argon gas atmosphere was prepared in a reaction vessel, then, the compound 2b (40 g), monochlorobenzene (320 mL), 2-fluoropyridine (14 mL) and trifluoromethanesulfonic anhydride (27 mL) were added, and the mixture was stirred at room temperature for 30 minutes. Thereafter, to this was added 3-bromobenzhydrazide (35 g), then, the mixture was stirred at 90°C for 7 hours. Thereafter, the resultant reaction liquid was cooled down to room temperature, then, to this was added a 2 mol/L sodium hydrogen carbonate aqueous solution (160 mL), the mixture was stirred, then, an organic layer was extracted. The resultant organic layer was washed with ion exchanged water. Thereafter, the resultant organic layer was concentrated under reduced pressure, to obtain an oil. The resultant oil was purified by silica gel column chromatography (a mixed solvent of chloroform and ethanol), to obtain a solid. The resultant solid was crystallized using heptane, then, further, dried at 50°C under reduced pressure, to obtain a compound 2c (48 g, yield 77%) as a white solid. The HPLC area percentage value of the compound 2c was 99.5% or more.

The measurement results of LC-MS and NMR of the compound 2c were as described below.

LC/MS (APPI, positive): m/z = 426 [M+H]⁺
¹H-NMR (400 MHz, CD₂Cl₂) δ (ppm) = 7.60-7.55 (m, 1H), 7.41 (d, 1H), 7.25 (d, 1H), 7.21-7.13 (m, 2H), 7.09-7.03 (m, 2H), 2.36 (s, 3H), 1.76-1.59 (m, 4H), 1.43-1.07 (m, 11H), 0.84 (t, 3H).

An argon gas atmosphere was prepared in a reaction vessel, then, the compound 2c (2.2 g), 4-tert-butylphenylboronic acid (1.0 g), toluene (22 mL) and (di-tert-butyl(4-dimethylaminophenyl)phosphine)dichloropalladium(II) (18 mg) were added, and the mixture was heated up to 80°C. Thereafter, to this was added a 20% by mass tetrabutylammonium hydroxide aqueous solution (16 mL), then, the mixture was stirred under reflux with heating for 18 hours. Thereafter, the resultant reaction liquid was cooled down to room temperature, then, to this was added toluene, and an organic layer was extracted. The resultant organic layer was washed with ion exchanged water. Thereafter, the resultant organic layer was dried over anhydrous magnesium sulfate, then, filtrated through a filter paved with silica gel and Celite. The resultant filtrate was concentrated under reduced pressure, to obtain a solid. The resultant solid was purified by silica gel column chromatography (a mixed solvent of chloroform and ethanol), then, crystallized using heptane. Thereafter, the resultant solid was dried at 50°C under reduced pressure, to obtain a compound 2d (2.2 g, yield 85%) as a white solid. The HPLC area percentage value of the compound 2d was 99.5% or more.

The measurement results of LC-MS and NMR of the compound 2d were as described below.

LC-MS (APPI, positive): m/z = 480 [M+H]⁺
¹H-NMR (400 MHz, CD₂Cl₂) δ (ppm) = 7.53-7.48 (m, 1H), 7.46-7.39 (m, 2H), 7.40-7.37 (m, 2H), 7.34-7.29 (m, 2H), 7.26-7.19 (m, 3H), 7.07 (s, 1H), 2.40 (s, 3H), 1.74 (s, 3H), 1.70-1.61 (m, 1H), 1.47-1.36 (m, 1H), 1.34-1.30 (m, 12H), 1.29-1.14 (m, 4H), 1.12 (s, 3H), 0.86 (t, 3H)

An argon gas atmosphere was prepared in a reaction vessel, then, trisacetylacetonatoiridium (1.0 g), the compound 2d (2.0 g) and pentadecane (3 mL) were added, and the mixture was stirred under reflux with heating for 46 hours. Thereafter, to this was added toluene and the mixture was filtrated through a filter paved with silica gel, then, from the resultant silica gel, a yellow solution containing a metal complex B2 was extracted using a mixed solvent of toluene and ethyl acetate. The resultant solution was concentrated under reduced pressure, to obtain a solid, then, the resultant solid was washed with acetonitrile and heptane, and further, purified by silica gel column chromatography (a mixed solvent of toluene and ethyl acetate). Thereafter, the resultant solid was crystallized using a mixed solvent of toluene and acetonitrile, then, further, dried at 50°C under reduced pressure, to obtain a metal complex B2 (1.0 g) as a yellow solid. The HPLC area percentage value of the metal complex B2 was 98.8%.

The measurement results of LC-MS and NMR of the metal complex B2 were as described below.

LC-MS (APCI, positive): m/z = 1629 [M+H]⁺
¹H-NMR (400 MHz, CD₂Cl₂) δ (ppm) = 7.41-7.16 (m, 15H), 7.10-6.64 (m, 12H), 6.19-6.04 (m, 3H), 2.54-2.43 (m, 9H), 2.16-1.67 (m, 9H), 1.62-1.03 (m, 63H), 0.85-0.63 (m, 9H).

The maximum peak wavelength of the emission spectrum of the metal complex B2 was 476 nm.

### <Synthesis Example B3> Synthesis of metal complex B3

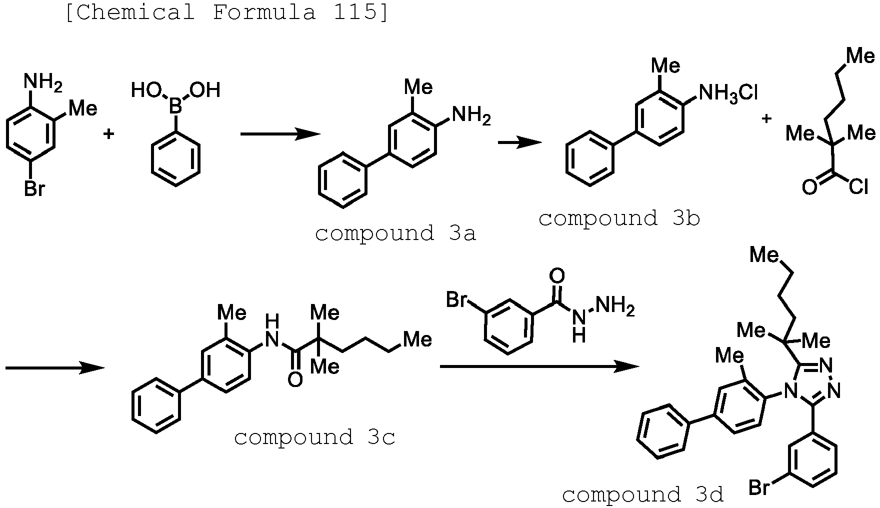

An argon gas atmosphere was prepared in a reaction vessel, then, 2-phenyl-4,4,5,5-tetramethyl-1,3,2-dioxaborolane (50 g), 2-methyl-4-bromoaniline (46 g), tris(dibenzylideneacetone)dipalladium(0) (3 g), 2-dicyclohexylphosphino-2',6'-dimethoxybiphenyl (4 g) and toluene (1L) were added, and the mixture was stirred at room temperature. Thereafter, a 20% by mass tetraethylammonium hydroxide aqueous solution was dropped into this at room temperature, then, the mixture was stirred at 70°C for 5 hours. The resultant reaction liquid was cooled down to room temperature, then, the resultant reaction liquid was liquid-separated, to obtain an organic layer. The resultant organic layer was washed with ion exchanged water. Thereafter, the resultant organic layer was dried over magnesium sulfate, then, filtrated. The resultant filtrate was concentrated, then, to this were added tetrahydrofuran and activated white earth, and the mixture was stirred at room temperature for 30 minutes, then, an operation of filtrating through a filter paved with Celite was repeated twice. The resultant filtrate was concentrated under reduced pressure, then, to this were added toluene and activated carbon, and the mixture was stirred at room temperature for 30 minutes. Thereafter, the mixture was filtrated through a filter paved with Celite, and the resultant filtrate was concentrated. The above-described operation was repeated, to obtain a compound 3a (92 g, reddish brown oil). The GC area percentage value of the compound 3a was 99.5% or more.

A nitrogen gas atmosphere was prepared in a reaction vessel, then, the compound 3a (92 g) and cyclopentyl methyl ether (214 mL) were added, and the mixture was stirred. Thereafter, the reaction vessel was cooled using an ice bath, then, a 16% by mass hydrogen chloride cyclopentyl methyl ether solution (114 g) was dropped into this, then, heptane (649 mL) was dropped. After dropping, stirring at room temperature was continued for 1 hour, then, the deposited solid was collected by filtration, and the resultant solid was washed with heptane and acetone. The resultant solid was crystallized several times using 2-propanol, methanol, ethanol and heptane, then, the resultant solid was dried at room temperature under reduced pressure, to obtain a compound 3b (37 g, pale red solid). The above-described operation was repeated, to ensure a necessary amount of the compound 3b.

The measurement results of NMR of the compound 3b were as described below.

¹H-NMR (400 MHz, CDCl₃) δ (ppm) = 7.33-7.65 (8H, m), 4.85 (3H, s), 2.46 (3H, s).

An argon atmosphere was prepared in a reaction vessel, then, 2,2'-dimethylhexanoic acid (29 g), chloroform (174 mL) and N,N'-dimethylformamide (0.14 g) were added, and the mixture was stirred at 50°C. Thereafter, thionyl chloride (24 g) was dropped into this, then, the mixture was stirred at 50°C for 4 hours. Thereafter, the reaction vessel was cooled using a water bath, to prepare a reaction liquid containing 2,2'-dimethylhexanoyl chloride.

A nitrogen gas atmosphere was prepared in a reaction vessel separately prepared, then, the compound 3b (39 g), chloroform (290 mL) and triethylamine (47 mL) were added, and the mixture was stirred. Thereafter, the reaction vessel was cooled using an ice bath, then, the reaction liquid containing 2,2'-dimethylhexanoyl chloride prepared above was dropped into this. After dropping, stirring at room temperature was continued for 2 hours, then, to this was added a saturated sodium carbonate aqueous solution (300 mL), and the mixture was stirred at room temperature. The resultant reaction mixture was liquid-separated, to obtain an organic layer. The resultant organic layer was washed with a saturated sodium carbonate aqueous solution and ion exchanged water in series. Thereafter, the resultant organic layer was dried over magnesium sulfate, then, filtrated. The resultant filtrate was concentrated under reduced pressure, then, separated and purified by silica gel column chromatography (a mixed solvent of hexane and ethyl acetate), to obtain an oil. To the resultant oil was added hexane, then, the resultant mixture was stirred for 1 hour while cooling using an acetone bath added with dry ice, to deposit a solid. Thereafter, the resultant solid was collected by filtration, and the resultant solid was dried at 50°C under reduced pressure, to obtain a compound 3c (40 g, white solid). The above-described operation was repeated, to ensure a necessary amount of the compound 3c. The HPLC area percentage value of the compound 3c was 99.5% or more.

The measurement results of NMR of the compound 3c were as described below.

¹H-NMR (400 MHz, CDCl₃) δ (ppm) = 7.98 (1H, d), 7.55 (1H, d), 7.42 (1H, t), 7.41 (4H, m), 7.31 (1H, t), 2.32 (3H, s), 1.62 (2H, s), 1.35 (10H, s), 0.91 (3H, s).

An argon gas atmosphere was prepared in a reaction vessel, then, the compound 3c (30 g), monochlorobenzene (300 mL), 2-fluoropyridine (9 mL) and trifluoromethanesulfonic anhydride (18 mL) were added, and the mixture was stirred at room temperature for 30 minutes. Thereafter, to this was added 2-bromobenzoylhydrazine (23 g), then, the mixture was stirred at 90°C for 3 hours. Thereafter, the resultant reaction liquid was cooled down to room temperature, then, to this was added a sodium hydrogen carbonate aqueous solution (300 mL), and an organic layer was extracted. The resultant organic layer was washed with ion exchanged water. Thereafter, the resultant organic layer was concentrated under reduced pressure, to obtain a solid. The resultant solid was washed with hexane, then, further, crystallized several times using 2-propanol, heptane and acetonitrile. Thereafter, the resultant solid was dried at 50°C under reduced pressure, to obtain a compound 3d (31 g) as a white solid. The HPLC area percentage value of the compound 3d was 99.5% or more.

The measurement results of LC-MS and NMR of the compound 3d were as described below.

LC-MS (APCI, positive): m/z = 488 [M+H]⁺
¹H-NMR (400 MHz, CDCl₃) δ (ppm) = 7.57-7.64 (m, 4H), 7.38-7.49 (m, 6H), 7.28-7.30 (d, 1H), 7.07 (t, 1H), 1.85 (3H, s), 1.67-1.74 (2H, m), 1.42-1.50 (1H, m), 1.39 (3H, s), 1.14-1.36 (3H, m), 1.17 (3H, s), 0.88 (3H, t).

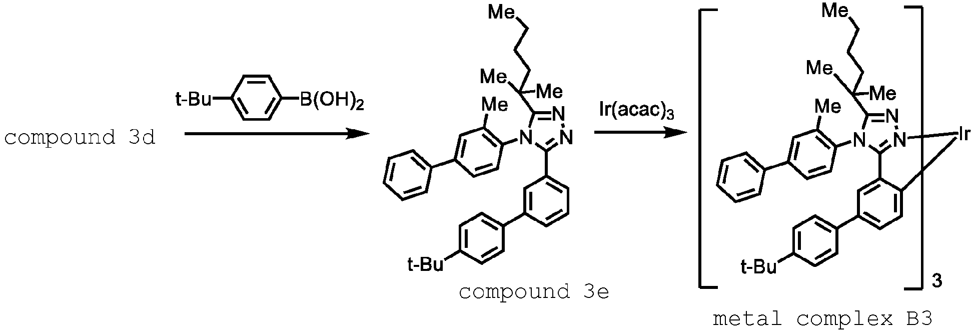

An argon gas atmosphere was prepared in a reaction vessel, then, the compound 3d (10 g), 4-tert-butylphenylboronic acid (4 g) and toluene were added, and the mixture was stirred at room temperature. Thereafter, to this was added bis(di-tert-butyl(4-dimethylaminobiphenyl)phosphine)dichloropalladium (72 mg), then, the mixture was heated to 90°C. Thereafter, a 20% by mass tetrabutylammonium hydroxide aqueous solution (64 g) was dropped into this, then, the mixture was stirred at 90°C for 3 hours. Thereafter, the reaction vessel was cooled down to room temperature, then, the resultant reaction mixture was liquid-separated. The resultant organic layer was washed with ion exchanged water twice. Thereafter, the resultant organic layer was dried over magnesium sulfate, then, filtrated. To the resultant filtrate was added activated carbon, and the mixture was stirred at room temperature for 30 minutes, then, filtrated through a filter paved with Celite. The resultant filtrate was concentrated under reduced pressure, then, to this was added hexane, and a solid was collected by filtration. The resultant solid was crystallized several times using hexane and 2-propanol, then, the resultant solid was dried at 50°C under reduced pressure, to obtain a compound 3e (9 g, white solid). The HPLC area percentage value of the compound 3e was 99.5% or more.

The measurement results of LC-MS and NMR of the compound 3e were as described below.

LC-MS (APCI, positive): m/z = 542 [M+H]⁺
¹H-NMR (400 MHz, CDCl₃) δ (ppm) = 7.63-7.68 (m, 4H), 7.31-7.52 (m, 8H), 7.25 (d, 2H), 7.15-7.17 (d, 2H), 1.88 (s, 3H), 1.43 (s, 3H), 1.28 (s, 9H), 1.21 (s, 3H), 1.45-1.78 (m, 1H), 1.17-1.39 (m, 5H), 0.88 (3H, t)

An argon gas atmosphere was prepared in a reaction vessel, then, trisacetylacetonatoiridium (1.1 g), the compound 3e (5.0 g) and pentadecane (13 mL) were added, and the mixture was stirred for 48 hours under reflux with heating. Thereafter, to this was added toluene and the mixture was filtrated through a filter paved with silica gel, then, from the resultant silica gel, a yellow solution containing a metal complex B3 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), to obtain a solid. The resultant solid was crystallized using a mixed solvent of toluene and acetonitrile several times, and crystallized using a mixed solvent of toluene and hexane several times, respectively. Thereafter, the resultant solid was dried at 50°C under reduced pressure, to obtain a metal complex B3 (1.7 g, yellow solid). The HPLC area percentage value of the metal complex B3 was 98.3%.

The measurement results of NMR of the metal complex B3 were as described below.

¹H-NMR (400 MHz, CD₂Cl₂) δ (ppm) = 7.42-7.73 (24H, m), 6.97-7.11 (18H, m), 6.13-6.26 (3H, m), 2.23-2.27 (4H, m), 2.01 (1H, s), 1.94 (1H, s), 0.97-1.89 (34H, m), 1.88 (2H, d), 1.56 (3H, s), 1.20 (27H, s), 0.70-0.84 (9H, m).

The maximum peak wavelength of the emission spectrum of the metal complex B3 was 478 nm.

### <Synthesis Example B4> Synthesis of metal complex B4

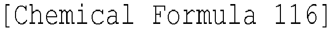

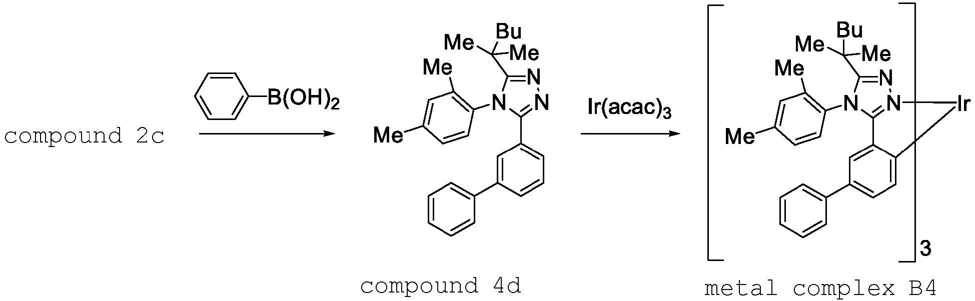

An argon gas atmosphere was prepared in a reaction vessel, then, the compound 2c (7.0 g), phenylboronic acid (2.1 g), toluene (70 mL) and (di-tert-butyl(4-dimethylaminophenyl)phosphine)dichloropalladium(II) (58 mg) were added, and the mixture was heated up to 80°C. Thereafter, to this was added a 20% by mass tetrabutylammonium hydroxide aqueous solution (51 g), then, the mixture was stirred for 18 hours under reflux with heating. Thereafter, the resultant reaction liquid was cooled down to room temperature, then, to this was added toluene, and an organic layer was extracted. The resultant organic layer was washed with ion exchanged water, and further, dried over anhydrous magnesium sulfate, then, filtrated through a filter paved with silica gel and Celite. Thereafter, the resultant filtrate was concentrated under reduced pressure, to obtain a coarse product. The resultant coarse product was purified by silica gel column chromatography (a mixed solvent of chloroform and ethanol), then, further, dried at 50°C under reduced pressure, to obtain a compound 4d (4.7 g, yield 48%) as a colorless oil. The HPLC area percentage value of the compound 4d was 99.5% or more.

The measurement results of LC-MS and NMR of the compound 4d were as described below.

LC-MS (APPI, positive): m/z = 480 [M+H]⁺
¹H-NMR (400 MHz, CD₂Cl₂-d₂) δ (ppm) = 7.54-7.46 (m, 2H), 7.43-7.39 (m, 1H), 7.39-7.27 (m, 7H), 7.21 (d, 1H), 7.07 (s, 1H), 2.39 (s, 3H), 1.75 (s, 3H), 1.71-1.62 (m, 1H), 1.46-1.36 (m, 1H), 1.33 (s, 3H), 1.32-1.14 (m, 4H), 1.13 (s, 3H), 0.86 (t, 3H).

An argon gas atmosphere was prepared in a reaction vessel, then, trisacetylacetonatoiridium (1.5 g), the compound 4d (4.5 g) and pentadecane (14 mL) were added, and the mixture was stirred under reflux with heating for 46 hours. Thereafter, to this was added toluene and the mixture was filtrated through a filter paved with silica gel, then, from the resultant silica gel, a yellow solution containing a metal complex B4 was extracted using a mixed solvent of toluene and ethyl acetate. The resultant solution was concentrated under reduced pressure, to obtain a solid, then, the resultant solid was washed with acetonitrile and heptane, then, purified by silica gel column chromatography (a mixed solvent of toluene and ethyl acetate). Thereafter, the resultant solid was crystallized using a mixed solvent of toluene and acetonitrile, then, the resultant solid was dried at 50°C under reduced pressure, to obtain a metal complex B4 (3.2 g) as a yellow solid. The HPLC area percentage value of the metal complex B4 was 96.3%.

The measurement results of LC-MS and NMR of the metal complex B4 were as described below.

LC-MS (APCI, positive): m/z = 1629 [M+H]⁺
¹H-NMR (400 MHz, CD₂Cl₂) δ (ppm) = 7.41-7.17 (m, 15H), 7.15-6.67 (m, 15H), 6.21-6.06 (m, 3H), 2.53-2.43 (m, 9H), 2.16-2.05 (m, 5H), 1.90-1.67 (m, 4H), 1.62-0.99 (m, 36H), 0.83-0.62 (m, 9H).

The maximum peak wavelength of the emission spectrum of the metal complex B4 was 476 nm.

### <Synthesis Example B5> Synthesis of metal complex B5

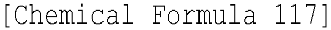

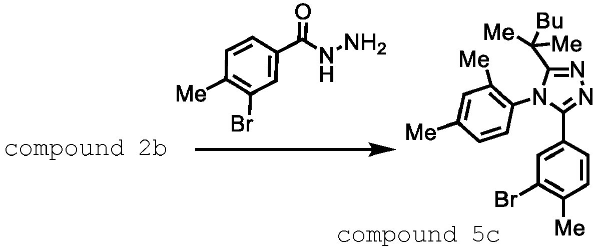

An argon gas atmosphere was prepared in a reaction vessel, then, compound 2b (25.2 g), 2-fluoropyridine (10.8 g), chlorobenzene (202 mL) and trifluoroacetic anhydride (31.3 g) were added, and the mixture was stirred. Thereafter, the reaction vessel was cooled using a water bath, then, to this was added 2-bromo-3-methylbenzoylhydrazine (25.4 g), and the mixture was stirred at room temperature for 10 minutes. Thereafter, an aliquot of the reaction liquid was taken out, diluted with chloroform, then, HPLC measurement was performed, to confirm that the residual amount of the compound 2b became less than 2% (HPLC area percentage value), then, the reaction liquid was further stirred at 90°C for 7 hours. Thereafter, the reaction vessel was cooled down to room temperature, then, to this was added a sodium hydrogen carbonate aqueous solution (100 mL), and an organic layer was extracted. The resultant organic layer was washed with ion exchanged water. Thereafter, magnesium sulfate was added to the resultant organic layer and the layer was dried. Thereafter, to the dried organic layer was added 12.6 g of activated carbon, and the mixture was stirred, then, filtrated through a filter paved with Celite. The resultant filtrate was concentrated under reduced pressure, to obtain a solid. To the resultant solid were added chloroform and tetrahydrofuran, then, the mixture was filtrated through a filter paved with silica gel and Celite. Thereafter, the resultant filtrate was concentrated under reduced pressure, to obtain a solid. The resultant solid was crystallized using a mixed solvent of toluene and heptane. Thereafter, the resultant solid was dried at 50°C under reduced pressure, to obtain a compound 5c (36.2 g) as a white solid. The HPLC area percentage value of the compound 5c was 99.5% or more.

The measurement results of NMR of the compound 5c were as described below.

¹H-NMR (400 MHz, CD₂Cl₂-d₂) δ (ppm) = 7.61-7.53 (m, 1H), 7.28-7.21 (m, 1H), 7.21-7.12 (m, 1H), 7.12-7.01 (m, 3H), 2.34 (s, 3H),2.30 (s, 3H), 1.75-1.60 (m, 5H), 1.42-1.08 (m, 10H), 85 (t, 3H).

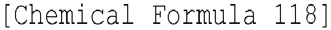

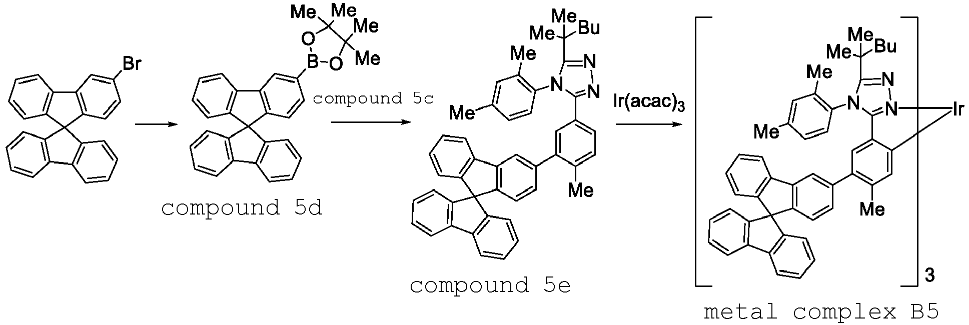

A nitrogen gas atmosphere was prepared in a reaction vessel, then, 3-bromospirofluorene (5.0 g), bispinacolatodiboron (4.1 g), potassium acetate (4.9 g) and cyclopentyl methyl ether (125 mL) were added, and the mixture was stirred. Thereafter, to this was added [1,1'-bis(diphenylphosphino)ferrocene]palladium(II) dichloride dichloromethane (0.3 g), then, stirring at 90°C was continued for 16 hours. Thereafter, the reaction vessel was cooled down to room temperature, then, the resultant reaction liquid was liquid-separated. The resultant organic layer was washed with ion exchanged water (50 mL) twice. Thereafter, the resultant organic layer was dried over magnesium sulfate, then, filtrated, and the resultant filtrate was concentrated under reduced pressure, to obtain a solid. To the resultant solid were added toluene and activated carbon (1.4 g), and the mixture was stirred at room temperature for 1 hour, then, filtrated through a filter paved with Celite. The resultant filtrate was concentrated, to obtain a white solid. The resultant white solid was crystallized using toluene and acetonitrile, then, the resultant solid was dried at 50°C under reduced pressure, to obtain a compound 5d (4.5 g, white solid).

The measurement results of ¹H-NMR of the compound 5d were as described below.

¹H-NMR (CD₂Cl₂, 400 MHz) δ (ppm) = 1.33 (12H, m), 6.64 (4H, m), 7.06-7.23 (3H, m), 7.35 (3H, t), 7.51 (1H, d), 7.86 (2H, d), 7.91 (1H, d), 8.26 (1H, s).

An argon gas atmosphere was prepared in a reaction vessel, then, the compound 5c (1.7 g), the compound 5d (2.0 g), 40% by mass tetrabutylammonium hydroxide aqueous solution (5.9 g), ion exchanged water (5.9 g) and toluene (19.9 g) were added, and the mixture was stirred at room temperature. Thereafter, to this was added bis(di-tert-butyl(4-dimethylaminobiphenyl)phosphine)dichloropallad ium (0.03 g), then, the mixture was stirred at 80°C for 19 hours. Thereafter, the reaction vessel was cooled down to room temperature, then, the resultant reaction liquid was liquid-separated. The resultant organic layer was washed with ion exchanged water (27.0 g) twice. Thereafter, the resultant organic layer was dried over magnesium sulfate, then, filtrated. To the resultant filtrate was added activated carbon (0.5 g), and the mixture was stirred at room temperature for 1 hour, then, filtrated through a filter paved with Celite. The resultant filtrate was concentrated under reduced pressure, to obtain a solid. The resultant solid was separated and purified by silica gel column chromatography (a mixed solvent of hexane and ethyl acetate), to obtain a solid. The resultant solid was crystallized several times using a mixed solvent of toluene and heptane, and a mixed solvent of toluene and acetonitrile. Thereafter, the resultant solid was dried at 50°C under reduced pressure. The above-described operation was repeated, to obtain a compound 5e (2.6 g, white solid). The HPLC area percentage value of the compound 5e was 99.5% or more.

The measurement results of ¹H-NMR of the compound 5e were as described below.

¹H-NMR (CD₂Cl₂, 400 MHz) δ (ppm) = 7.89-7.85 (m, 2H), 7.84-7.80 (m, 1H), 7.60-7.57 (m, 1H), 7.40-7.35 (m, 3H), 7.30-7.26 (m, 2H), 7.23 (d, 1H), 7.18-7.08 (m, 5H), 7.05 (br, 1H), 6.82 (dd, 1H), 6.74-6.63 (m, 4H), 2.32 (s, 3H), 2.27 (s, 3H), 1.76 (s, 3H), 1.69-1.59 (m, 1H), 1.44-1.37 (m, 1H), 1.32 (s, 3H), 1.29-1.15 (m, 4H), 1.09 (s, 3H), 0.85 (t, 3H).

An argon gas atmosphere was prepared in a reaction vessel, then, trisacetylacetonatoiridium (0.5 g), the compound 5e (2.5 g) and pentadecane (7.2 g) were added, and the mixture was stirred under reflux with heating for 46 hours. Thereafter, to this was added toluene (9.0 g) and the mixture was filtrated through a filter paved with silica gel (22.6 g), then, from the resultant silica gel, a yellow solution containing a metal complex B5 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), to obtain a solid. The resultant solid was crystallized using a mixed solvent of toluene and acetonitrile, then, dried at 50°C under reduced pressure, to obtain a metal complex B5 (0.7 g, yellow solid). The HPLC area percentage value of the metal complex B5 was 99.0%.

The measurement results of LC/MS and ¹H-NMR of the metal complex B5 were as described below.

LC/MS (APCI, positive): m/z = 2218 [M+H]⁺
¹H-NMR (CD₂Cl₂, 400 MHz) δ (ppm) = 7.90-7.82 (m, 9H), 7.51-7.34 (m, 15H), 7.27-7.09 (m, 15H), 6.90-6.78 (m, 3H), 6.75-6.59 (m, 12H), 6.57-6.51 (m, 3H), 5.88-5.78 (m, 3H), 2.25-2.05 (m, 27H), 2.01-1.83 (m, 6H), 1.47-1.06 (m, 30H), 0.89-0.72 (m, 9H).

The maximum peak wavelength of the emission spectrum of the metal complex B5 was 467 nm.

### <Synthesis Example B6> Synthesis of metal complex B6

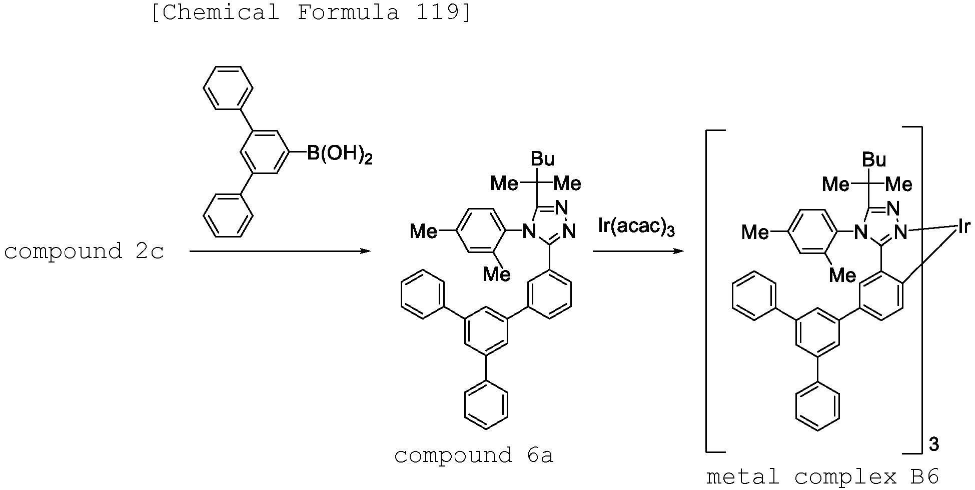

An argon gas atmosphere was prepared in a reaction vessel, then, the compound 2c (13.0 g), 5'-m-terphenylboronic acid (9.2 g), bis(di-t-butyl(4-dimethylaminobiphenyl)phosphine)dichloropalladium (0.1 g) and toluene (100 mL) were added, and the mixture was stirred at room temperature. Thereafter, to this was added a 40% by mass tetrabutylammonium hydroxide aqueous solution (49 mL), then, the mixture was stirred at 90°C for 21 hours. Thereafter, the reaction vessel was cooled down to room temperature, then, the resultant reaction liquid was liquid-separated. The resultant organic layer was washed with ion exchanged water. Thereafter, the resultant organic layer was dried over magnesium sulfate, then, filtrated. To the resultant filtrate was added activated carbon (3.0 g), and the mixture was stirred at room temperature for 1 hour, then, filtrated through a filter paved with Celite. The resultant filtrate was concentrated under reduced pressure, to obtain a coarse product. The resultant coarse product was separated and purified by silica gel column chromatography (a mixed solvent of chloroform and ethanol), to obtain an oil. To the resultant oil were added methanol and activated carbon, and the mixture was stirred at room temperature for 1 hour, then, filtrated through a filter paved with Celite. The resultant filtrate was concentrated under reduced pressure, to obtain a white solid. The resultant solid was crystallized using a mixed solvent of heptane and 2-propanol, and the resultant solid was dried at 50°C under reduced pressure, to obtain a compound 6a (11.3 g, white solid). The HPLC area percentage value of the compound 6a was 99.5% or more.

The measurement results of ¹H-NMR of the compound 6a were as described below.

¹H-NMR (400 MHz, CD₂Cl₂) δ (ppm) = 7.80-7.25 (m, 18H), 7.20-7.07 (m, 1H), 7.01 (t, 1H), 2.19-2.09 (t, 3H), 1.84-1.56 (m, 5H), 1.45-1.06 (m, 10H), 0.94-0.86 (m, 3H).

An argon gas atmosphere was prepared in a reaction vessel, then, trisacetylacetonatoiridium (2.1 g), the compound 6a (10 g) and pentadecane (50 mL) were added, then, the mixture was stirred for 63 hours under reflux with heating. Thereafter, the reaction vessel was cooled down to room temperature, to this was added 2-propanol (100 mL), and the deposited solid was collected by filtration. The resultant solid was washed with a mixed solvent of dichloromethane and acetonitrile, to obtain a yellow solid (5.5 g). The resultant solid was separated and purified by silica gel column chromatography (a mixed solvent of toluene and ethyl acetate), then, crystallized using a mixed solvent of dichloromethane and ethanol, a mixed solvent of toluene and acetonitrile, and a mixed solvent of toluene and heptane. Further, the resultant solid was separated and purified by reverse phase silica gel column chromatography (a mixed solvent of methylene chloride and acetonitrile), then, crystallized using a mixed solvent of toluene and ethanol. Thereafter, the resultant solid was dried at 50°C under reduced pressure, to obtain a metal complex B6 (3.0 g, yellow solid). The HPLC area percentage value of the metal complex B6 was 99.5% or more.

The measurement results of ¹H-NMR of the metal complex B6 were as described below.

¹H-NMR (400 MHz, CD₂Cl₂) δ (ppm) = 7.66-7.56 (m, 15H),7.51-7.19 (m, 27H), 7.17-6.80 (m, 12H), 6.41-6.26 (m, 3H), 2.34-2.49 (m, 6H), 1.96-1.80 (m, 12H), 1.63-1.00 (m, 36H), 0.89-0.65 (m, 9H).

The maximum peak wavelength of the emission spectrum of the metal complex B6 was 477 nm.

### <Synthesis Example B7> Synthesis of metal complex B7

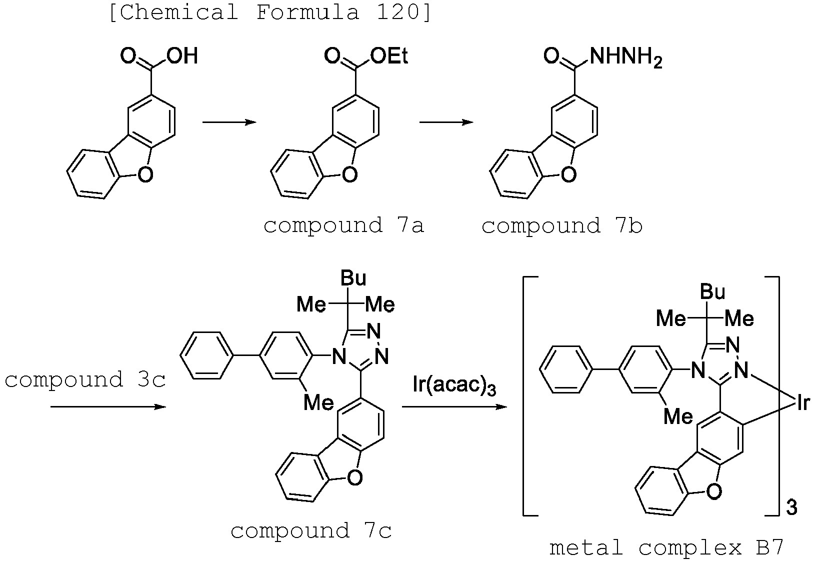

An argon gas atmosphere was prepared in a reaction vessel, then, 2-dibenzofurancarboxylic acid (20.0 g), sulfuric acid (1.8 g) and ethanol (600 mL) were added, the mixture was stirred at 80°C for 45 hours, then, the resultant reaction liquid was adjusted to room temperature. The above-described operation was repeated twice, then, the resultant two reaction liquids were combined. The resultant combined reaction liquid was concentrated, then, to this was added ethyl acetate (400 mL), and the solution was concentrated. To the resultant condensate were added ethyl acetate (200 mL) and ion exchanged water (200 mL), and an organic layer was extracted. The resultant organic layer was washed with a sodium carbonate aqueous solution (200 mL), then, the resultant organic layer was washed with ion exchanged water (200 mL). Thereafter, the resultant organic layer was dried over magnesium sulfate, then, filtrated through a filter paved with Celite and silica gel. The resultant filtrate was concentrated under reduced pressure, to obtain an oil. Thereafter, the resultant oil was dried at 50°C under reduced pressure, to obtain a compound 7a (39.4 g) as a pale yellow oil. The HPLC area percentage value of the compound 7a was 99.0%.

The measurement results of ¹H-NMR of the compound 7a were as described below.

¹H-NMR (400 MHz, CD₂Cl₂) δ (ppm) = 1.40 (3H, t), 4.39 (2H, q), 7.38 (1H, dt), 7.50 (1H, dt), 7.59 (2H, d), 8.02 (1H, dd), 8.16 (1H, dd), 8.67 (1H, d).

An argon gas atmosphere was prepared in a reaction vessel, then, the compound 7a (40.0 g), ethanol (360 mL), ion exchanged water (40 mL) and hydrazine monohydrate (125.0 g) were added, then, the mixture was stirred at 80°C for 6 hours. Thereafter, the reaction liquid was cooled down to room temperature, then, to this was added ion exchanged water (300 mL), and the mixture was stirred at 0°C for 1 hour, to generate a solid. The resultant solid was collected by filtration, then, the resultant solid was washed with ion exchanged water (200 mL) twice, and further, washed with 50% ethanol water (200 mL) once. To the resultant solid was added 2-propanol (565 mL), then, the mixture was suspended by stirring. Thereafter, the solid was collected by filtration, and the resultant solid was dried at 50°C under reduced pressure, to obtain a compound 7b (34.5 g) as a white solid. The HPLC area percentage value of the compound 7b was 97.1%.

The measurement results of ¹H-NMR of the compound 7b were as described below.

¹H-NMR (400 MHz, CD₃OD) δ (ppm) = 4.84 (2H, s), 7.39 (1H, dt), 7.52 (1H, dt), 7.60 (1H, dd), 7.64 (1H, d), 7.93 (1H, dd), 8.07 (1H, dd), 8.48 (1H, d).

An argon gas atmosphere was prepared in a reaction vessel, then, the compound 3c (22.0 g), monochlorobenzene (220 mL), 2-fluoropyridine (6.7 mL) and trifluoromethanesulfonic anhydride (12.8 mL) were added, and the mixture was stirred at room temperature. Thereafter, to this was added the compound 7b (17.7 g), then, the mixture was stirred at 85°C for 3 hours. Thereafter, the resultant reaction liquid was cooled down to room temperature, then, to this was added a sodium hydrogen carbonate aqueous solution (78 mL), and an organic layer was extracted. The resultant organic layer was washed with ion exchanged water (88 mL). Thereafter, the resultant organic layer was dried over magnesium sulfate, then, filtrated. The resultant filtrate was concentrated under reduced pressure, then, the resultant solid was washed with hexane. Thereafter, the resultant solid was crystallized using acetonitrile, then, further, dried at 50°C under reduced pressure, to obtain a compound 7c (28.2 g) as a white solid. The HPLC area percentage value of the compound 7c was 99.5% or more.

The measurement results of ¹H-NMR of the compound 7c were as described below.

¹H-NMR (400 MHz, CD₂Cl₂) δ (ppm) = 0.89 (3H, t), 1.18 (3H, s), 1.20-1.35 (3H, m), 1.39 (3H, m), 1.46 (1H, dt), 1.63 (1H, m), 1.66-1.75 (1H, m), 1.83-(3H, s), 7.29 (1H, dt), 7.34-7.66 (12H, m), 7.80 (1H, dd), 8.02 (1H, d).

An argon gas atmosphere was prepared in a reaction vessel, then, trisacetylacetonatoiridium (4.4 g), the compound 7c (18.0 g) and pentadecane (90 mL) were added, and the mixture was stirred for 66 hours under reflux with heating. Thereafter, the resultant reaction liquid was cooled down to room temperature, then, to this was added 2-propanol (90 mL), to generate a solid. The resultant solid was collected by filtration, then, to the resultant solid was added toluene (15 mL) and the mixture was filtrated through a filter paved with silica gel (76 g). Thereafter, from the resultant silica gel, a yellow solution containing a metal complex B7 was extracted using a mixed solvent of toluene and ethyl acetate. The resultant solution was concentrated under reduced pressure, then, the resultant solid was separated and purified by silica gel column chromatography (a mixed solvent of toluene and ethyl acetate), to obtain a solid. The resultant solid was crystallized with a mixed solvent of toluene and ethanol, then, further, dried at 50°C under reduced pressure, to obtain a metal complex B7 (7.0 g, yellow solid). The HPLC area percentage value of the metal complex B7 was 98.3%.

The measurement results of LC/MS and ¹H-NMR of the metal complex B7 were as described below.

LC/MS (APCI, positive): m/z = 1688.8 [M+H]⁺
¹H-NMR (400 MHz, CD₂Cl₂) δ (ppm) = 0.49-0.86 (10H, m), 0.94-1.70 (35H, m), 1.81-1.91 (4H ,m), 2.23-2.32 (5H, m), 6.51-6.59 (3H, m), 6.78-7.27 (15H, m), 7.43-7.81 (24H, m).

The maximum peak wavelength of the emission spectrum of the metal complex B7 was 452 nm.

### <Synthesis Example B8> Synthesis of metal complex B8

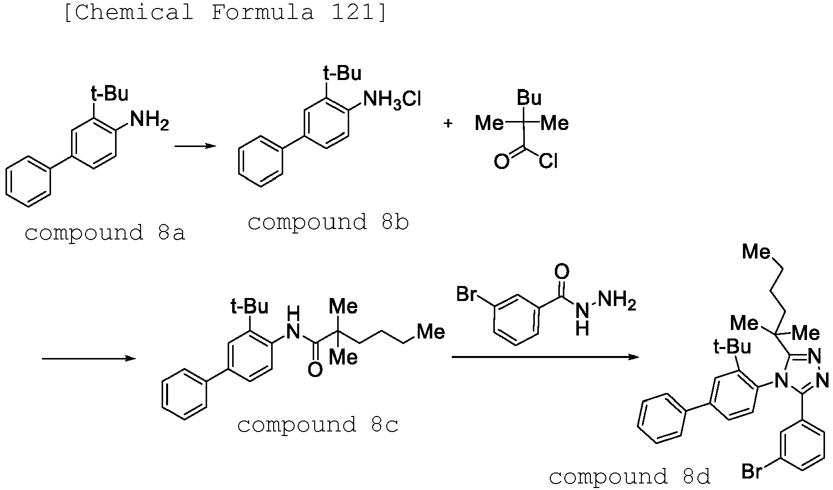

A nitrogen gas atmosphere was prepared in a reaction vessel, then, the compound 8a (27.5 g) and cyclopentyl methyl ether (55 g) were added, and the mixture was stirred. Thereafter, the reaction vessel was cooled using an ice bath, then, a 16% by mass hydrogen chloride cyclopentyl methyl ether solution (27.8 g) was dropped into this. Thereafter, heptane (110 g) was dropped into this, then, stirring at room temperature was continued for 1 hour, and the deposited solid was collected by filtration. The resultant solid was washed with heptane and cyclopentyl methyl ether, then, further, dried under reduced pressure, to obtain a compound 8b (29 g).

A nitrogen gas atmosphere was prepared in a reaction vessel, then, 2,2'-dimethylhexanoic acid (17.3 g), chloroform (114 g) and N,N'-dimethylformamide (0.04 g) were added, and the mixture was stirred at 50°C. Thereafter, thionyl chloride (15.0 g) was dropped into this, then, the mixture was stirred at 40°C for 3 hours, to generate 2,2'-dimethylhexanoyl chloride. Thereafter, the reaction vessel was cooled using a water bath, to obtain a reaction liquid containing 2,2'-dimethylhexanoyl chloride.

A nitrogen gas atmosphere was prepared in a reaction vessel separately prepared, then, the compound 8b (28.5 g), chloroform (114 g) and triethylamine (39.7 g) were added, and the mixture was stirred. Thereafter, the reaction vessel was cooled using an ice bath, then, the reaction liquid containing 2,2'-dimethylhexanoyl chloride prepared above was dropped into this, then, the mixture was stirred at 40°C for 5 hours. Thereafter, the resultant reaction liquid was cooled down to room temperature, then, ion exchanged water was dropped into this. Thereafter, an aqueous layer was removed, then, the resultant organic layer was washed with ion exchanged water, and further, concentrated under reduced pressure, to obtain a coarse product. The resultant coarse product was separated and purified by silica gel column chromatography (a mixed solvent of toluene and ethyl acetate), then, further, crystallized using heptane. Thereafter, the resultant solid was dried at 50°C under reduced pressure, to obtain a compound 8c (26.4 g). The HPLC area percentage value of the compound 8c was 99.5% or more.

The measurement results of NMR of the compound 8c were as described below.

¹H-NMR (CD₂Cl₂, 400 MHz) δ (ppm) = 7.64-7.60 (m, 2H), 7.59-7.55 (m, 2H), 7.44-7.39 (m, 3H), 7.36 (br, 1H), 7.34-7.29 (m, 1H), 1.65-1.57 (m,2H), 1.43 (s, 9H), 1.36-1.27 (m, 10H), 0.92-0.87 (m, 3H).

An argon gas atmosphere was prepared in a reaction vessel, then, the compound 8c (5.5 g), monochlorobenzene (28 g), 2-fluoropyridine (1.7 g) and trifluoromethanesulfonic anhydride (4.9 g) were added, and the mixture was stirred at room temperature for 1 hour. Thereafter, to this was added 3-bromobenzhydrazide (3.7 g), then, the mixture was stirred at 110°C for 17 hours. Thereafter, the resultant reaction liquid was cooled down to room temperature, then, to this was added a 2 mol/L sodium hydrogen carbonate aqueous solution (30 g). Thereafter, an aqueous layer was removed, then, the resultant organic layer was washed with ion exchanged water, and further, concentrated under reduced pressure, to obtain a coarse product. The resultant coarse product was separated and purified by silica gel column chromatography (a mixed solvent of hexane and ethyl acetate), then, further, dried at 50°C under reduced pressure, to obtain a compound 8d (5.3 g). The HPLC area percentage value of the compound 8d was 99.1%.

The measurement results of NMR of the compound 8d were as described below.

¹H-NMR (CD₂Cl₂,400 MHz) δ (ppm) = 7.79 (d, 1H), 7.69-7.64 (m, 2H), 7.61 (dd, 1H), 7.55 (dd, 1H), 7.53-7.47 (m, 2H), 7.46-7.39 (m, 2H), 7.35 (d, 1H), 7.34-7.27 (m, 1H), 7.12 (t, 1H), 2.00-1.86 (m, 1H), 1.59-1.50 (m, 1H), 1.44-1.26 (m, 6H), 1.25-1.13 (m, 4H), 0.99-0.88 (m, 12H).

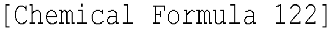

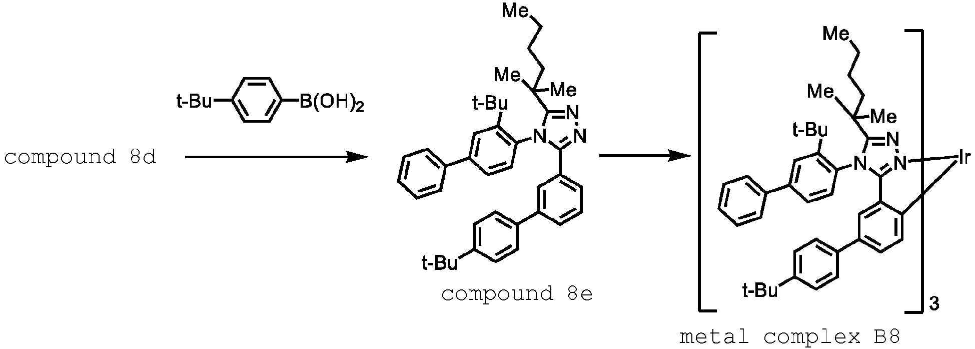

An argon gas atmosphere was prepared in a reaction vessel, then, the compound 8d (5.2 g), 4-tert-butylphenylboronic acid (2.1 g), toluene (52 g) and (di-tert-butyl(4-dimethylaminophenyl)phosphine)dichloropalladium(II) (67 mg) were added, and the mixture was heated up to 80°C. Thereafter, to this was added a 20% by mass tetrabutylammonium hydroxide aqueous solution (30 mL), then, the mixture was stirred for 70 hours under reflux with heating. Thereafter, the resultant reaction liquid was cooled down to room temperature, then, to this was added toluene and the mixture was filtrated through a filter paved with silica gel and Celite. The resultant filtrate was concentrated under reduced pressure, to obtain a solid. The resultant solid was purified by silica gel column chromatography (a mixed solvent of hexane and chloroform), and further, crystallized using a mixed solvent of toluene and heptane, then, the resultant solid was dried at 50°C under reduced pressure, to obtain a compound 8e (3.9 g). The HPLC area percentage value of the compound 8e was 99.5% or more.

The measurement results of NMR of the compound 8e were as described below.

¹H-NMR (CD₂Cl₂,400 MHz) δ (ppm) = 7.82 (d, 1H), 7.73-7.66 (m, 3H), 7.64 (dd, 1H), 7.55-7.47 (m, 3H), 7.47-7.35 (m, 3H), 7.23-7.16 (m, 3H), 7.09-7.03 (m, 2H), 2.01-1.90 (m, 1H), 1.60-1.50 (m, 1H), 1.44-1.16 (m, 19H), 0.95-0.84 (m, 12H).

An argon gas atmosphere was prepared in a reaction vessel, then, trisacetylacetonatoiridium (0.86 g), the compound 8e (3.6 g) and pentadecane (10 g) were added, and the mixture was stirred for 67 hours under reflux with heating. Thereafter, the resultant reaction liquid was cooled down to room temperature, then, to this was added toluene, and the solution was filtrated through a filter paved with silica gel. The resultant filtrate was concentrated under reduced pressure, to obtain a solid. The resultant solid was purified by silica gel column chromatography (a mixed solvent of toluene and ethyl acetate), and further, crystallized using a mixed solvent of toluene and acetonitrile, then, dried at 50°C under reduced pressure, to obtain a metal complex B8 (1.0 g). The HPLC area percentage value of the metal complex B8 was 95.3%.

The measurement results of LC-MS and NMR of the metal complex B8 were as described below.

LC-MS (APCI, positive): m/z = 1941 [M+H]⁺
¹H-NMR (CD₂Cl₂, 400 MHz) δ (ppm) = 8.05-7.93 (m, 3H), 7.77-7.31 (m, 21H), 7.17-6.81 (m, 18H), 6.29-6.16 (m, 3H), 2.00-1.77 (m, 2H), 1.75-1.52 (m, 2H), 1.50-1.15 (m, 64H), 1.12-0.80 (m, 28H), 0.54-0.42 (m, 3H).

The maximum peak wavelength of the emission spectrum of the metal complex B8 was 479 nm.

### <Synthesis Example B9> Synthesis of metal complex B9

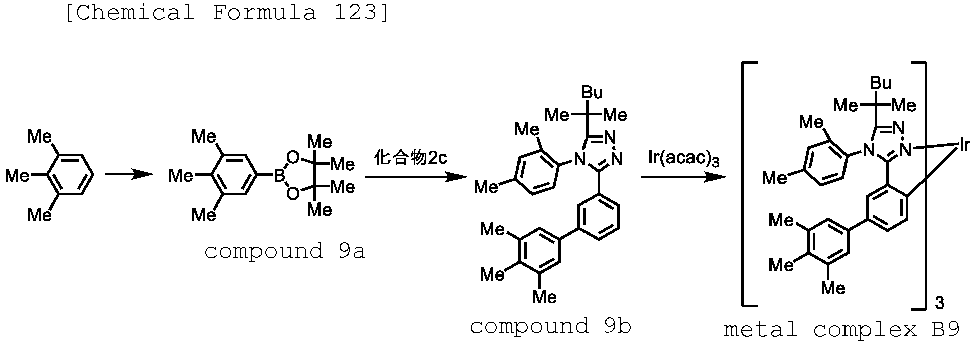

A nitrogen gas atmosphere was prepared in a reaction vessel, then, 1,2,3-trimethylbenzene (168 g), bispinacolatodiboron (384 g), (1,5-cyclooctadiene)(methoxy)iridium (I) (dimer) (8 g) and cyclopentyl methyl ether (1681 mL) were added, and the mixture was stirred. Thereafter, to this was added (1,5-cyclooctadiene)(methoxy)iridium (I) (dimer) (10 g), then, stirring at 95°C was continued for 6 hours. Thereafter, the reaction vessel was cooled down to room temperature, to obtain a reaction mixture.

A reaction vessel containing a nitrogen gas atmosphere was separately prepared, into this was added methanol (2391 g), and it was cooled by an ice bath, and stirred. Thereafter, the reaction mixture obtained above was slowly added to this. Thereafter, to this was added activated white earth (336 g), and the mixture was stirred for 30 minutes, then, filtrated through a filter. The resultant filtrate was concentrated, to obtain a solid. The resultant solid was separated and purified by silica gel column chromatography (a mixed solvent of toluene and hexane), and further, crystallized using acetonitrile. Thereafter, the resultant solid was dried at 50°C under reduced pressure, to obtain a compound 9a (165 g, white solid).

The measurement results of ¹H-NMR of the compound 9a were as described below.
¹H-NMR (400 MHz, CDCl₃) δ (ppm) = 7.46 (s, 2H), 2.29 (s, 6H), 2.19 (s, 3H), 1.34 (s, 12H).

An argon gas atmosphere was prepared in a reaction vessel, then, the compound 2c (9.0 g), the compound 9a (6.2 g), 40% by mass tetrabutylammonium hydroxide aqueous solution (32.9 g), ion exchanged water (32.9 g) and toluene (108.0 g) were added, and the mixture was stirred at room temperature. Thereafter, to this was added bis(di-tert-butyl(4-dimethylaminobiphenyl)phosphine)dichloropalladium (0.2 g), then, the mixture was stirred at 80°C for 2 hours. Thereafter, the reaction vessel was cooled down to room temperature, then, the resultant reaction liquid was liquid-separated. The resultant organic layer was washed with ion exchanged water (91.0 g) twice. Thereafter, the resultant organic layer was dried over magnesium sulfate, then, filtrated. To the resultant filtrate was added activated carbon (1.6 g), and the mixture was stirred at room temperature for 1 hour, then, filtrated through a filter paved with Celite. The resultant filtrate was concentrated under reduced pressure, to obtain a toluene solution.

An argon gas atmosphere was prepared in a reaction vessel, then, the toluene solution obtained above (49.9 g), the compound 9a (5.2 g), 40% by mass tetrabutylammonium hydroxide aqueous solution (32.9 g), ion exchanged water (32.9 g) and toluene (108.0 g) were added, and the mixture was stirred at room temperature. Thereafter, to this was added bis(di-tert-butyl(2-butenyl)phosphine)dichloropalladium (0.2 g), then, the mixture was stirred at 80°C for 27 hours. Thereafter, the reaction vessel was cooled down to room temperature, then, the resultant reaction liquid was liquid-separated. The resultant organic layer was washed with ion exchanged water twice. Thereafter, the resultant organic layer was dried over magnesium sulfate, then, filtrated. To the resultant filtrate was added activated carbon, and the mixture was stirred for 1 hour at room temperature, then, filtrated through a filter paved with Celite. The resultant filtrate was concentrated, then, to this was added heptane and the mixture was stirred for 1 hour, then, a solid was collected by filtration. The resultant solid was crystallized using a mixed solvent of toluene and heptane, and further, was dried at 50°C under reduced pressure, to obtain a compound 9b (6.2 g, white solid). The HPLC area percentage value of the compound 9b was 99.5% or more.

The measurement results of LC/MS and ¹H-NMR of the compound 9b were as described below.

LC/MS (APCI, positive): m/z = 466 [M+H]⁺
¹H-NMR (CD₂CL₂, 400 MHz) δ (ppm) = 7.51-7.45 (m, 2H), 7.40 (t, 1H), 7.35-7.28 (m, 2H), 7.24-7.19 (m, 1H), 7.09-7.06 (m, 1H), 6.91 (s, 2H), 2.40 (s, 3H), 2.28 (s, 6H), 2.16 (s, 3H), 1.75 (s, 3H), 1.70-1.61 (m, 1H), 1.45-1.35 (m, 1H), 1.33 (s, 3H), 1.30-1.16 (m, 4H), 1.11 (s, 3H), 0.89-0.83 (m, 3H).

An argon gas atmosphere was prepared in a reaction vessel, then, trisacetylacetonatoiridium (1.6 g), the compound 9b (6.0 g) and pentadecane (14.2 g) were added, and the mixture was stirred for 45 hours under reflux with heating. Thereafter, to this was added toluene (31.6 g) and the mixture was filtrated through a filter paved with silica gel (18.9 g), then, from the resultant silica gel, a yellow solution containing a metal complex B9 was extracted using a mixed solvent of toluene and ethyl acetate. The resultant solution was concentrated under reduced pressure, to obtain a solid, then, the resultant solid was separated and purified by silica gel column chromatography (a mixed solvent of toluene and ethyl acetate), to obtain a solid. The resultant solid was crystallized using a mixed solvent of toluene and acetonitrile, and further, dried at 50°C under reduced pressure, to obtain a metal complex B9 (3.2 g, yellow solid). The HPLC area percentage value of the metal complex B9 was 99.1%.

The measurement results of LC/MS and ¹H-NMR of the metal complex B9 were as described below.

LC/MS (APCI, positive): m/z = 1585 [M+H]⁺
¹H-NMR (CD₂CL₂, 400 MHz) δ (ppm) = 7.42-7.16 (m, 9H), 6.99-6.62 (m, 12H), 6.31-6.12 (m, 3H), 2.53-2.41 (m,9H), 2.31200 (m, 36H), 1.86-1.77 (m, 3H), 1.44-0.98 (m, 33H), 0.85-0.62 (m, 9H).

The maximum peak wavelength of the emission spectrum of the metal complex B9 was 478 nm.

### <Synthesis Example B10> Synthesis of metal complex B10

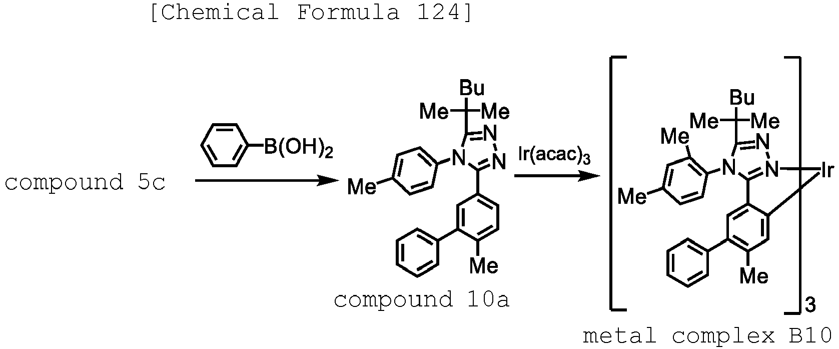

An argon gas atmosphere was prepared in a reaction vessel, then, the compound 5c (15.0 g), phenylboric acid (4.4 g), bis(di-tert-butyl(4-dimethylaminobiphenyl)phosphine)dichloropalladium (0.1 g) and toluene (75 mL) were added, and the mixture was stirred at 80°C. Thereafter, to this was added a 40% by mass tetrabutylammonium hydroxide aqueous solution (55 mL), then, the mixture was stirred at 80°C for 40 hours. Thereafter, the reaction vessel was cooled down to room temperature, then, the resultant reaction liquid was liquid-separated. The resultant organic layer was washed with ion exchanged water (75 mL) twice, then, the resultant organic layer was dried over magnesium sulfate. Thereafter, to the dried organic layer was added activated carbon (15.0 g), and the mixture was stirred at room temperature for 1 hour, then, filtrated through a filter paved with Celite. The resultant filtrate was concentrated under reduced pressure, to obtain an oil. The resultant oil was separated and purified by silica gel column chromatography (a mixed solvent of chloroform and ethanol), to obtain a solid. The resultant solid was crystallized using a mixed solvent of heptane and 2-propanol, and further, dried at 50°C under reduced pressure, to obtain a compound 10a (4.0 g, white solid). The HPLC area percentage value of the compound 10a was 99.5% or more.

The measurement results of ¹H-NMR of the compound 10a were as described below.

¹H-NMR (400 MHz, CD₂Cl₂) δ (ppm) = 7.40-6.94 (m, 11H), 2.42-2.34 (m, 3H), 2.23-2.15 (m, 3H), 1.78-1.48 (m, 6H), 1.42-1.16 (m, 6H), 1.13-1.06 (m, 3H), 0.92-0.77 (m, 3H).

An argon gas atmosphere was prepared in a reaction vessel, then, trisacetylacetonatoiridium (1.1 g), the compound 10a (4.0 g) and pentadecane (50 mL) were added, and the mixture was stirred for 52 hours under reflux with heating. Thereafter, to this was added toluene (32 mL) and the mixture was filtrated through a filter paved with silica gel (16.0 g), then, from the resultant silica gel, a yellow solution containing a metal complex 10 was extracted using a mixed solvent of toluene and ethyl acetate. The resultant solution was concentrated under reduced pressure, to obtain a solid, then, the resultant solid was separated and purified by silica gel column chromatography (a mixed solvent of toluene and ethyl acetate), and further, the resultant solid was washed with ethanol. Then, the resultant solid was separated and purified by reverse phase silica gel column chromatography (a mixed solvent of methylene chloride and acetonitrile), and further, the resultant solid was washed with acetonitrile. Thereafter, the resultant solid was crystallized using a mixed solvent of toluene and ethanol, and further, dried at 50°C under reduced pressure, to obtain a metal complex B10 (1.5 g, yellow solid). The HPLC area percentage value of the metal complex B10 was 99.4%.

The measurement results of ¹H-NMR of the metal complex B10 were as described below.

¹H-NMR (400 MHz, CD₂Cl₂) δ (ppm) = 7.33-7.08 (m, 18H), 7.02-6.93 (m, 6H), 6.73-6.48 (m, 3H), 5.81-5.71 (m, 3H), 2.43-2.32 (m, 9H), 2.16-1.97 (m, 15H), 1.91-1.79 (m, 3H), 1.58-1.03 (m, 36H), 0.84-0.67 (m, 9H).

The maximum peak wavelength of the emission spectrum of the metal complex B10 was 466 nm.

### <Example D1> Fabrication and evaluation of light emitting device D1

### (Formation of anode and hole injection layer)

An ITO film was deposited with a thickness of 45 nm on a glass substrate by a sputtering method, to form an anode. A polythiophene-sulfonic acid type hole injection agent AQ-1200 (manufactured by Plextronics) was spin-coated on the anode, to form a film with a thickness of 35 nm, and the film was heated on a hot plate at 170°C for 15 minutes under an air atmosphere, to form a hole injection layer.

### (Formation of second organic layer)

The polymer compound HTL-1 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a second organic layer (second light emitting layer). By this heating, the polymer compound HTL-1 became a crosslinked body.

### (Formation of first organic layer)

The compound HM-1, the metal complex B1 and the metal complex G1 (compound HM-1/metal complex B1/metal complex G1 = 74% by mass/25% by mass/1% by mass) were dissolved at a concentration of 2% by mass in toluene. The resultant toluene solution was spin-coated on the second organic layer to form a film with a thickness of 75 nm, and the film was heated at 130°C for 10 minutes under a nitrogen gas atmosphere, to form a first organic layer (first light emitting layer).

### (Formation of electron transporting layer)

The polymer compound ET1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, the pressure in the machine was reduced to 1.0×10⁻⁴ Pa or less, then, sodium fluoride was vapor-deposited with a thickness of about 4 nm on the electron transporting layer, then, aluminum was vapor-deposited with a thickness of about 80 nm on the sodium fluoride layer, as a cathode. After vapor deposition, sealing with a glass substrate was performed, to fabricate a light emitting device D1.

### (Evaluation of light emitting device)

Voltage was applied to the light emitting device D1, to observe EL emission. At a current density of 5 mA/cm², the external quantum efficiency [%] and the CIE chromaticity coordinate (x,y) were measured. The results are shown in Table 4.

### <Examples D2 to D10 and Comparative Examples CD1 to CD2>

Fabrication and evaluation of light emitting devices D2 to 10, CD1 and CD2
Light emitting devices D2 to 10, CD1 and CD2 were fabricated in the same manner as in Example D1, except that materials described in Table 4 were used instead of "the compound HM-1, the metal complex B1 and the metal complex G1 (compound HM-1/metal complex B1/metal complex G1 = 74% by mass/25% by mass/1% by mass)" in (Formation of first organic layer) of Example D1.

Voltage was applied to the light emitting devices D2 to 10, CD1 and CD2, to observe EL emission. At a current density of 5 mA/cm², the external quantum efficiency [%] and the CIE chromaticity coordinate (x,y) were measured. The results are shown in Table 4.

**[Table 4]**

| | light emitting device | formation of second organic layer | | formation of first organic layer | | external quantum efficiency (%) (5 mA/cm²) | CIE chromaticity coordinate (x,y) (5 mA/cm²) |
|---|---|---|---|---|---|---|---|
| | | material | composition ratio (% by mass) | material | composition ratio (% by mass) | | |
| Example D1 | D1 | HTL-1 | 100 | HM-1/B1/G1 | 74/25/1 | 19.0 | (0.43,0.46) |
| Example D2 | D2 | HTL-1 | 100 | HM-1/B2/G1 | 74/25/1 | 21.1 | (0.42,0.47) |
| Example D3 | D3 | HTL-1 | 100 | HM-1/B3/G1 | 74/25/1 | 22.0 | (0.40,0.47) |
| Example D4 | D4 | HTL-1 | 100 | HM-1/B4/G1 | 74/25/1 | 21.6 | (0.40,0.48) |
| Example D5 | D5 | HTL-1 | 100 | HM-1/B5/G1 | 74/25/1 | 20.5 | (0.40,0.45) |
| Example D6 | D6 | HTL-1 | 100 | HM-1/B6/G1 | 74/25/1 | 21.9 | (0.41,0.47) |
| Example D7 | D7 | HTL-1 | 100 | HM-1/B7/G1 | 74/25/1 | 22.3 | (0.42,0.47) |
| Example D8 | D8 | HTL-1 | 100 | HM-1/B8/G1 | 74/25/1 | 20.8 | (0.40,0.47) |
| Example D9 | D9 | HTL-1 | 100 | HM-1/B9/G1 | 74/25/1 | 20.2 | (0.42,0.47) |
| Example D10 | D10 | HTL-1 | 100 | HM-1/B10/G1 | 74/25/1 | 19.8 | (0.42,0.45) |
| Comparative Example CD1 | CD1 | HTL-1 | 100 | HM-1/BC1/G1 | 74/25/1 | 15.7 | (0.43,0.43) |
| Comparative Example CD2 | CD2 | HTL-1 | 100 | HM-1/BC2/G1 | 74/25/1 | 12.1 | (0.42,0.44) |

### <Example D11 and Comparative Example CD3> Fabrication and evaluation of light emitting devices D11 and CD3

Light emitting devices D11 and CD3 were fabricated in the same manner as in Example D1, except that materials described in Table 5 were used instead of "the compound HM-1, the metal complex B1 and the metal complex G1 (compound HM-1/metal complex B1/metal complex G1 = 74% by mass/25% by mass/1% by mass)" in (Formation of first organic layer) of Example D1.

Voltage was applied to the light emitting devices D11 and CD3, to observe EL emission. At a current density of 10 mA/cm², the external quantum efficiency [%] and the CIE chromaticity coordinate (x,y) were measured. The results are shown in Table 5.

**[Table 5]**

| | light emitting device | formation of second organic layer | | formation of first organic layer | | external quantum efficiency (%) (10 mA/cm²) | CIE chromaticity coordinate (x,y) (10 mA/cm²) |
|---|---|---|---|---|---|---|---|
| | | material | composition ratio (% by mass) | material | composition ratio (% by mass) | | |
| Example D11 | D11 | HTL-1 | 100 | HM-1/B1 | 75/25 | 18.0 | (0.39,0.37) |
| Comparative Example CD3 | CD3 | HTL-1 | 100 | HM-1/BC1 | 75/25 | 15.5 | (0.42,0.37) |

### <Examples D12 to D21 and Comparative Example CD4>

Fabrication and evaluation of light emitting devices D12 to D21 and CD4

Light emitting devices D12 to D21 and CD4 were fabricated in the same manner as in Example D1, except that materials described in Table 6 were used instead of "the polymer compound HTL-1" in (Formation of second organic layer) of Example D1, and further, materials described in Table 6 were used instead of "the compound HM-1, the metal complex B1 and the metal complex G1 (compound HM-1/metal complex B1/metal complex G1 = 74% by mass/25% by mass/1% by mass)" in (Formation of first organic layer) of Example D1.

In (Formation of second organic layer) of Examples D12 to D21 and Comparative Example CD4, the polymer compounds HTL-2 to HTL-6 became crosslinked bodies by heating.

Voltage was applied to the light emitting devices D12 to D21 and CD4, to observe EL emission. At a current density of 0.1 mA/cm², the external quantum efficiency [%] and the CIE chromaticity coordinate (x,y) were measured. The results are shown in Table 6.

**[Table 6]**

| | light emitting device | formation of second organic layer | | formation of first organic layer | | external quantum efficiency (%) (0.1 mA/cm²) | CIE chromaticity coordinate (x,y) (0.1 mA/cm²) |
|---|---|---|---|---|---|---|---|
| | | material | composition ratio (% by mass) | material | composition ratio (% by mass) | | |
| Comparative Example CD4 | CD4 | HTL-2 | 100 | HM-1/B1/R3 | 74/25/1 | 3.6 | (0.48,0.42) |
| Example D12 | D12 | HTL-2/R3 | 65/35 | HM-1/B1 | 75/25 | 14.2 | (0.34,0.36) |
| Example D13 | D13 | HTL-2/R4 | 65/35 | HM-1/B1 | 75/25 | 13.4 | (0.31,0.34) |
| Example D14 | D14 | HTL-2/R2 | 65/35 | HM-1/B1 | 75/25 | 13.4 | (0.32,0.34) |
| Example D15 | D15 | HTL-2/R5 | 65/35 | HM-1/B1 | 75/25 | 7.0 | (0.26,0.35) |
| Example D16 | D16 | HTL-2/R1 | 65/35 | HM-1/B1 | 75/25 | 5.0 | (0.25,0.32) |
| Example D17 | D17 | HTL-3 | 100 | HM-1/B1 | 75/25 | 19.9 | (0.41,0.37) |
| Example D18 | D18 | HTL-4/R3 | 65/35 | HM-1/B1 | 75/25 | 8.3 | (0.28,0.35) |
| Example D19 | D19 | HTL-5 | 100 | HM-1/B1 | 75/25 | 12.7 | (0.50,0.37) |
| Example D20 | D20 | HTL-4/R4 | 65/35 | HM-1/B1 | 75/25 | 8.1 | (0.28,0.35) |
| Example D21 | D21 | HTL-6 | 100 | HM-1/B1 | 75/25 | 13.0 | (0.47,0.35) |

### <Examples D22 to D25> Fabrication and evaluation of light emitting devices D22 to D25

Light emitting devices D22 to D25 were fabricated in the same manner as in Example D1, except that materials described in Table 7 were used instead of "the polymer compound HTL-1" in (Formation of second organic layer) of Example D1, and further, materials described in Table 7 were used instead of "the compound HM-1, the metal complex B1 and the metal complex G1 (compound HM-1/metal complex B1/metal complex G1 = 74% by mass/25% by mass/1% by mass)" in (Formation of first organic layer) of Example D1.

In (Formation of second organic layer) of Examples D22 to D25, the compound HTM-1 became a crosslinked body by heating.

Voltage was applied to the light emitting devices D22 to D25, to observe EL emission. At a current density of 1 mA/cm², the external quantum efficiency [%] and the CIE chromaticity coordinate (x,y) were measured. The results are shown in Table 7.

**[Table 7]**

| | light emitting device | formation of second organic layer | | formation of first organic layer | | external quantum efficiency (%) (1 mA/cm²) | CIE chromaticity coordinate (x,y) (1 mA/cm²) |
|---|---|---|---|---|---|---|---|
| | | material | composition ratio (% by mass) | material | composition ratio (% by mass) | | |
| Example D22 | D22 | HTM-1/R3 | 65/35 | HM-1/B1 | 75/25 | 9.7 | (0.31,0.35) |
| Example D23 | D23 | HTM-1/R2 | 65/35 | HM-1/B1 | 75/25 | 7.3 | (0.31,0.32) |
| Example D24 | D24 | HTM-1/R5 | 65/35 | HM-1/B1 | 75/25 | 6.0 | (0.30,0.34) |
| Example D25 | D25 | HTM-1/R1 | 65/35 | HM-1/B1 | 75/25 | 3.9 | (0.25,0.38) |

### Industrial Applicability

According to the present invention, a light emitting device excellent in external quantum efficiency can be provided.

## Claims

1. A light emitting device having an anode, a cathode, and, a first organic layer and a second organic layer disposed between said anode and said cathode, wherein
said first organic layer is a layer containing a metal complex represented by the formula (1), and
said second organic layer is a layer containing at least one selected from the group consisting of a metal complex represented by the formula (2) and a polymer compound containing a constitutional unit having a group obtained by removing from the metal complex represented by the formula (2) one or more hydrogen atoms: 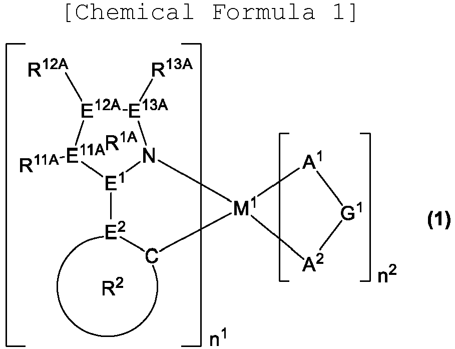 wherein,
M¹ represents a rhodium atom, a palladium atom, an iridium atom or a platinum atom,
n¹ represents an integer of 1 or more and n² represents an integer of 0 or more, provided that n¹ + n² is 3 when M¹ is a rhodium atom or an iridium atom, while n¹ + n² = 2 when M¹ is a palladium atom or a platinum atom,
Ring R^{1A} represents a diazole ring, a triazole ring or a tetrazole ring,
Ring R² represents an aromatic hydrocarbon ring or an aromatic hetero ring, and the foregoing rings optionally have a substituent, and when a plurality of said substituents are present, they may be combined together to form a ring together with atoms to which they are attached, and when a plurality of Ring R² are present, they may be the same or different,
E¹, E², E^{11A}, E^{12A} and E^{13A} each independently represent a nitrogen atom or a carbon atom, and when a plurality of E¹, E², E^{11A}, E^{12A} and E^{13A} are present, they may be the same or different at each occurrence, and at least one of E¹ and E² is a carbon atom,
R^{11A}, R^{12A} and R^{13A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, and when a plurality of R^{11A}, R^{12A} and R^{13A} are present, they may be the same or different at each occurrence,
at least one of E^{11A}, E^{12A} and E^{13A} is a nitrogen atom, and at least one of R^{11A}, R^{12A} and R^{13A} bonding to the nitrogen atom is a group represented by the formula (Ar-1A),
R^{11A} and R^{12A} may be combined together to form a ring together with atoms to which they are attached, R^{12A} and R^{13A} may be combined together to form a ring together with atoms to which they are attached, and the substituent which Ring R² optionally has and R^{11A} may be combined together to form a ring together with atoms to which they are attached,
when E^{11A} is a nitrogen atom, R^{11A} may be present or absent, when E^{12A} is a nitrogen atom, R^{12A} may be present or absent, and when E^{13A} is a nitrogen atom, R^{13A} may be present or absent,
A¹-G¹-A² represents an anionic bidentate ligand, A¹ and A² each independently represent a carbon atom, an oxygen atom or a nitrogen atom, and these atoms may be ring-constituent atoms, G¹ represents a single bond or an atomic group constituting a bidentate ligand together with A¹ and A², and when a plurality of A¹-G¹-A² are present, they may be the same or different, 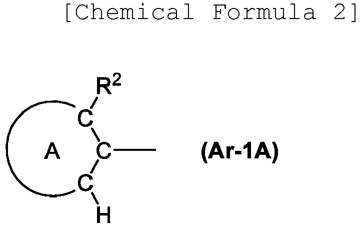
wherein,
Ring A represents an aromatic hydrocarbon ring or an aromatic hetero ring, and the foregoing rings optionally have a substituent, and when a plurality of said substituents are present, they may be combined together to form a ring together with atoms to which they are attached,
R² represents an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, 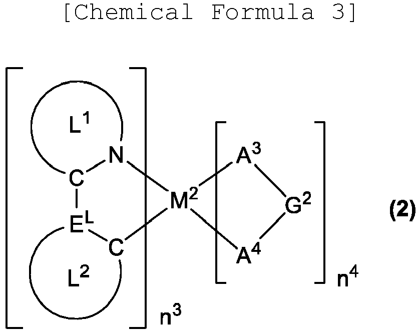
wherein,
M² represents a rhodium atom, a palladium atom, an iridium atom or a platinum atom,
n³ represents an integer of 1 or more and n⁴ represents an integer of 0 or more, provided that n³ + n⁴ = 3 when M² is a rhodium atom or an iridium atom, while n³ + n⁴ is 2 when M² is a palladium atom or a platinum atom,
E^{L} represents a carbon atom or a nitrogen atom, and when a plurality of E^{L} are present, they may be the same or different at each occurrence,
Ring L¹ represents a 6-membered aromatic hetero ring, and this ring optionally has a substituent, and when a plurality of said substituents are present, they may be combined together to form a ring together with atoms to which they are attached, and when a plurality of Ring L¹ are present, they may be the same or different,
Ring L² represents an aromatic hydrocarbon ring or an aromatic hetero ring, and the foregoing rings optionally have a substituent, and when a plurality of said substituents are present, they may be combined together to form a ring together with atoms to which they are attached, and when a plurality of Ring L² are present, they may be the same or different,
the substituent which Ring L¹ optionally has and the substituent which Ring L² optionally has may be combined together to form a ring together with atoms to which they are attached,
A³-G²-A⁴ represents an anionic bidentate ligand, A³ and A⁴ each independently represent a carbon atom, an oxygen atom or a nitrogen atom, and these atoms may be ring-constituent atoms, G² represents a single bond or an atomic group constituting a bidentate ligand together with A³ and A⁴, and when a plurality of A³-G²-A⁴ are present, they may be the same or different.

2. The light emitting device according to Claim 1, wherein said second organic layer contains a polymer compound containing a constitutional unit represented by the formula (1-1B), the formula (1-2B), the formula (1-3B) or the formula (1-4B), as said polymer compound containing a constitutional unit having a group obtained by removing from the metal complex represented by the formula (2) one or more hydrogen atoms: 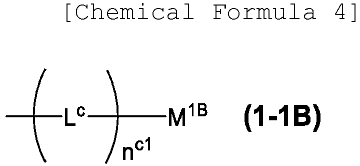 wherein,
M^{1B} represents a group obtained by removing from said metal complex represented by the formula (2) one hydrogen atom,
L^{C} represents an oxygen atom, a sulfur atom, -N(R^{A})-, - C(R^{B})₂-, -C(R^{B})=C(R^{B})-, -C≡C-, an arylene group or a divalent hetero ring group, and the foregoing groups optionally have a substituent, R^{A} represents a hydrogen atom, an alkyl group, a cycloalkyl group, an aryl group or a monovalent hetero ring group, and the foregoing groups optionally have a substituent, R^{B} represents a hydrogen atom, an alkyl group, a cycloalkyl group, an alkoxy group, a cycloalkoxy group, an aryl group or a monovalent hetero ring group, and the foregoing groups optionally have a substituent, a plurality of R^{B} may be the same or different, and they may be combined together to form a ring together with carbon atoms to which they are attached, and when a plurality of L^{C} are present, they may be the same or different,
n^{c1} represents an integer of 0 or more, 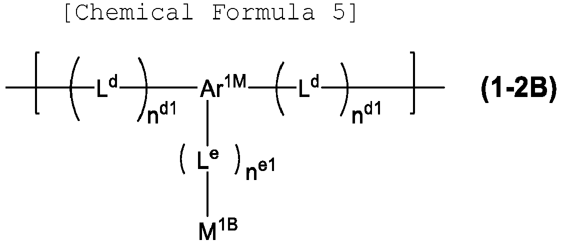
wherein,
M^{1B} represents the same meaning as described above,
L^{d} and L^{e} each independently represent an oxygen atom, a sulfur atom, -N(R^{A})-, -C(R^{B})₂-, -C(R^{B})=C(R^{B})-, -C≡C-, an arylene group or a divalent hetero ring group, and the foregoing groups optionally have a substituent, R^{A} and R^{B} represent the same meaning as described above, and when a plurality of L^{d} and L^{e} are present, they may be the same or different at each occurrence,
n^{d1} and n^{e1} each independently represent an integer of 0 or more, a plurality of n^{d1} may be the same or different,
Ar^{1M} represents an aromatic hydrocarbon group or a hetero ring group, and the foregoing groups optionally have a substituent, 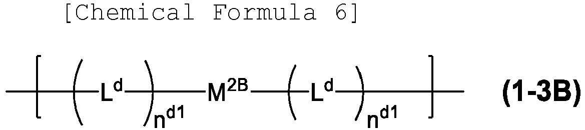
wherein,
L^{d} and n^{d1} represent the same meaning as described above,
M^{2B} represents a group obtained by removing from said metal complex represented by the formula (2) two hydrogen atoms, 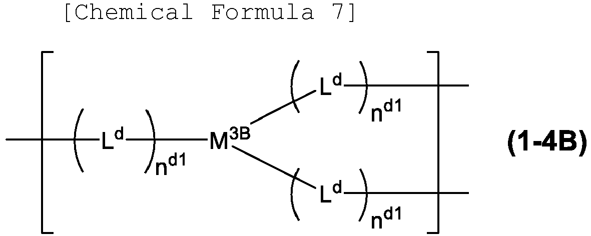
wherein,
L^{d} and n^{d1} represent the same meaning as described above,
M^{3B} represents a group obtained by removing from said metal complex represented by the formula (2) three hydrogen atoms.

3. The light emitting device according to Claim 1 or 2, wherein said metal complex represented by the formula (1) is a metal complex represented by the formula (1-A1) or the formula (1-A2): 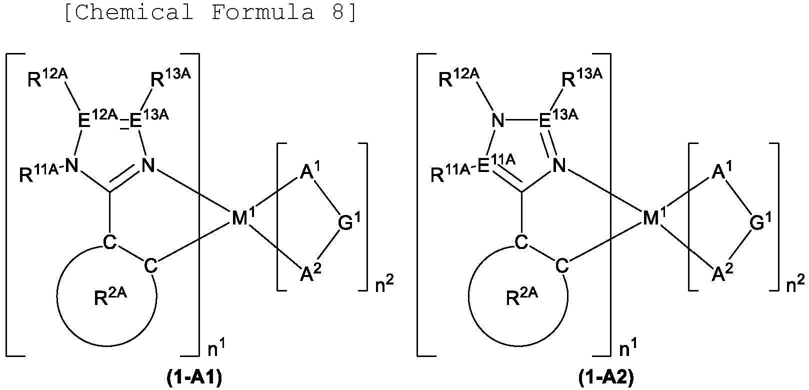
wherein, M¹, n¹, n², R^{11A}, R^{12A}, R^{13A}, E^{11A}, E^{12A}, E^{13A} and A¹-G¹-A² represent the same meaning as described above,
Ring R^{2A} represents a benzene ring, a fluorene ring, a spirobifluorene ring, a dihydrophenanthrene ring, a pyridine ring, a diazabenzene ring, a carbazole ring, a dibenzofuran ring or a dibenzothiophene ring, and the foregoing rings optionally have a substituent, and when a plurality of said substituents are present, they may be combined together to form a ring together with atoms to which they are attached, and when a plurality of Ring R^{2A} are present, they may be the same or different,
the substituent which Ring R^{2A} optionally has and R^{11A} may be combined together to form a ring together with atoms to which they are attached,
in the formula (1-A1), at least one of R^{11A} is said group represented by the formula (Ar-1A), and in the formula (1-A2), at least one of R^{12A} is said group represented by the formula (Ar-1A).

4. The light emitting device according to any one of Claims 1 to 3, wherein said group represented by the formula (Ar-1A) is a group represented by the formula (Ar-2A) : 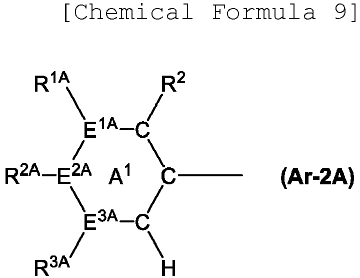 wherein,
R² represents the same meaning as described above,
Ring A¹ represents a benzene ring, a pyridine ring or a diazabenzene ring,
E^{1A}, E^{2A} and E^{3A} each independently represent a nitrogen atom or a carbon atom, and when E^{1A} is a nitrogen atom, R^{1A} is absent, when E^{2A} is a nitrogen atom, R^{2A} is absent and when E^{3A} is a nitrogen atom, R^{3A} is absent,
R^{1A}, R^{2A} and R^{3A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent,
R^{1A} and R^{2A}, and, R^{2A} and R^{3A} each may be combined together to form a ring together with atoms to which they are attached.

5. The light emitting device according to any one of Claims 1 to 4, wherein said metal complex represented by the formula (2) is a metal complex represented by the formula (2-B): 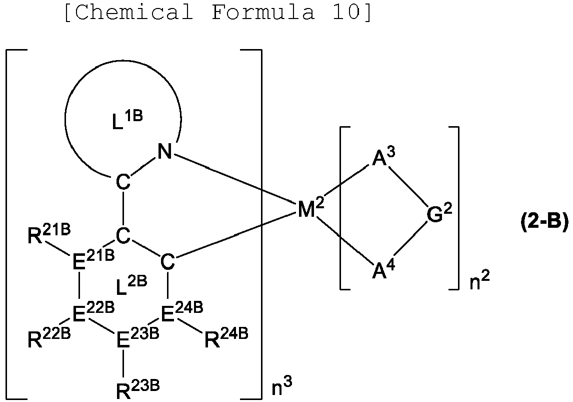 wherein,
M², n³, n⁴ and A³-G²-A⁴ represent the same meaning as described above,
Ring L^{1B} represents a pyridine ring, a diazabenzene ring, an azanaphthalene ring or a diazanaphthalene ring, and the foregoing rings optionally have a substituent, and when a plurality of said substituents are present, they may be combined together to form a ring together with atoms to which they are attached, and when a plurality of Ring L^{1B} are present, they may be the same or different,
E^{21B}, E^{22B}, E^{23B} and E^{24B} each independently represent a nitrogen atom or a carbon atom, and when a plurality of E^{21B}, E^{22B}, E^{23B} and E^{24B} are present, they may be the same or different at each occurrence, and when E^{21B} is a nitrogen atom, R^{21B} is absent, when E^{22B} is a nitrogen atom, R^{22B} is absent, when E^{23B} is a nitrogen atom, R^{23B} is absent and when E^{24B} is a nitrogen atom, R^{24B} is absent,
R^{21B}, R^{22B}, R^{23B} and R^{24B} each independently represent a hydrogen atom or a group represented by the formula (1-T), and when a plurality of R^{21B}, R^{22B}, R^{23B} and R^{24B} are present, they may be the same or different at each occurrence, R^{21B} and R^{22B}, R^{22B} and R^{23B}, R^{23B} and R^{24B}, and, a substituent which Ring L^{1B} optionally has and R^{21B} each may be combined together to form a ring together with atoms to which they are attached,
Ring L^{2B} represents a benzene ring, a pyridine ring or a diazabenzene ring,
[Chemical Formula 11] **-R^{1T} (1-T)**
wherein, R^{1T} represents an alkyl group, a cycloalkyl group, an alkoxy group, a cycloalkoxy group, an aryloxy group, an aryl group, a monovalent hetero ring group, a substituted amino group or a halogen atom, and the foregoing groups optionally have a substituent.

6. The light emitting device according to Claim 5, wherein at least one of said Ring L^{1B} has said group represented by the formula (1-T), or at least one of said R^{21B}, said R^{22B}, said R^{23B} and said R^{24B} is said group represented by the formula (1-T).

7. The light emitting device according to Claim 6, wherein said R^{1T} is an alkyl group optionally having a substituent, a cycloalkyl group optionally having a substituent, a group represented by the formula (D-A), a group represented by the formula (D-B) or a group represented by the formula (D-C): 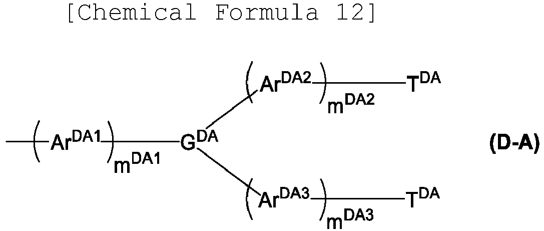 wherein,
m^{DA1}, m^{DA2} and m^{DA3} each independently represent an integer of 0 or more,
G^{DA} represents a nitrogen atom, an aromatic hydrocarbon group or a hetero ring group, and the foregoing groups optionally have a substituent,
Ar^{DA1}, Ar^{DA2} and Ar^{DA3} each independently represent an arylene group or a divalent hetero ring group, and the foregoing groups optionally have a substituent, and when a plurality of Ar^{DA1}, Ar^{DA2} and Ar^{DA3} are present, they may be the same or different at each occurrence,
T^{DA} represents an aryl group or a monovalent hetero ring group, and the foregoing groups optionally have a substituent, and a plurality of T^{DA} may be the same or different, 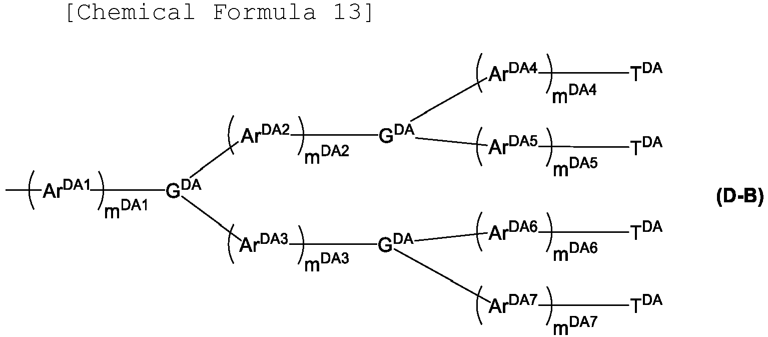
wherein,
m^{DA1} , m^{DA2}, m^{DA3}, m^{DA4}, m^{DA5}, m^{DA6} and m^{DA7} each independently represent an integer of 0 or more,
G^{DA} represents a nitrogen atom, an aromatic hydrocarbon group or a hetero ring group, and the foregoing groups optionally have a substituent, a plurality of G^{DA} may be the same or different,
Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and the foregoing groups optionally have a substituent, and when a plurality of Ar^{DA1}, Ar^{DA2} , Ar^{DA3}, Ar^{DA4}, Ar^{DA5}, Ar^{DA6} and Ar^{DA7} are present, they may be the same or different at each occurrence,
T^{DA} represents an aryl group or a monovalent hetero ring group, and the foregoing groups optionally have a substituent, and a plurality of T^{DA} may be the same or different, 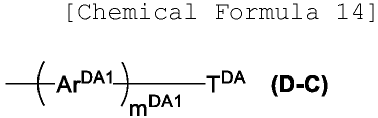
wherein,
m^{DA1} represents an integer of 0 or more,
Ar^{DA1} represents an arylene group or a divalent hetero ring group, and the foregoing groups optionally have a substituent, and when a plurality of Ar^{DA1} are present, they may be the same or different,
T^{DA} represents an aryl group or a monovalent hetero ring group, and the foregoing groups optionally have a substituent.

8. The light emitting device according to any one of Claims 1 to 7, wherein said first organic layer further contains a compound represented by the formula (H-1) or a polymer compound containing a constitutional unit represented by the formula (Y), or a combination thereof: 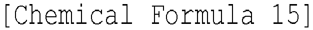 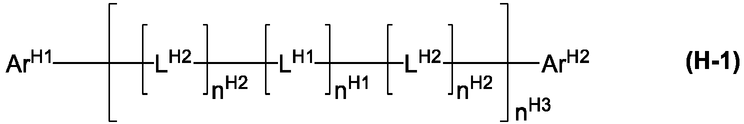 wherein,
Ar^{H1} and Ar^{H2} each independently represent an aryl group or a monovalent hetero ring group, and the foregoing groups optionally have a substituent,
n^{H1} and n^{H2} each independently represent 0 or 1, and when a plurality of n^{H1} are present, they may be the same or different, and a plurality of n^{H2} may be the same or different,
n^{H3} represents an integer of 0 or more and 10 or less,
L^{H1} represents an arylene group, a divalent hetero ring group or a group represented by -[C(R^{H11})₂]n^{H11}-, and the foregoing groups optionally have a substituent, and when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and the foregoing groups optionally have a substituent, a plurality of R^{H11} may be the same or different, and they may be combined together to form a ring together with carbon atoms to which they are attached,
L^{H2} represents a group represented by -N(-L^{H21-}R^{H21})-, and when a plurality of L^{H2} are present, they may be the same or different, L^{H21} represents a single bond, an arylene group or a divalent hetero ring group, and the foregoing groups optionally have a substituent, R^{H21} represents a hydrogen atom, an alkyl group, a cycloalkyl group, an aryl group or a monovalent hetero ring group, and the foregoing groups optionally have a substituent, 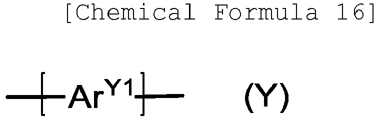 wherein, Ar^{Y1} represents an arylene group, a divalent hetero ring group, or a divalent group in which at least one arylene group and at least one divalent hetero ring group are bonded directly, and the foregoing groups optionally have a substituent.

9. The light emitting device according to any one of Claims 1 to 8, wherein the maximum peak wavelength of the emission spectrum of said metal complex represented by the formula (1) is 380 nm or more and less than 495 nm, and the maximum peak wavelength of the emission spectrum of said metal complex represented by the formula (2) is 495 nm or more and less than 750 nm.

10. The light emitting device according to any one of Claims 1 to 9, wherein said first organic layer and said second organic layer are adjacent.

11. The light emitting device according to any one of Claims 1 to 10, wherein said second organic layer is a layer disposed between said anode and said first organic layer.

12. The light emitting device according to any one of Claims 1 to 11, wherein said first organic layer is a first light emitting layer, and said second organic layer is a second light emitting layer.
